# EUROPEAN PATENT APPLICATION

(11) **EP 4 199 130 A1**
(43) Date of publication of application: **21.06.2023**
(21) Application number: 21214611.2
(22) Date of filing: 15.12.2021
(51) Int. Cl.: H01L 51/54

(54) **AN ORGANIC ELECTROLUMINESCENCE DEVICE COMPRISING A LIGHT EMITTING LAYER COMPRISING THREE DIFFERENT COMPOUNDS AND AN ELECTRONIC EQUIPMENT COMPRISING SAID ORGANIC ELECTROLUMINESCENCE DEVICE**

(71) Applicant: Idemitsu Kosan Co.,Ltd., Tokyo 100-8321 (JP)
(72) Inventor: Lin, Chao-Chen, 4057 Basel (CH); Chebotareva, Natalia, 68220 Hagenthal le Bas (FR)
(74) Representative: Hollah, Dorothee

(57) **Abstract**

An organic electroluminescence device comprising a cathode, an anode and an emitting layer having an anode side and a cathode side disposed between the cathode and the anode, and a further layer next to the anode side of the emitting layer wherein
the emitting layer comprises
(i) At least one compound with a dipole moment of less than 1.7 10⁻³⁰ Cm (0.5 debye), preferably less than 1.3 10⁻³⁰ Cm (0.4 debye), more preferably 1.0 10⁻³⁰ Cm (0.3 debye), as component (1);
(ii) At least one organic fluorescent compound whose onset of fluorescence is at lower energies than that of component (1) and at an energy higher than 2.6 eV, whose photoluminescence quantum yield is higher than 70% and whose ionization potential in absolute values is higher than 5.33 eV, as component (2);
(iii) At least one organic compound whose ionization potential in absolute values is lower than 5.33 eV and whose onset of fluorescence is at higher energies than that of component (2), as component (3); and

the further layer comprising a compound fulfilling the following requirement:
Ionization potential in absolute values of component (1) - Ionization potential in absolute values of component (4) ≤ 0.35 eV,; a material being in form of a layer structure comprising a layer comprising components (1), (2) and (3) and a further layer comprising a compound fulfilling the following requirement:
Ionization potential in absolute values of component (1) - Ionization potential in absolute values of component (4) ≤ 0.35 eV; a composition comprising components (1), (2) and (3), wherein component (3) is present in the composition in an amount of 5% by weight or less, preferably in an amount of 0.5% to 5% by weight, based on the total amount of the composition; an organic electroluminescence device comprising the inventive composition; an electronic equipment comprising said organic electroluminescence device; and the use of said material or said composition in an organic electroluminescence device.

## Description

The present invention relates to an organic electroluminescence device, comprising three different components (1), (2) and (3) having a specific energetic relationship in an emitting layer of the organic electroluminescence device and a further layer next to the anode side of the emitting layer comprising a compound having an ionization potential which is not more than 0.35 eV lower than that of component (1); a material being in form of a layer structure comprising a layer comprising components (1), (2) and (3) and a further layer comprising a compound (4), fulfilling the following requirement: Ionization potential in absolute values of component (1) - Ionization potential in absolute values of component (4) ≤ 0.35 eV; a composition comprising components (1), (2) and (3), wherein component (3) is present in the composition in an amount of 5% by weight or less, preferably in an amount of 0.5% to 5% by weight, based on the total amount of the composition; an organic electroluminescence device comprising the inventive composition; an electronic equipment comprising said organic electroluminescence device; and the use of said material or said composition in an organic electroluminescence device. When a voltage is applied to an organic electroluminescence device (hereinafter may be referred to as an organic EL device or OLED), holes are injected to an emitting layer from an anode and electrons are injected to an emitting layer from a cathode. In the emitting layer, injected holes and electrons are re-combined and excitons are formed.

An organic EL device essentially comprises an emitting layer between the anode and the cathode. Further, there may be a case where it has a stacked layer structure comprising one or more additional organic layers.

Organic electroluminescence devices, comprising three different compounds having a specific energetic relationship in an emitting layer of the organic electroluminescence device are generally known in the art.

US20190280209A1 relates to an OLED having a light emitting layer comprising (1) an anthracene compound as host material, (2) a pyrene compound as host material and (3) a fluorescent dopant. The light emitting layer may be laminated, with one layer containing the anthracene compound and the other layer containing the pyrene compound.

US2020052212A1 and US20210005826A1 relate to an OLED having a light emitting layer comprising (1) an aromatic host material, (2) a 2^{nd} host material with higher hole-mobility and (3) a fluorescent dopant.

For an easy control of the brightness of the organic EL device panel, stable EQE (external quantum efficiency) over current density is required. Generally, an anthracene compound or a pyrene compound as a host material, is used together with an EBL (electron-blocking layer) or HTL (hole transport layer) having a deep IP (ionization potential) and therefore a small energy difference to the IP of the host material is used to obtain the stable EQE over current density. Generally, non-polar host materials are used in this case. Known deep IP emitter in non-polar host materials combined with deep IP EBL or HTL lead to devices having a low EQE and a short lifetime (LT).

Accordingly, it is an object of the present invention to improve the performance of deep IP emitter in non-polar host materials combined with deep IP EBL or HTL in an organic electroluminescence device, allowing for organic electroluminescence devices, having stable EQE over current density and at the same time good lifetimes (LT).

Said object is solved by an organic electroluminescence device comprising a cathode, an anode and an emitting layer having an anode side and a cathode side disposed between the cathode and the anode, and a further layer next to the anode side of the emitting layer wherein the emitting layer comprises
(i) At least one compound with a dipole moment of less than 1.7 · 10⁻³⁰ Cm (0.5 debye), preferably less than 1.3 · 10⁻³⁰ Cm (0.4 debye), more preferably 1.0 · 10⁻³⁰ Cm (0.3 debye), as component (1), preferably having a fluorescence onset of >2.75 eV;
(ii) At least one organic fluorescent compound whose onset of fluorescence is at lower energies than that of component (1) and at an energy higher than 2.6 eV, whose photoluminescence quantum yield is higher than 70% and whose ionization potential in absolute values is higher than 5.33 eV, as component (2);
(iii) At least one organic compound whose ionization potential in absolute values is lower than 5.33 eV and whose onset of fluorescence is at higher energies than that of component (2), as component (3);
and
the further layer comprising a compound fulfilling the following requirement:
Ionization potential in absolute values of component (1) - Ionization potential in absolute values of component (4) ≤ 0.35 eV, as component (4);
   wherein
the dipole moment is computed using the DFT method with the Gaussian 16 software;
the onset of fluorescence is determined by linear fitting of the high energy side of the spectra; the photoluminescence quantum yield is measured with an integrating sphere;
the ionization potential of component (2) and component (3) is measured by cyclic voltammetry; and
the ionization potential of component (1) and component (4) is measured by photoelectron spectroscopy.

The expression "Comprising a compound fulfilling the following requirement: Ionization potential in absolute values of component (1) - Ionization potential in absolute values of component (4) ≤ 0.35 eV" has the following meaning:
The difference between the absolute value of the ionization potential of compound (1) and the absolute value of the ionization potential of component (4) is equal to or less than 0.35 eV.

In the present application, the absolue values of the ionization potential of compounds (1), (2), (3) and (4) are given, to improve readybility. Therefore, for example, the ionization potential of component (2) is in absolute values higher than 5.33 eV and the the ionization potential of component (3) is in absolute values lower than 5.33 eV.

However, the ionization potentials of compounds (1), (2), (3) and (4) are negative values. This means, for example, that the (negative) value of the ionization potential of component (2) is lower than -5.33 eV and the (negative) value of the ionization potential of component (3) higher than -5.33 eV.

It has been found by the inventors that organic EL devices having a stable EQE over current density and at the same time good lifetimes (LT) can be provided by matching the ionization potential (IP) of component (1), i.e. preferably the host material, in an emitting layer of an organic EL device with the IP of component (4) present in a further layer next to the anode side of the emitting layer, i.e. preferably the electron blocking layer.

In a further embodiment, said object is solved by a composition comprising
(i) At least one compound with a dipole moment of less than 1.7 · 10⁻³⁰ Cm (0.5 debye), preferably less than 1.3 · 10⁻³⁰ Cm (0.4 debye), more preferably 1.0 · 10⁻³⁰ Cm (0.3 debye), as component (1), preferably having a fluorescence onset of >2.75 eV;
(ii) At least one organic fluorescent compound whose onset of fluorescence is at lower energies than that of component (1) and at an energy higher than 2.6 eV, whose photoluminescence quantum yield is higher than 70% and whose ionization potential in absolute values is higher than 5.33 eV, as component (2);
(iii) 5 % by weight or less , preferably 0.5 to 5 % by weight, based on the total amount of the composition, of at least one organic compound whose ionization potential in absolute values is lower than 5.33 eV and whose onset of fluorescence is at higher energies than that of component (2), as component (3),
wherein
the dipole moment is computed using the DFT method with the Gaussian 16 software;
the onset of fluorescence is determined by linear fitting of the high energy side of the spectra; the photoluminescence quantum yield is measured with an integrating sphere;
the ionization potential of component (2) and component (3) is measured by cyclic voltammetry; and
the ionization potential of component (1) is measured by photoelectron spectroscopy.

In a further embodiment, said object is solved by an organic electroluminescence device comprising a cathode, an anode and an emitting layer disposed between the cathode and the anode, wherein the emitting layer comprises the inventive composition mentioned above. Preferably, the emitting layer is a single layer, a double layer or a stack of a plurality of layers.

Generally, component (1) is a host material, component (2) ist a dopant material and component (3) is an additive. The light emitting layer of the inventive organic electroluminescence device therefore preferably comprises at least one host material represented by component (1), at least one dopant represented by component (2) and at least one additive represented by component (3).

Component (4) is generally a hole transporting material, which is present in the layer next to the anode side of the emitting layer. Said layer defined as "electron blocking layer" in the present application.

Generally, components 1, 2, 3 and 4 present in the organic electroluminescent device of the present invention are different from each other.

Preferably, components (1), (2) and (3) are present in the light-emitting layer in form of a mixture.

It has been found by the inventors of the present invention that organic electroluminescence devices comprising a combination of a non-polar host material (component (1)) combined with a hole transporting material with high ionization potential (IP) in absolute values (component (4)) having a stable EQE over current density and at the same time good lifetimes (LT) can be provided by combining the non-polar host material (component (1)), a hole transporting material with high IP in absolute values (component (4)) and a dopant (component (2)) having an ionization potential that is in absolute values higher than 5.33 eV with at least one organic compound whose ionization potential is in absolute values lower than 5.33 eV and whose onset of fluorescence is at higher energies than that of component (2), as component (3).

It has further been found that the EQE and at the same time the lifetimes (LT) of an organic electroluminescence device are especially good, if an organic electroluminescence device comprising components (1), (2) and (3) in an emitting layer is employed, wherein the amount of component (3) is 5 % by weight or less, preferably 0.5 to 5 % by weight, based on the total amount of a composition comprising components (1) to (3), and/or if the organic electroluminescence device comprising components (1), (2) and (3) in an emitting layer is employed, additionally comprising a component (4) in a layer next to the anode side of the emitting layer fulfilling the requirement: Ionization potential in absolute values of component (1) - Ionization potential in absolute values of component (4) ≤ 0.35 eV. This means that component (4) has an ionization potential which is in absolute values less than 0.35 eV lower than that of component (1).

The term organic EL device (organic electroluminescence device) is used interchangeably with the term organic light-emitting diode (OLED) in the present application.

A further subject of the present invention is directed to a material being in form of a layer structure comprising
a first layer comprising
   (i) at least one component (1);
   (ii) at least one component (2);
   (iii) at least one component (3);
wherein components (1), (2) and (3) are defined above and below, and
a further layer
comprising a compound
fulfilling the following requirement: Ionization potential in absolute values of component (1) - Ionization potential in absolute values of component (4) ≤ 0.35 eV, as component (4). The further layer is generally present next to the first layer.

A further subject of the present invention is directed to an electronic equipment comprising the organic electroluminescence device according the present invention.

A further subject of the present invention is directed to the use of a material or a composition according to the present invention in a light emitting layer of an organic electroluminescence device.

The terms unsubstituted or substituted aromatic hydrocarbon group containing 6 to 50 ring atoms, an unsubstituted or substituted heteroaromatic group containing 5 to 50 ring atoms, heterocyclic group having 5 to 50 ring atoms, an unsubstituted or substituted alkyl group having 1 to 50 carbon atoms, an unsubstituted or substituted cycloalkyl group having 3 to 50 ring carbon atoms, are known in the art and generally have the following meaning, if said groups are not further specified in specific embodiments mentioned below:
The unsubstituted or substituted aromatic hydrocarbon group containing 6 to 50 ring atoms, preferably 6 to 30 ring atoms, more preferably 6 to 24 ring atoms, most preferably 6 to 24 ring atoms, may be a non-condensed aryl group or a condensed aryl group. Specific examples thereof include phenyl group, naphthyl group, phenanthryl group, biphenyl group, terphenyl group, quaterphenyl group, fluoranthenyl group, triphenylenyl group, phenanthrenyl group, fluorenyl group, anthracenyl, chrysenyl, spirofluorenyl group, 9,9-diphenylfluorenyl group, 9,9'-spirobi[9H-fluorene]-2-yl group, 9,9-dimethylfluorenyl group, benzo[c]phenanthrenyl group, benzo[a]triphenylenyl group, naphtho[1,2-c]phenanthrenyl group, naphtho[1,2-a]triphenylenyl group, dibenzo[a,c]triphenylenyl group, benzo[a]fluoranthenyl group, benzo[j]fluoranthenyl group, benzo[k]fluoranthenyl group and benzo[b]fluoranthenyl group, with phenyl group, naphthyl group, biphenyl group, terphenyl group, phenanthryl group, triphenylenyl group, fluorenyl group, spirobifluorenyl group anthracenyl, and fluoranthenyl group being preferred, and phenyl group, 1-naphthyl group, 2-naphthyl group, biphenyl-2-yl group, biphenyl-3-yl group, biphenyl-4-yl group, phenanthrene-9-yl group, phenanthrene-3-yl group, phenanthrene-2-yl group, triphenylene-2-yl group, 9,9-dimethylfluorene-2-yl group, 9,9-dimethylfluorene-4-yl group, 9,9-diphenylfluorene-2-yl group, 9,9-diphenylfluorene-4-yl group, fluoranthene-3-yl group, fluoranthene-2-yl group, fluoranthene-8-yl, anthracen-3-yl and anthracen-9-yl group being most preferred.

In the case that linkers represent an unsubstituted or substituted aromatic hydrocarbon group containing 6 to 50 ring atoms, the linkers are divalent aromatic hydrocarbon groups containing 6 to 50 ring atoms, which are unsubstituted or (further) substituted.

The unsubstituted or (further) substituted divalent aromatic hydrocarbon group containing 6 to 50 ring atoms, preferably 6 to 30 ring atoms, more preferably 6 to 18 ring atoms, most preferably 6 to 14 ring atoms, may be a non-condensed or a condensed divalent aromatic hydrocarbon group. Specific examples thereof include phenylene group, naphthylene group, biphenylene group, terphenylene group, quaterphenylene group, fluoranthene-diyl group, triphenylene-diyl group, phenanthrene-diyl group, fluorene-diyl group, anthracene-diyl, chrysene-diyl, spirofluorene-diyl group, 9,9-diphenylfluorene-diyl group, 9,9'-spirobi[9H-fluorene]-2-diyl group, 9,9-dimethylfluorene-diyl group, benzo[c]phenanthrene-diyl group, benzo[a]triphenylene-diyl group, naphtho[1,2-c]phenanthrene-diyl group, naphtho[1,2-a]triphenylene-diyl group, dibenzo[a,c]triphenylene-diyl group, benzo[a]fluoranthene-diyl group, benzo[j]fluoranthene-diyl group, benzo[k]fluoranthene-diyl group and benzo[b]fluoranthene-diyl group, with phenylene group, naphthylene group, biphenylene group, terphenylene group, phenanthrene-diyl group, triphenylene-diyl group, fluorene-diyl group, spirobifluorene-diyl group, anthracene-diyl and fluoranthene-diyl group being preferred.

The unsubstituted or substituted heterocyclic group having 5 to 50 ring atoms, preferably 5 to 30 ring atoms, more preferably 5 to 18 ring atoms, is preferably an unsubstituted or substituted heteroaromatic group containing 5 to 50 ring atoms, preferably 5 to 30 ring atoms, more preferably 5 to 18 ring atoms, may be a non-condensed heteroaromatic group or a condensed heteroaromatic group. Specific examples thereof include the residues of pyrrole ring, isoindole ring, imidazopyridine ring, imidazopyrimidine ring, imidazopyrazin ring, benzofuran ring, isobenzofuran ring, benzothiophene, dibenzothiophene ring, isoquinoline ring, quinoxaline ring, quinazoline, phenanthridine ring, phenanthroline ring, pyridine ring, pyrazine ring, pyrimidine ring, pyridazine ring, indole ring, quinoline ring, acridine ring, carbazole ring, furan ring, thiophene ring, benzoxazole ring, benzothiazole ring, benzimidazole ring, dibenzofuran ring, triazine ring, oxazole ring, oxadiazole ring, thiazole ring, thiadiazole ring, triazole ring, azadibenzofuran, aza-dibenzothiophene, aza-carbazole, and imidazole ring with the residues of dibenzofuran ring, carbazole ring, benzimidazole ring, pyridine ring, and dibenzothiophene ring being preferred, and the residues of imidazo[1,2-a]pyridine, imidazo[1,5-a]pyridine, dibenzofuran-1-yl group, dibenzofuran-3-yl group, dibenzofuran-2-yl group, dibenzofuran-4-yl group, 9-phenylcarbazole-3-yl group, 9-phenylcarbazole-2-yl group, 9-phenylcarbazole-4-yl group, dibenzothiophene-2-yl group, and dibenzothiophene-4-yl, dibenzothiophene-1-yl group, and dibenzothiophene-3-yl group being more preferred.

In the case that the linkers represent an unsubstituted or substituted heteroaromatic group containing 5 to 50 ring atoms, the linkers are a divalent aromatic heteroaromatic group containing 5 to 50 ring atoms, which is unsubstituted or (further) substituted.

The unsubstituted or (further) substituted divalent heteroaromatic group containing 5 to 50 ring atoms, preferably 5 to 30 ring atoms, more preferably 5 to 18 ring atoms, may be a non-condensed heteroaromatic group or a condensed heteroaromatic group. Specific examples thereof include pyrrole-diyl, isoindole-diyl, benzofuran-diyl, isobenzofuran-diyl, benzothiophene-diyl, dibenzothiophene-diyl, isoquinoline-diyl, quinoxaline -diyl, quinazoline-diyl, phenanthridine-diyl, phenanthroline-diyl, pyridine-diyl, pyrazine-diyl, pyrimidine-diyl, pyridazine-diyl, indole-diyl, quinoline-diyl, acridine-diyl, carbazole-diyl, furan-diyl, thiophene-diyl, benzoxazole-diyl, benzothiazole-diyl, benzimidazole-diyl, dibenzofuran-diyl, triazine-diyl, oxazole-diyl, oxadiazole-diyl, thiazole-diyl, thiadiazole-diyl, triazole-diyl, aza-dibenzothiophene-diyl, azadibenzofuran-diyl, aza-carbazole-diyl, and imidazole-diyl.

Examples of the unsubstituted or substituted alkyl group having 1 to 50 carbon atoms, preferably 1 to 25 carbon atoms, more preferably 1 to 8 carbon atoms, are methyl group, ethyl group, n-propyl group, isopropyl group, n-butyl group, s-butyl group, isobutyl group, t-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, neopentyl group and 1-methylpentyl group.

Further preferred are alkyl groups having 1 to 6 carbon atoms. Examples of the alkyl group having 1 to 6 carbon atoms are methyl group, ethyl group, n-propyl group, isopropyl group, n-butyl group, s-butyl group, isobutyl group, t-butyl group, n-pentyl group, n-hexyl group, neopentyl group and 1-methylpentyl group, with methyl group, ethyl group, n-propyl group, isopropyl group, n-butyl group, s-butyl group, isobutyl group and t-butyl group being preferred.

Examples of the unsubstituted or substituted cycloalkyl group having 3 to 50 ring carbon atoms, preferably 3 to 18 ring carbon atoms, more preferably 3 to 12 ring carbon atoms, include cyclopropyl group, cyclobutyl group, cyclopentyl group, cyclohexyl group, cyclooctyl group, and adamantyl group. Most preferred are cycloalkyl groups having 3 to 6 ring carbon atoms, i.e. a cyclopropyl group, a cyclobutyl group, a cyclopentyl group or a cyclohexyl group.

Examples of the optional substituent(s) indicated by "substituted or unsubstituted" and "may be substituted" referred to above or hereinafter include a halogen atom, a cyano group, R^{a}R^{b}PO, an alkyl group having 1 to 50, preferably 1 to 25 carbon atoms, more preferably 1 to 8 carbon atoms, a cycloalkyl group having 3 to 50, preferably 3 to 18 ring carbon atoms, more preferably 3 to 12 ring carbon atoms, an alkoxy group having 1 to 50, preferably 1 to 25 carbon atoms, more preferably 1 to 8 carbon atoms, an alkylamino group having 1 to 50 carbon atoms, preferably 1 to 25 carbon atoms, more preferably 1 to 5 carbon atoms, a carboxyalkyl group having 1 to 50 carbon atoms, preferably 1 to 25 carbon atoms, more preferably 1 to 5 carbon atoms, a carboxamidalkyl group having 1 to 50 carbon atoms, preferably 1 to 25 carbon atoms, more preferably 1 to 5 carbon atoms, a silyl group, a C₆ to C₅₀ aryl group, preferfably a C₆ to C₂₄ aryl group, more preferfably a C₆ to C₁₈ aryl group, an aryloxy group having 6 to 50, preferably 6 to 24 ring carbon atoms, more preferably 6 to 18 ring carbon atoms, an aralkyl group having 7 to 50, preferably 7 to 24 carbon atoms, more preferably 7 to 20 carbon atoms, an alkylthio group having 1 to 50, preferably 1 to 25 carbon atoms, more preferably 1 to 5 carbon atoms, an arylthio group having 6 to 50, preferably 6 to 24 ring carbon atoms, more preferably 6 to 18 ring carbon atoms, an arylamino group having 6 to 50 carbon atoms, preferably 6 to 30 carbon atoms, more preferably 6 to 18 carbon atoms, a carboxyaryl group having 6 to 50 carbon atoms, preferably 6 to 24 carbon atoms, more preferably 6 to 18 carbon atoms, a carboxamidaryl group having 6 to 50 carbon atoms, preferably 6 to 24 carbon atoms, more preferably 6 to 18 carbon atoms, and a heteroaromatic group having 5 to 50 ring atoms, preferably 5 to 30 ring atoms, more preferably 5 to 18 ring atoms. The substituents may in turn be unsubstituted or substituted, preferably unsubstituted.

R^{a} and R^{b} each independently represents an unsubstituted or substituted aromatic hydrocarbon group containing 6 to 50 ring atoms, or an unsubstituted or substituted heteroaromatic group containing 5 to 50 ring atoms, an unsubstituted or substituted alkyl group having 1 to 50 carbon atoms, an unsubstituted or substituted cycloalkyl group having 3 to 50 ring carbon atoms.

The alkyl group having 1 to 50, preferably 1 to 25 carbon atoms, more preferably 1 to 8 carbon atoms, the C₆ to C₅₀ aryl group, preferably C₆ to C₂₄ aryl group, more preferably C₆ to C₁₈ aryl group, and cycloalkyl group having 3 to 50 ring carbon atoms, preferably 3 to 18 ring carbon atoms, preferably 3 to 12 ring carbon atoms, and the heterocyclic group having 5 to 50 ring atoms, preferably 5 to 30 ring atoms, more preferably 5 to 18 ring atoms, are defined above.

Examples of the alkenyl group having 2 to 50 carbon atoms include those disclosed as alkyl groups having 2 to 50 carbon atoms but comprising at least one double bond, preferably one, or where possible, two or three double bonds.

Examples of the alkynyl group having 2 to 50 carbon atoms include those disclosed as alkyl groups having 2 to 50 carbon atoms but comprising at least one triple bond, preferably one, or where possible, two or three triple bonds.

The silyl group is an alkyl and/or aryl substituted silyl group. Examples of alkyl and/or aryl substituted silyl groups include alkylsilyl groups having 1 to 10 carbon atoms, preferably 1 to 5 carbon atoms, including trimethylsilyl group, triethylsilyl group, tributylsilyl group, dimethylethylsilyl group, t-butyldimethylsilyl group, propyldimethylsilyl group, dimethylisopropylsilyl group, dimethylpropylsilyl group, dimethylbutylsilyl group, dimethyltertiarybutylsilyl group, diethylisopropylsilyl group, alkylarylsilyl groups having 6 to 50 carbon atoms, preferably 6 to 30 carbon atoms, more preferably 6 to 18 carbon atoms, in the aryl part and 1 to 10 carbon atoms, preferably 1 to 5 carbon atoms, in the alkyl part including phenyldimethylsilyl group, diphenylmethylsilyl group, diphenyltertiarybutylsilyl group, and arylsilyl groups having 6 to 50 carbon atoms, preferably 6 to 30 carbon atoms, more preferably 6 to 18 carbon atoms, including a triphenylsilyl group, with trimethylsilyl, triphenylsilyl, diphenyltertiarybutylsilyl group and t-butyldimethylsilyl group being preferred.

Examples of halogen atoms include fluorine, chlorine, bromine, and iodine.

Examples of an alkylamino group (alkyl substituted amino group), preferably an alkylamino group having 1 to 50 ring carbon atoms include those having an alkyl portion selected from the alkyl groups mentioned above.

Examples of an arylamino group (aryl substituted amino group), preferably an arylamino group having 6 to 50 ring carbon atoms include those having an aryl portion selected from the aromatic hydrocarbon groups mentioned above.

Examples of the optional aralkyl group having 7 to 50 ring carbon atoms include benzyl group, 2-phenylpropane-2-yl group, 1-phenylethyl group, 2-phenylethyl group, 1-phenylisopropyl group, 2-phenylisopropyl group, phenyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthylisopropyl group, 2-β-naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydroxybenzyl group, o-hydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylisopropyl group, and 1-chloro-2-phenylisopropyl group.

Examples of a carboxyalkyl group (alkyl substituted carboxyl group), preferably a carboxyalkyl group having 1 to 50 carbon atoms, preferably 1 to 25 carbon atoms, more preferably 1 to 5 carbon atoms, include those having an alkyl portion selected from the alkyl groups mentioned above.

Examples of a carboxyaryl group (aryl substituted carboxyl group), preferably a carboxyaryl group having 6 to 50 carbon atoms, preferably 6 to 24 carbon atoms, more preferably 6 to 18 carbon atoms, include those having an aryl portion selected from the aromatic hydrocarbon groups mentioned above.

Examples of a carboxamidalkyl group (alkyl substituted amide group), preferably a carboxamidalkyl group having 1 to 50 carbon atoms, preferably 1 to 25 carbon atoms, more preferably 1 to 5 carbon atoms, include those having an alkyl portion selected from the alkyl groups mentioned above.

Examples of a carboxamidaryl group (aryl substituted amide group), preferably a carboxamidaryl group having 6 to 50 carbon atoms, preferably 6 to 24 carbon atoms, preferably 6 to 18 carbon atoms, include those having an aryl portion selected from the aromatic hydrocarbon groups mentioned above.

The optional substituent is preferably a halogen atom, a cyano group, an alkyl group having 1 to 25 carbon atoms, an aryl group having 6 to 24 ring carbon atoms, preferably 6 to 18 ring carbon atoms, and an heterocyclic group having 5 to 50 ring atoms, preferably 5 to 18 ring atoms; more preferably a cyano group, a phenyl group, a naphthyl group, a biphenyl group, a terphenyl group, a phenanthryl group, a triphenylenyl group, a fluorenyl group, a spirobifluorenyl group, a fluoranthenyl group, a residue based on a dibenzofuran ring, a residue based on a carbazole ring, and a residue based on a dibenzothiophene ring, a methyl group, an ethyl group, a n-propyl group, an isopropyl group, a n-butyl group, a s-butyl group, an isobutyl group, a t-butyl group, a cyclopentyl group, and a cyclohexyl group.

The optional substituent mentioned above may be further substituted by one or more of the optional substituents mentioned above.

The number of the optional substituents depends on the group which is substituted by said substituent(s). Preferred are 1, 2, 3 or 4 optional substituents, more preferred are 1, 2 or 3 optional substituents, most preferred are 1 or 2 optional substituents. In a further preferred embodiment, the groups mentioned above are unsubstituted.

The "carbon number of a to b" in the expression of "substituted or unsubstituted X group having a to b carbon atoms" is the carbon number of the unsubstituted X group and does not include the carbon atom(s) of an optional substituent.

The hydrogen atom referred to herein includes isotopes different from neutron numbers, i.e., light hydrogen (protium), heavy hydrogen (deuterium) and tritium.

The term "unsubstituted" referred to by "unsubstituted or substituted" means that a hydrogen atom is not substituted by one of the groups mentioned above.

### Component (1)

Component (1) is at least one compound with a dipole moment of less than 1.7 · 10⁻³⁰ Cm (0.5 debye), preferably less than 1.3 · 10⁻³⁰ Cm (0.4 debye), more preferably 1.0 · 10⁻³⁰ Cm (0.3 debye). Preferably, component (1) has a fluorescence onset of >2.75 eV.

Wherein the dipole moment is computed using the DFT method with the Gaussian 16 software and the onset of fluorescence is determined by linear fitting of the high energy side of the spectra.

Preferably, component (1) is an aromatic hydrocarbon compound, preferably exclusively comprising carbon and hydrogen, more preferably an anthracene skeleton-containing compound, a chrysene skeleton-containing compound, a pyrene skeleton-containing compound, a fluorene skeleton-containing compound, a fluoranthene skeleton containing compound, with a pyrene skeleton-containing compound and an anthracene skeleton-containing compound being more preferred and an anthracene skeleton-containing compound being most preferred. Preferred anthracene skeleton-containing compounds, chrysene skeleton-containing compounds, pyrene skeleton-containing compounds, fluorene skeleton-containing compounds and fluoranthene skeleton containing compounds are described in the following.

Suitable anthracene skeleton-containing compounds exclusively comprising carbon and hydrogen are for example described in US 2021/005826 A1 and US 2019/0280209 A1.

Preferred anthracene skeleton-containing compounds are compounds of the following formula (10): 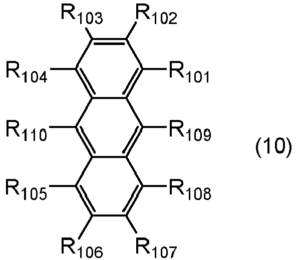 wherein
one or more pairs of two or more adjacent R₁₀₁ to R₁₁₀ may form a substituted or unsubstituted, saturated ring;
R₁₀₁ to R₁₁₀ that do not form the substituted or unsubstituted, saturated ring are independently a hydrogen atom, a substituted or unsubstituted alkyl group including 1 to 50 carbon atoms, a substituted or unsubstituted cycloalkyl group including 3 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalkyl group including 3 to 50 ring carbon atoms, a substituted or unsubstituted alkylene group including 1 to 50 carbon atoms, a substituted or unsubstituted aralkyl group including 7 to 50 carbon atoms, a substituted or unsubstituted aryl group including 6 to 50 ring carbon atoms, or a group represented by the following formula (30);
provided that at least one of R₁₀₁ to R₁₁₀ that do not form the substituted or unsubstituted, saturated ring is a group represented by the following formula (30). If two or more groups represented by the formula (30) are present, each of these groups may be the same or different;

   -L₁₀₁-Ar₁₀₁ (30)

   wherein in the formula (30),
   L₁₀₁ is a single bond, a substituted or unsubstituted arylene group including 6 to 30 ring carbon atoms;
   Ar₁₀₁ is a substituted or unsubstituted aryl group including 6 to 50 ring carbon atoms.

-L₁₀₁- preferably represents one of the following groups:

A single bond,

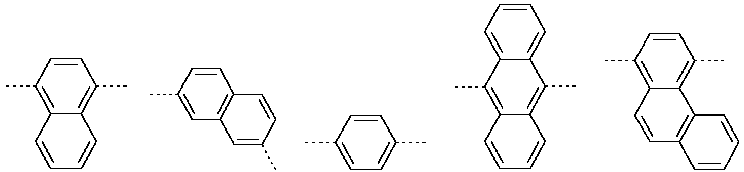

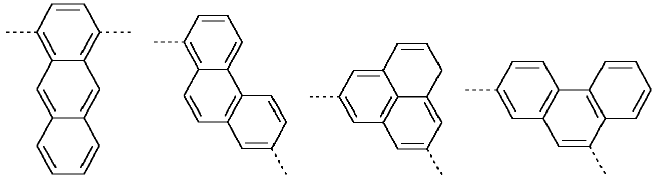

Ar₁₀₁ preferably represents a phenyl, an anthracenyl, a biphenyl-yl, a terphenyl-yl, a naphthyl, a phenanthryl or a fluorenyl group, more preferably a group of the following formula

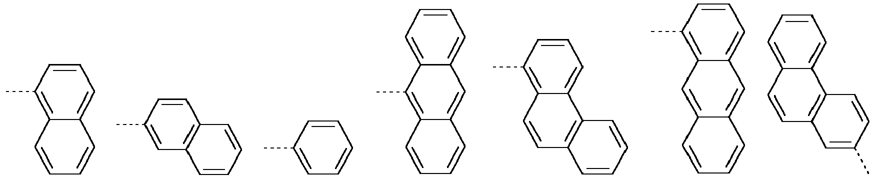

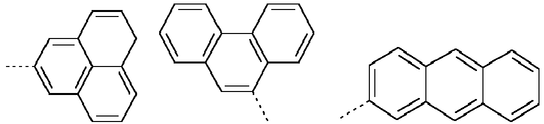

The dotted lines are bonding sites.

Preferred groups -L₁₀₁-Ar₁₀₁ are each independently

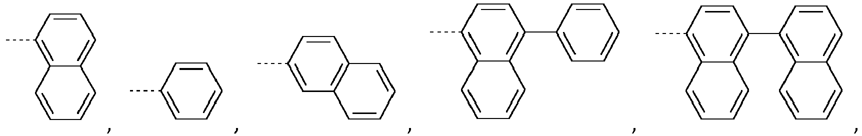

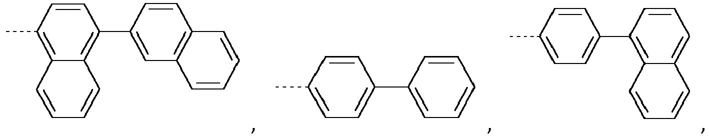

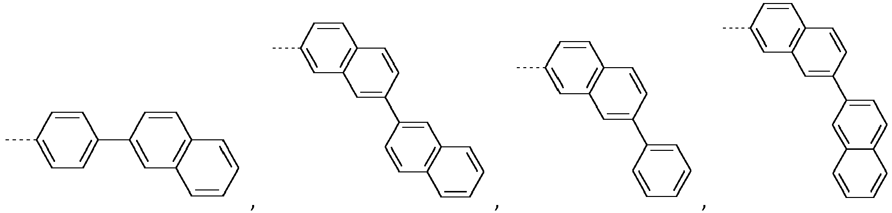

Specific examples of each substituent, substituents for "substituted or unsubstituted" in the compound (10) are the hydrocarbon residues exclusively comprising carbon and hydrogen of the substituents mentioned above.

An explanation will be given on "one or more pairs of two or more adjacent R₁₀₁ to R₁₁₀ may form a substituted or unsubstituted, saturated ring".

The "one pair of two or more adjacent R₁₀₁ to R₁₁₀" is a combination of R₁₀₁ and R₁₀₂, R₁₀₂ and R₁₀₃, R₁₀₃ and R₁₀₄, R₁₀₅ and R₁₀₆, R₁₀₆ and R₁₀₇, R₁₀₇ and R₁₀₈, R₁₀₈ and R₁₀₉, R₁₀₁ and R₁₀₂ and R₁₀₃ or the like, for example.

The substituent in "substituted" in the "substituted or unsubstituted" for the saturated ring is the same as those for "substituted or unsubstituted" mentioned in the formula (10).

The "saturated ring" means, when R₁₀₁ and R₁₀₂ form a ring, for example, a ring formed by a carbon atom with which R₁₀₁ is bonded, a carbon atom with which R₁₀₂ is bonded and one or more arbitrary elements.

The "arbitrary element" is preferably a C element. In the arbitrary element, atomic bondings that do not form a ring may be terminated by a hydrogen atom, or the like.

The "one or more arbitrary element" is preferably 2 or more and 15 or less, more preferably 3 or more and 12 or less, and further preferably 3 or more and 5 or less arbitrary elements.

In one embodiment, R₁₀₁ to R₁₁₀ are independently a hydrogen atom, a substituted or unsubstituted alkyl group including 1 to 50 carbon atoms, a substituted or unsubstituted aryl group including 6 to 50 ring carbon atoms or a group represented by the formula (30).

Preferably, R₁₀₁ to R₁₁₀ are independently a hydrogen atom, a substituted or unsubstituted aryl group including 6 to 50 ring carbon atoms or a group represented by the formula (30).

More preferably, R₁₀₁ to R₁₁₀ are independently a hydrogen atom, a substituted or unsubstituted aryl group including 6 to 18 ring carbon atoms or a group represented by the formula (30).

Most preferably, at least one of R₁₀₉ and R₁₁₀ is a group represented by the formula (30).

Further most preferably, R₁₀₉ and R₁₁₀ are independently a group represented by the formula (30).

In one embodiment, the compound (10) is a compound represented by the following formula (10-1): 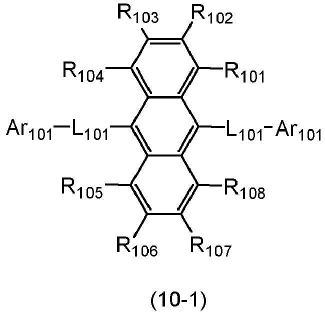 wherein in the formula (10-1), R₁₀₁ to R₁₀₈, L₁₀₁ and Ar₁₀₁ are as defined in the formula (10). Preferred groups L₁₀₁ and Ar₁₀₁ and -L₁₀₁-Ar₁₀₁ are mentioned above.

Preferably, at least R₁₀₁, R₁₀₄, R₁₀₅ and R₁₀₈ in the compounds of formula (10-1) are H. More preferably, at least R₁₀₁, R₁₀₄, R₁₀₅, R₁₀₃, R₁₀₇ and R₁₀₈ are H, most preferably, R₁₀₁, R₁₀₂, R₁₀₄, R₁₀₅, R₁₀₆, R₁₀₃, R₁₀₇ and R₁₀₈ are H.

In one embodiment, the compound (10) is a compound represented by the following formula (10-2): 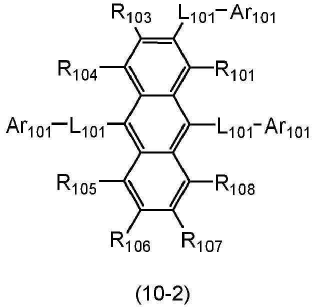 wherein in the formula (10-2), R₁₀₁, R₁₀₃ to R₁₀₈, L₁₀₁ and Ar₁₀₁ are as defined in the formula (10). Preferred groups L₁₀₁ and Ar₁₀₁ and -L₁₀₁-Ar₁₀₁ are mentioned above.

Preferably, at least R₁₀₁, R₁₀₄, R₁₀₅ and R₁₀₈ in the compounds of formula (10-2) are H. More preferably, at least R₁₀₁, R₁₀₄, R₁₀₅, R₁₀₃, R₁₀₇ and R₁₀₈ are H, most preferably, R₁₀₁, R₁₀₄, R₁₀₅, R₁₀₆, R₁₀₃, R₁₀₇ and R₁₀₈ are H.

In one embodiment, the compound (10) is a compound represented by the following formula (10-3): 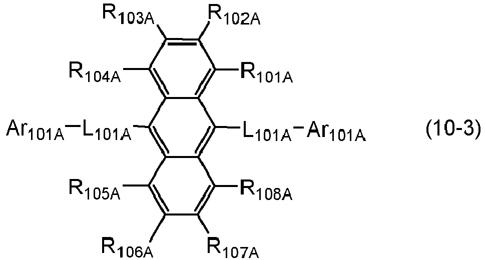 wherein in the formula (10-3),
R_{101A} to R_{108A} are independently a hydrogen atom or a substituted or unsubstituted aryl group including 6 to 50 ring carbon atoms;
L_{101A} is a single bond or a substituted or unsubstituted arylene group including 6 to 30 ring carbon atoms, and the two L_{101A}S may be the same or different;
Ar_{101A} is a substituted or unsubstituted aryl group including 6 to 50 ring carbon atoms, and the two Ar_{101A}S may be the same or different.

Preferred groups L_{101A} and Ar_{101A} and -L_{101A}-Ar_{101A} are the same groups as the groups L₁₀₁ and Ar₁₀₁ and -L₁₀₁-Ar₁₀₁ mentioned above.

Preferably, at least R_{101A}, R_{104A}, R_{105A} and R_{108A} in the compounds of formula (10-3) are H. More preferably, at least R_{101A}, R_{104A}, R_{105A}, R_{103A}, R_{107A} and R_{108A} are H, most preferably, R_{101A}, R_{102A}, R_{104A}, R_{105A}, R_{106A}, R_{103A}, R_{107A} and R_{108A} are H.

In one embodiment, the compound (10) is selected from the group consisting of compounds represented by the following formulae (10-3-1) to (10-3-6).

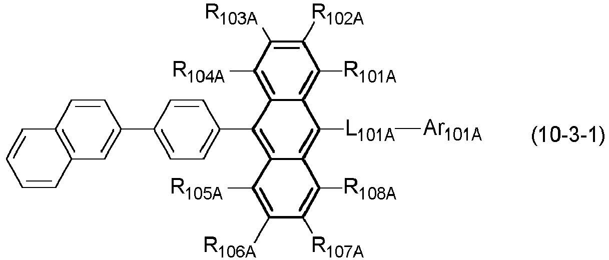

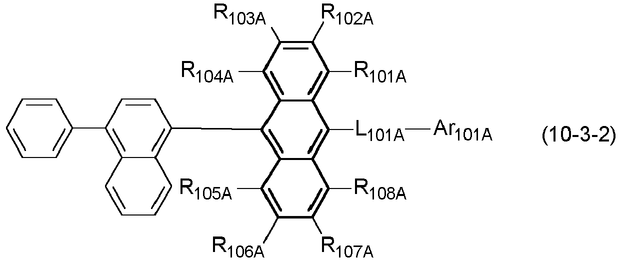

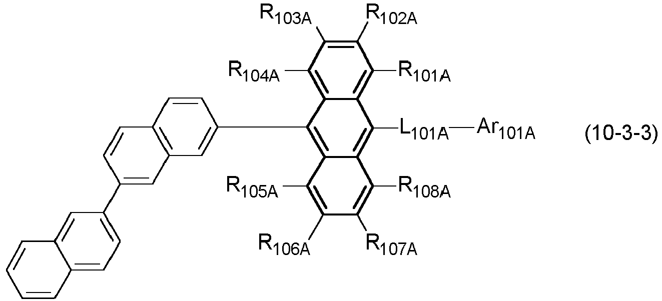

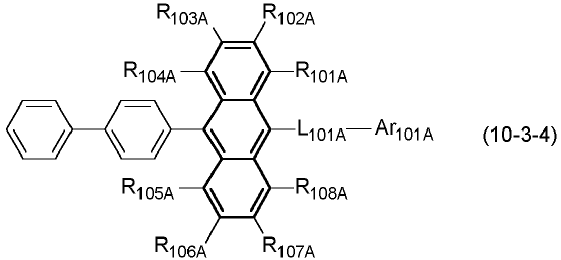

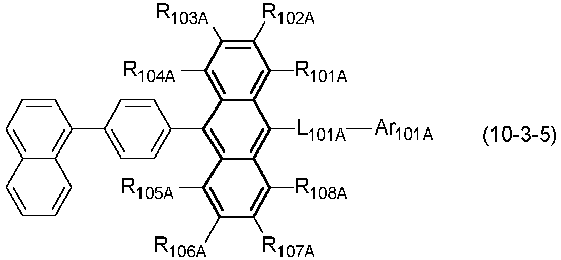

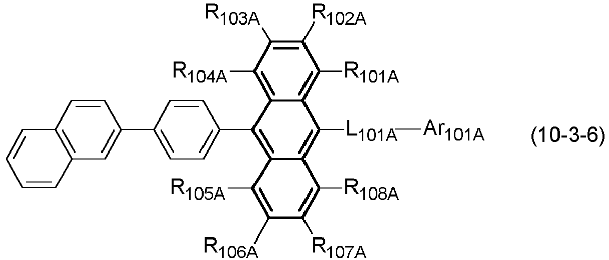

In the formulae (10-3-1) to (10-3-6), L_{101A} and Ar_{101A} are as defined in the formula (10-3).

Preferably, at least R_{101A}, R_{104A}, R_{105A} and R_{108A} in the compounds of formulae (10-3-1) to (10-3-6) are H. More preferably, at least R_{101A}, R_{104A}, R_{105A}, R_{103A}, R_{107A} and R_{108A} are H, most preferably, R_{101A}, R_{102A}, R_{104A}, R_{105A}, R_{106A}, R_{103A}, R_{107A} and R_{108A} are H.

### In formula (10):

The aryl group having 6 to 50 ring carbon atoms is preferably an aryl group having 6 to 40 ring carbon atoms, more preferably an aryl group having 6 to 30 ring carbon atoms. Examples for suitable aryl groups are: phenyl, biphenyl-yl, terphenyl-yl, quaterphenyl-yl, naphthyl, phenanthryl, fluorenyl, chrysenyl, triphenylenyl or pyrenyl, preferably phenyl or naphthyl.

The alkyl group having 1 to 50 carbon atoms is preferably an alkyl group having 1 to 30 carbon atoms, more preferably an alkyl group having 1 to 10 carbon atoms, further preferably an alkyl group having 1 to 5 carbon atoms. Examples of the alkyl group having 1 to 5 carbon atoms are methyl group, ethyl group, n-propyl group, isopropyl group, n-butyl group, s-butyl group, isobutyl group, t-butyl group, n-pentyl group, with methyl group, ethyl group, n-propyl group, isopropyl group, n-butyl group, s-butyl group, isobutyl group and t-butyl group being preferred.

The cycloalkyl group having 3 to 50 ring carbon atoms is preferably a cycloalkyl group having 3 to 12 ring carbon atoms, more preferably including cyclopropyl group, cyclobutyl group, cyclopentyl group, cyclohexyl group, cyclooctyl group, and adamantyl group. Most preferred are cycloalkyl groups having 3 to 6 ring carbon atoms, i.e. a cyclopropyl group, a cyclobutyl group, a cyclopentyl group or a cyclohexyl group.

The aralkyl group having 7 to 50 carbon atoms is preferably an aralkyl group having 7 to 30 carbon atoms, more preferably an aralkyl group having 7 to 20 carbon atoms. Examples of the optional aralkyl group having 7 to 50 ring carbon atoms include benzyl group, 2-phenylpropane-2-yl group, 1-phenylethyl group, 2-phenylethyl group, 1-phenylisopropyl group, 2-phenylisopropyl group, phenyl-t-butyl group, α-naphthylmethyl group, 1-α-naphthylethyl group, 2-α-naphthylethyl group, 1-α-naphthylisopropyl group, 2-α-naphthylisopropyl group, β-naphthylmethyl group, 1-β-naphthylethyl group, 2-β-naphthylethyl group, 1-β-naphthylisopropyl group, 2-β-naphthylisopropyl group, 1-pyrrolylmethyl group, 2-(1-pyrrolyl)ethyl group, p-methylbenzyl group, m-methylbenzyl group, o-methylbenzyl group, p-chlorobenzyl group, m-chlorobenzyl group, o-chlorobenzyl group, p-bromobenzyl group, m-bromobenzyl group, o-bromobenzyl group, p-iodobenzyl group, m-iodobenzyl group, o-iodobenzyl group, p-hydroxybenzyl group, m-hydroxybenzyl group, o-hydroxybenzyl group, p-aminobenzyl group, m-aminobenzyl group, o-aminobenzyl group, p-nitrobenzyl group, m-nitrobenzyl group, o-nitrobenzyl group, p-cyanobenzyl group, m-cyanobenzyl group, o-cyanobenzyl group, 1-hydroxy-2-phenylisopropyl group, and 1-chloro-2-phenylisopropyl group.

Suitable compounds of formula (10) and their preparation are for example described in US 2020/0111968 A1.

As for the compound represented by the formula (10), the following compounds can be given as specific examples.

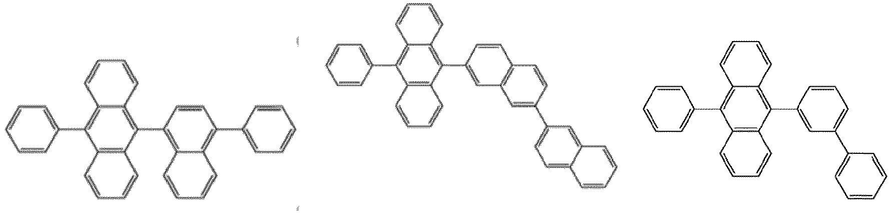

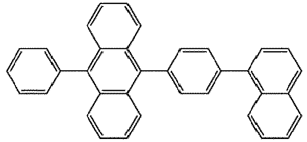

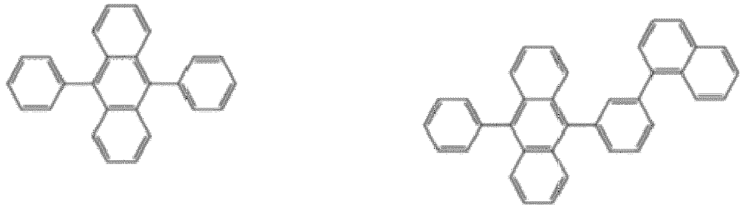

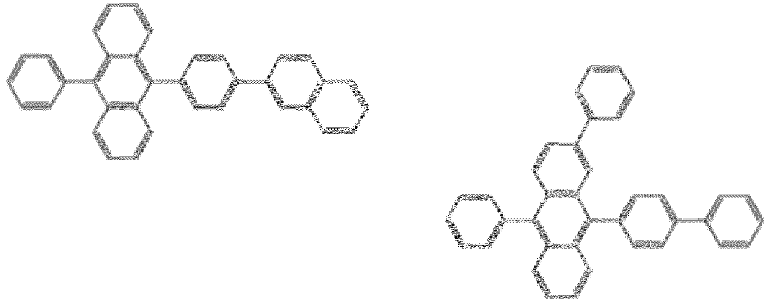

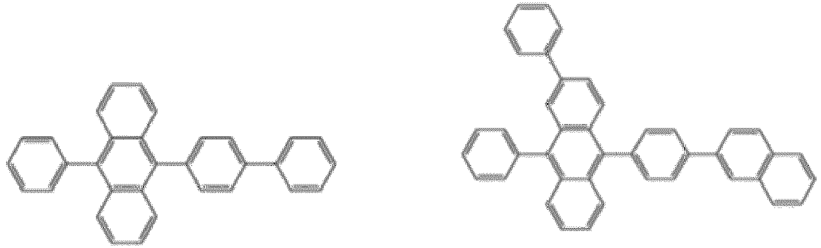

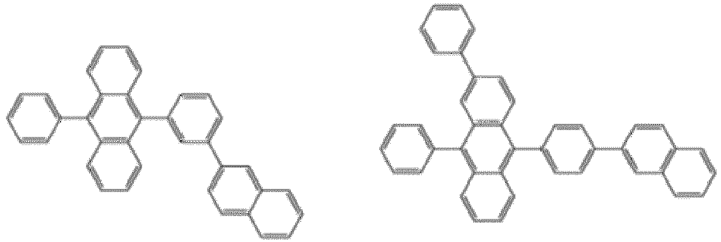

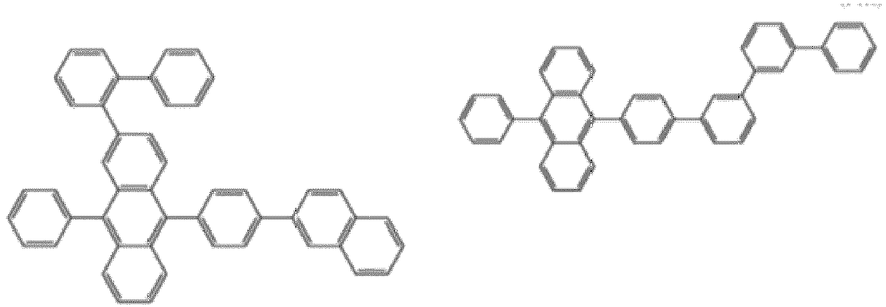

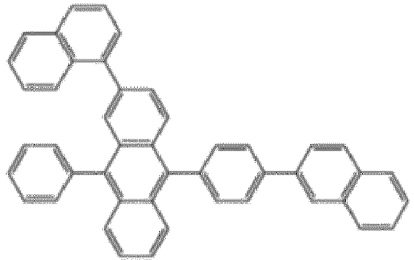

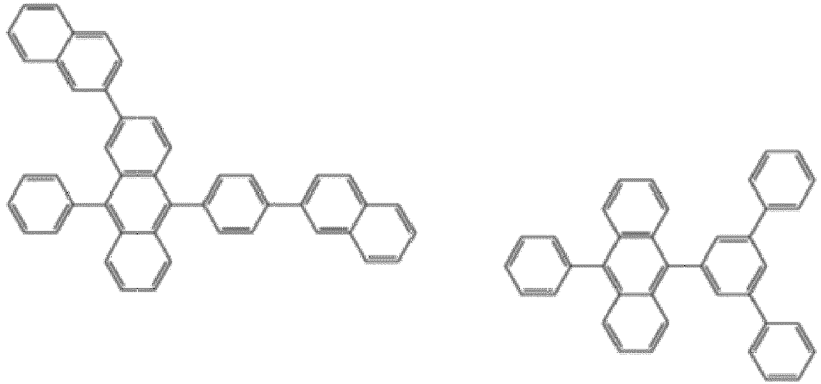

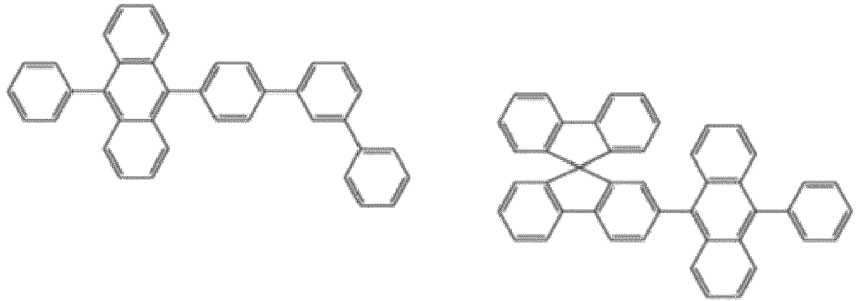

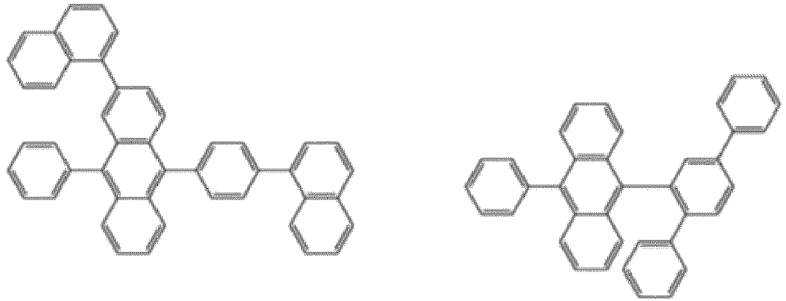

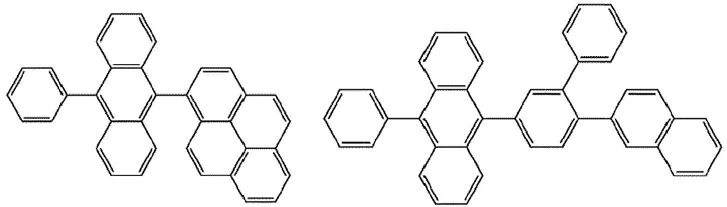

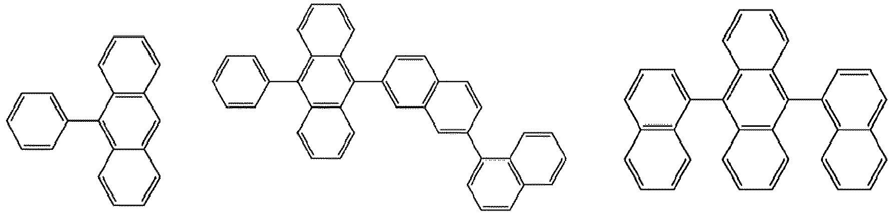

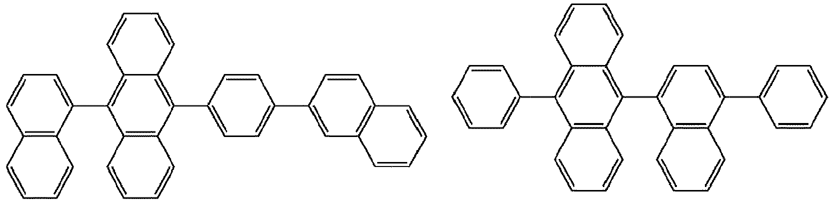

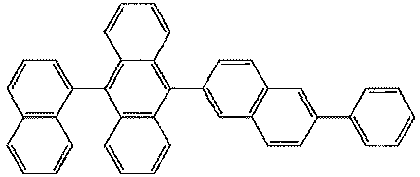

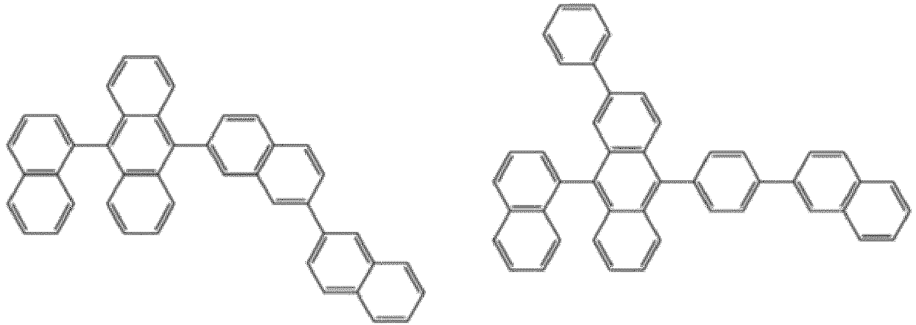

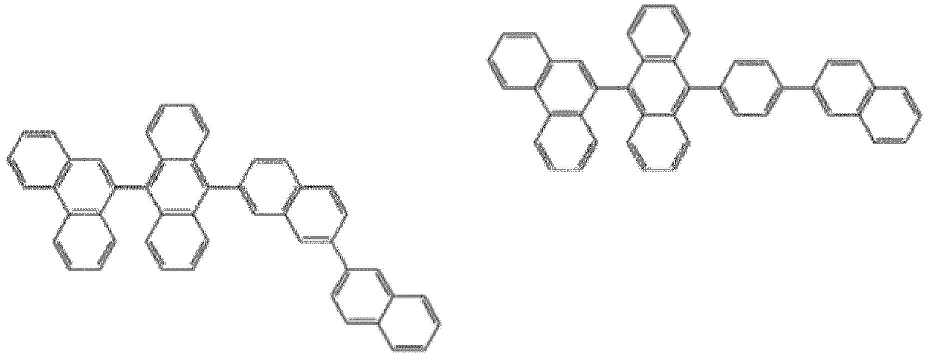

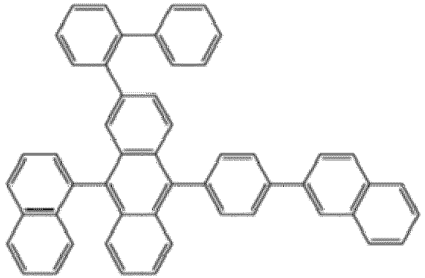

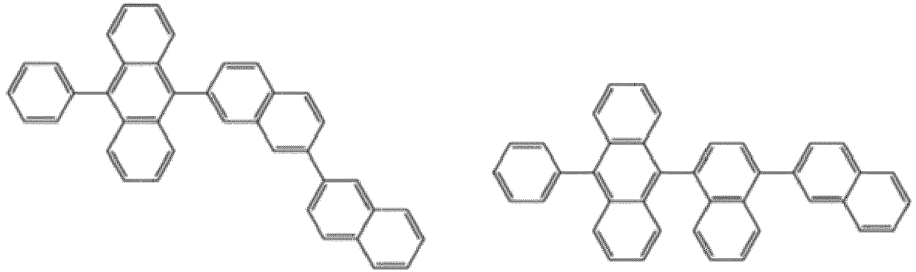

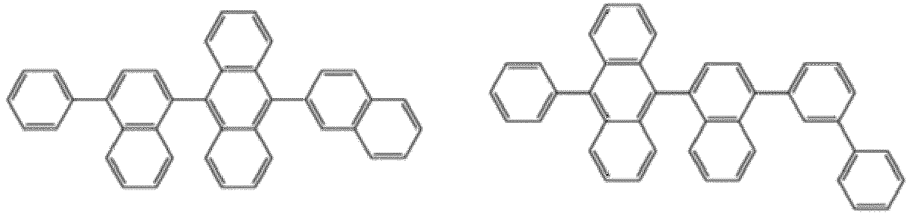

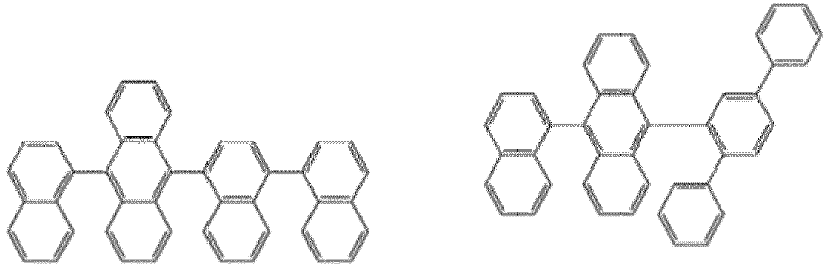

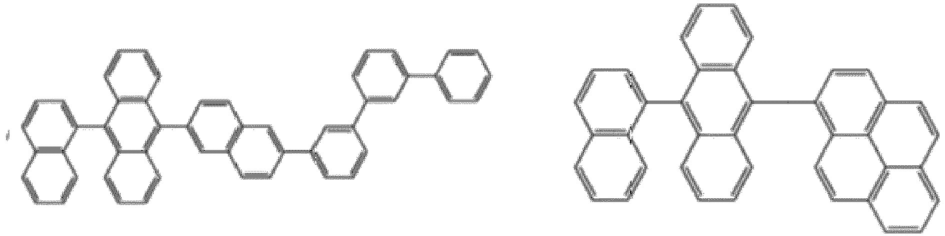

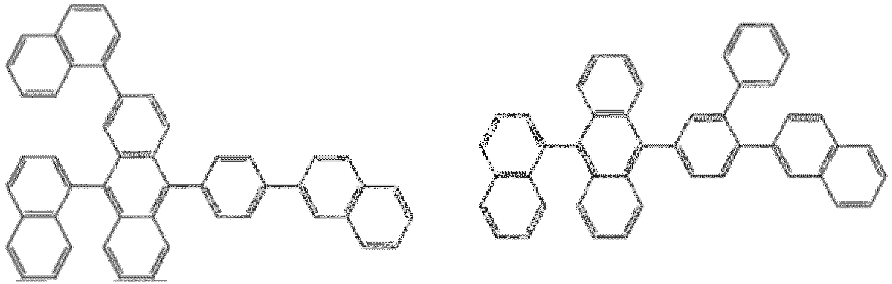

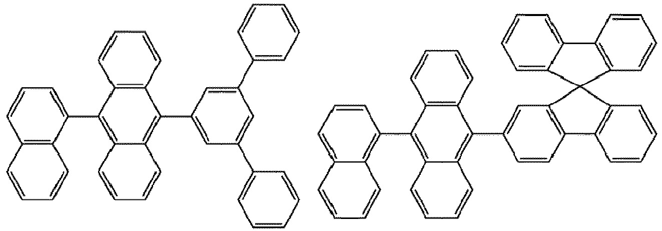

The compounds mentioned above are for example described in US 2019/00280209 A1 and US 2021/0005826 A1.

Most preferred components (1) are:

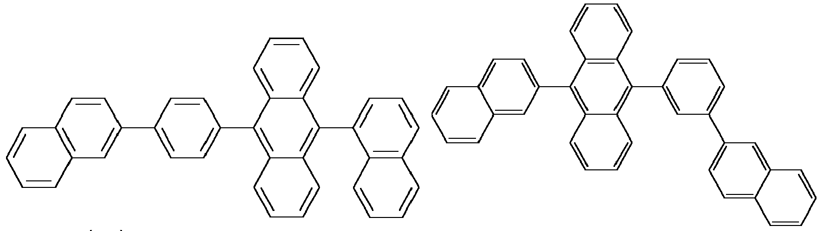

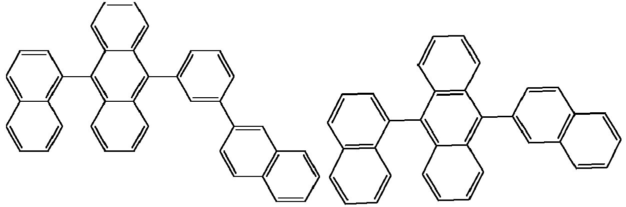

Preferred compounds (1) exclusively comprising carbon and hydrogen having a chrysene skeleton, a pyrene skeleton or a fluorene skeleton are described in US2021/0005826A1.

Examples are:

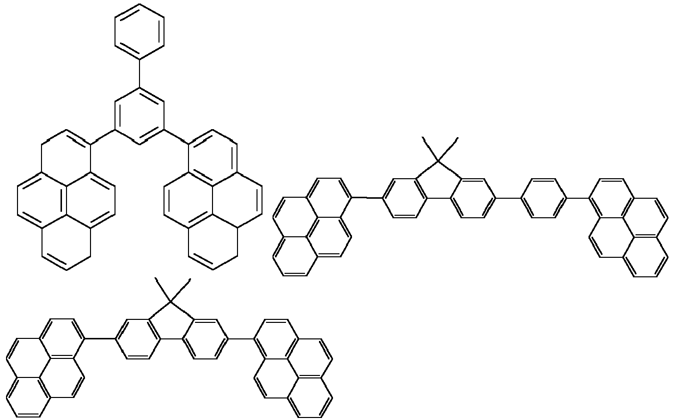

Preferred compounds (1) exclusively comprising carbon and hydrogen having a fluoranthene skeleton are described in US 2019/0280209 A1.

### Component (2)

Component (2) is at least one organic fluorescent compound whose onset of fluorescence is at lower energies than that of component (1) and at an energy higher than 2.6 eV, preferably higher than 2.7 eV, more preferably higher than 2.75 eV, whose photoluminescence quantum yield is higher than 70%, preferably higher than 75%, more preferably higher than 80%, and whose ionization potential is in absolute values higher than 5.33 eV.

Wherein the onset of fluorescence is determined by linear fitting of the high energy side of the spectra; the photoluminescence quantum yield is measured with an integrating sphere; and the ionization potential of component (2) and component (3) is measured by cyclic voltammetry.

Component (2) preferably has a Full Width at Half Maximum (FWHM) of emission of <30 nm, preferably 10 to 30 nm, more preferably 15 to 30 nm.

The FWHM is determined as known by a person skilled in the art and shown in the examples.

Component (2) is for example represented by a fused polycyclic aromatic compound, a styrylamine compound, a fused ring amine compound, a boron-containing compound, a pyrrole compound, an indole compound or a carbazole compound; preferably a fused polycyclic aromatic compound, a boron-containing compound or a carbazole compound.

The following compound (21) is an example for a boron-containing compound as component (2) 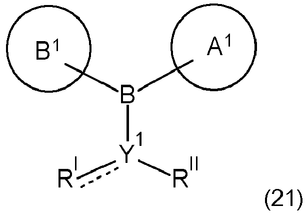 wherein, in the formula (21),
A¹ ring and B¹ ring each independently represents a substituted or unsubstituted aromatic hydrocarbon ring having 6 to 50 ring carbon atoms, or a substituted or unsubstituted heterocyclic ring having 5 to 50 ring atoms;
Y¹ represents C or N, wherein in the case of N the bonding 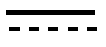 is a single bond and in the case of C the bonding 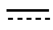 is a double bond;
R^{I} and R^{II} each independently represents
in the case of Y² = C: CR^{I1}R^{I2} and CR^{II1}R^{II2}, wherein
R^{I1} and R^{II1} together form a ring C¹, which ring C¹ represents a substituted or unsubstituted aromatic hydrocarbon ring having 6 to 50 ring carbon atoms, or a substituted or unsubstituted heterocyclic ring having 5 to 50 ring atoms;
R^{II1} and R^{II2} each independently represents CR^{II21}R^{II22}R^{II23}, OR^{II21}, NR^{II21}R^{II22}, SR^{II21} or SeR^{II21}, preferably NR^{II21}R^{II22} or CR^{II21}R^{II22}R^{II23}, more preferably NR^{II21}R^{II22};
wherein R^{II22} and R^{II23} each independently represents a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms; and
R^{II21} represents a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms; or a direct bond to the ring A¹ and to the ring B¹, preferably R^{II21} represents a direct bond to the ring A¹ and to the ring B¹;
in the case of Y² = N:
   R^{I} represents a ring D¹ and R^{II} represents a ring E¹, wherein the ring E¹ is connected via a group Y to the ring B¹; or
   R^{I} and R^{II} form together a ring F¹, which is fused with a ring G¹, wherein the ring G¹ is connected via a group Y to the ring B¹;
   wherein the rings D¹, E¹ and F¹ and the group Y are defined below.

Examples for compounds of formula (21) are: 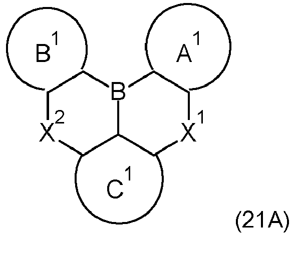 , preferably a compound of formula (21Aa) or (21Ab) 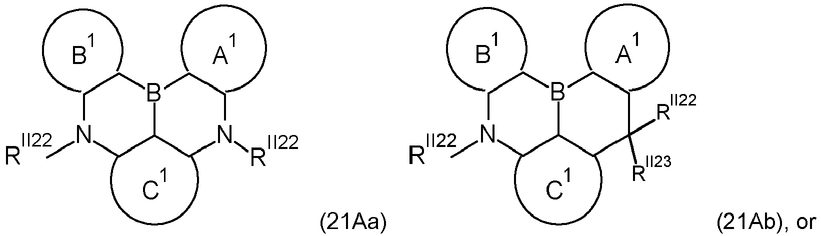 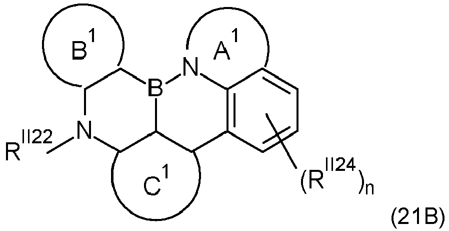 wherein, in the formula (21),
A¹ ring, B¹ ring and C¹ ring each independently represents a substituted or unsubstituted aromatic hydrocarbon ring having 6 to 50 ring carbon atoms, or a substituted or unsubstituted heterocyclic ring having 5 to 50 ring atoms;
X¹ and X² each independently represent NR^{II22} or CR^{II22}R^{II23}, more preferably NR^{II22};
R^{II22} and R^{II23} are each independently bonded to the A¹ ring, the B¹ ring or the C¹ ring to form a substituted or unsubstituted heterocyclic ring or do not form a substituted or unsubstituted heterocyclic ring;
R^{II22} and R^{II23} that do not form the substituted or unsubstituted heterocyclic ring and R^{II24}
each independently represents a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms;
n is 0, 1, 2 or 3, preferably 0 or 1;
   or
a compound represented by formula (21C): 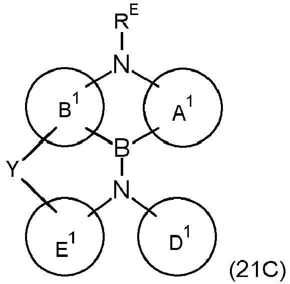 wherein
   ring A¹, ring B¹, ring D¹ and ring E¹ each independently represents a substituted or unsubstituted aromatic group having 6 to 60, preferably from 6 to 30, more preferably from 6 to 18 ring carbon atoms, or a substituted or unsubstituted heteroaromatic group having 5 to 60, preferably 5 to 30, more preferably 5 to 18 ring atoms;
      or
   ring E¹ and ring D¹ may be connected via a direct bond, O, S, NR²³, SiR²⁴R²⁵ or CR²⁷R²⁸, preferably via a direct bond;
   R^{E} represents hydrogen; an aryl group having from 6 to 50, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; a cycloalkyl group having from 3 to 50 ring carbon atoms which is unsubstituted or substituted; an alkenyl group having from 2 to 50 carbon atoms which is unsubstituted or substituted; an iminyl group R²³-C=N; an alkynyl group having from 2 to 50 carbon atoms which is unsubstituted or substituted;
      or
   R^{E} or a substituent on R^{E} may be bonded to the ring A₁ and/or to the ring B₁ or to a substituent on the ring A₁ and or the ring B₁ to form a ring structure which is unsubstituted or substituted, Y represents a direct bond, O, S, NR²³, SiR²⁴R²⁵ or CR²⁷R²⁸, preferably a direct bond;
   in the case that Y is a direct bond, ring B₁ and C₁ may additionally be connected via O, S, NR²³, SiR²⁴R²⁵ or CR²⁷R²⁸;
   R²³, R²⁴, R²⁵, R²⁷ and R²⁸ each independently represents an aryl group having from 6 to 50, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; or a cycloalkyl group having from 3 to 50 ring carbon atoms which is unsubstituted or substituted;
      and/or
   two residues R²⁴ and R²⁵ and/or two residues R²⁷ and R²⁸ together form a ring structure which is unsubstituted or substituted;
      or
a compound represented by formula (21D): 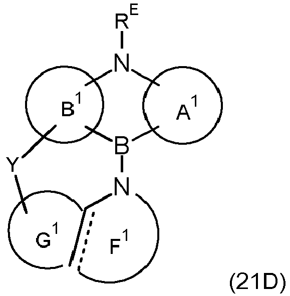 wherein
   ring A¹, ring B¹ and ring G¹ each independently represents a substituted or unsubstituted aromatic group having 6 to 50 ring carbon atoms, preferably from 6 to 30, more preferably from 6 to 18 ring carbon atoms, or a substituted or unsubstituted heteroaromatic group having 5 to 50, preferably 5 to 30, more preferably 5 to 18 ring atoms;
   ring F¹ represents a substituted or unsubstituted monocyclic ring having 5 to 7 ring atoms, which may be fused with at least one unsubstituted or substituted non-aromatic group having 5 to 50 ring atoms; preferably, ring F¹ represents a substituted or unsubstituted heteroaromatic monocyclic ring having 5 to 7 ring atoms, which may be fused with at least one unsubstituted or substituted non-aromatic group having 5 to 50 ring atoms or a substituted or unsubstituted non-heteroaromatic monocyclic ring having 5 to 7 ring atoms, which may be fused with at least one unsubstituted or substituted non-aromatic group having 5 to 50 ring atoms;
   ring G¹ and ring F¹ are fused together by a shared single or double bond;
   ring A¹ and ring F¹ may additionally be connected via a direct bond, O, S, NR²³, SiR²⁴R²⁵ or CR²⁷R²⁸, preferably via a direct bond;
   R^{E} represents hydrogen; an aryl group having from 6 to 50 ring carbon atoms which is unsubstituted or substituted, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; a cycloalkyl group having from 3 to 50 ring carbon atoms which is unsubstituted or substituted; an alkenyl group having from 2 to 50 carbon atoms which is unsubstituted or substituted; an iminyl group R²³-C=N, an alkynyl group having from 2 to 50 carbon atoms which is unsubstituted or substituted;
      or
   R^{E} or a substituent on R^{E} may be bonded to the ring A¹ and/or to the ring B¹ or to a substituent on the ring A¹ and or the ring B¹ to form a ring structure which is unsubstituted or substituted, Y represents a direct bond, O, S, NR²³, SiR²⁴R²⁵ or CR²⁷R²⁸, preferably a direct bond;
   in the case that Y is a direct bond, ring B¹ and G¹ may additionally be connected via O, S, NR²³, SiR²⁴R²⁵ or CR²⁷R²⁸;
   R²³, R²⁴, R²⁵, R²⁷ and R²⁸ each independently represents an aryl group having from 6 to 50 ring carbon atoms which is unsubstituted or substituted, preferably from 6 to 30, more preferably from 6 to 18 ring carbon atoms which is unsubstituted or substituted; a heteroaryl group having from 5 to 50, preferably 5 to 30, more preferably 5 to 18 ring atoms which is unsubstituted or substituted; an alkyl group having from 1 to 50 carbon atoms which is unsubstituted or substituted; or a cycloalkyl group having from 3 to 50 ring carbon atoms which is unsubstituted or substituted;
      and/or
   R²³, R²⁴, R²⁵, R²⁷ and R²⁸ may be bonded to the ring B¹ and/or to the ring G¹ to form a ring structure which is unsubstituted or substituted;
      and/or
   two residues R²⁴ and R²⁵ and/or two residues R²⁷ and R²⁸ together form a ring structure which is unsubstituted or substituted.

The compounds of formula (21), their syntheses and specific examples are for example described in EP 3 109 253 A1 (especially the compounds of formula (21A and 21B)), US 2020/0111968 A1, US 2019/0067577 A1, WO 2020/135953 and the not pre-published international applications PCT/IB2021/060748 (priority November 20, 2020) (especially the compounds of formula (21D) and PCT/IB2021/055387 (priority June 6, 2020) (especially the compounds of formula (21C)).

Fused polycyclic aromatic compounds and their syntheses are for example described in WO 2009/148015 A1. One preferred group of fused polycyclic aromatic compounds are indolocarbazoles. Examples of indolocarbazoles and their syntheses are described in EP 0 906 947 A1.

Specific examples for the compounds of formula (21) are:

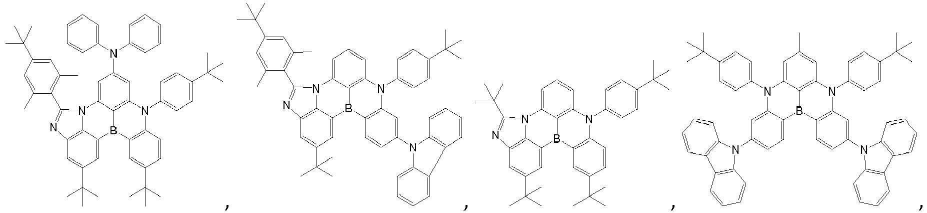

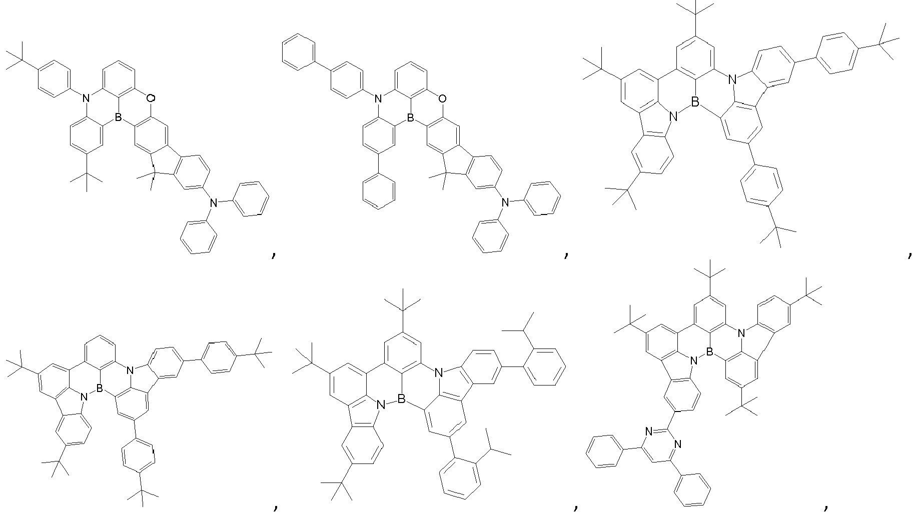

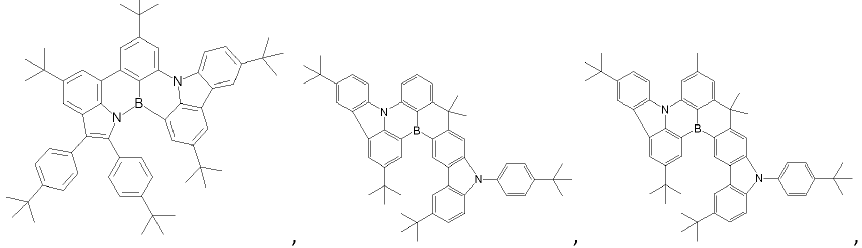

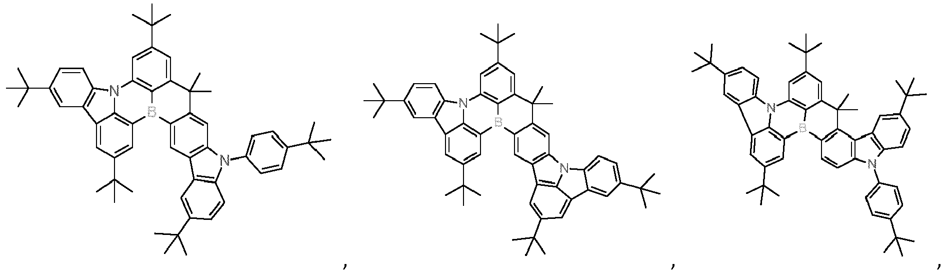

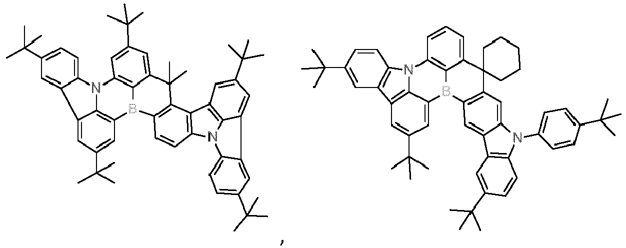

The following compound (22) is an example for an indolocarbazole compound as component (2): 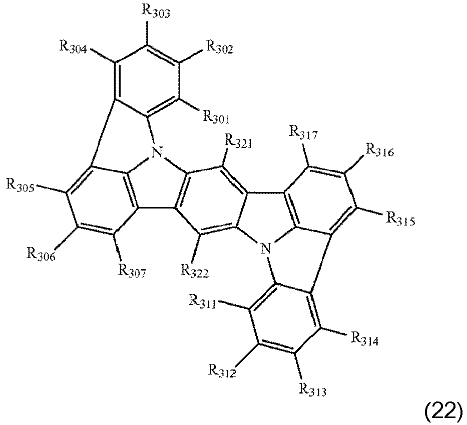 wherein, in the formula (22),
one or more pairs of two or more adjacent groups of R301 to R307 and R311 to R317 form a substituted or unsubstituted, saturated or unsaturated ring, or do not form a substituted or unsubstituted saturated or unsaturated ring;
R301 to R307 and R311 to R317 that do not form the substituted or unsubstituted, saturated or unsaturated ring each independently represent a hydrogen atom, a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms;
R321 and R322 each independently represent a hydrogen atom, a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms.

Specific examples for the compounds of formula (22) are:

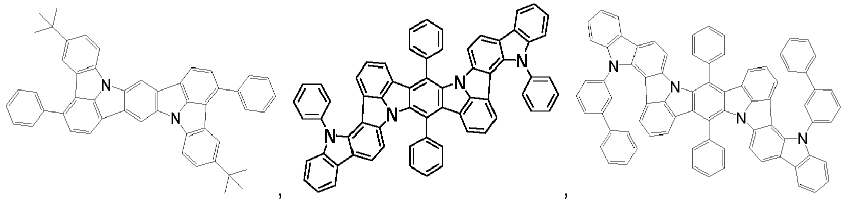

The compounds of formula (22) are for example described in US 2020/0111968 A1, US 2020/0098994 A1, US 2019/0355914 A1 and New J. Chem. 2010, 34, 1243-1246.

### Component (3)

Component (3) is at least one organic compound whose ionization potential is in absolute values lower than 5.33 eV and whose onset of fluorescence is at higher energies than that of component (2).

Wherein the onset of fluorescence is determined by linear fitting of the high energy side of the spectra; and the ionization potential of component (2) and component (3) is measured by cyclic voltammetry.

Component (3) is usually no TADF compound. One of the important factors that determine the efficiency of TADF is the energy gap between the lowest singlet (Si) and triplet (T₁) excited states (Δ*E*_{ST}), which should be small enough that the generated triplet excitons overcome it by thermal energy at room temperature to be converted into singlet excitons (usually<0.2eV).

Preferably, component (3) has energy difference between fluorescence and phosphorescence onsets (Δ*E*_{ST}) of more than 0.20 eV, preferably more than 0.3 eV, more preferably more than 0.4 eV.

Wherein the energy difference is determined by fluorescence versus phosphorescence onsets (Δ*E*_{ST}).

Wherein the onset of phosphorescence is determined by linear fitting of the high energy side of the phosphorescence spectra.

Component (3) is different from components (1) and (2) and is for example represented by the following formula (31) 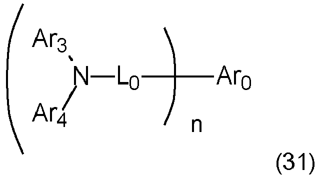 wherein
Ar₀ is a substituted or unsubstituted aromatic hydrocarbon group having 6 to 50 ring carbon atoms, preferably fused aromatic hydrocarbon group, or substituted or unsubstituted heterocyclic group having 5 to 50 ring atoms;
Ar₃ and A₄ are independently a substituted or unsubstituted aryl group having 6 to 50 ring carbon atoms, a substituted or unsubstituted heterocyclic ring group having 5 to 50 ring atoms, a substituted or unsubstituted alkyl group having 1 to 30 carbon atoms, a substituted or unsubstituted aralkyl group having 7 to 50 ring carbon atoms; Ar₃ and A₄ may be bonded together to form a saturated or unsaturated ring; when n is 2 or more, plural Ar₃ are mutually the same or different and plural Ar₄ are mutually the same or different;
L₀ is a direct bond or a linking group; L₀ in a form of the linking group is preferably selected from the group consisting of a substituted or unsubstituted aromatic hydrocarbon group having 6 to 30 ring carbon atoms and a substituted or unsubstituted heterocyclic group having 5 to 30 ring atoms; and when n is 2 or more, plural L₀ are mutually the same or different; preferably, L₀ is a direct bond;
n is an integer of 1 to 4, preferably 1 or 2.

In the first exemplary embodiment, Ar₀ in the formula (31) is preferably a group having a pyrene skeleton, an indolocarbazole skeleton, a fluorene skeleton, a dinaphthylfuran skeleton or a chrysene skeleton.

Further, in the first exemplary embodiment, when n in the formula (31) is 2, L₀ are both preferably single bonds.

When Ar₀ is a pyrene skeleton, n is 2, and L₀ is a single bond, the nitrogen atom in the formula (31) is preferably bonded to position 3 or 8 of the pyrene skeleton. When Ar₀ is a chrysene skeleton, n is 2, and L₀ is a single bond, the nitrogen atom in the formula (31) is preferably bonded to position 6 or 12 of the chrysene skeleton.

Compounds of formula (31) are for example mentioned in US 2018/0130968 A1 and WO 2018/124313.

Examples for compounds of formula (31) are the following compounds: 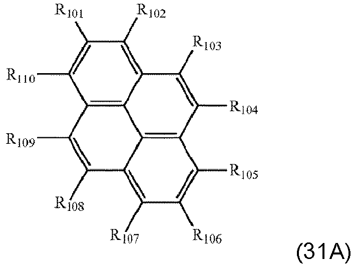 In the formula (31A),
one or more pairs of two or more adjacent groups of R101 to R110 are bonded with each other to form a substituted or unsubstituted, saturated or unsaturated ring, or do not form a substituted or unsubstituted, saturated or unsaturated ring;
at least one of R101 to R110 is a monovalent group represented by the formula (311);
R101 to R110 to that do not form the substituted or unsubstituted, saturated or unsaturated ring and that are not a monovalent group represented by the following formula (311) each independently represents a hydrogen atom, a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms; 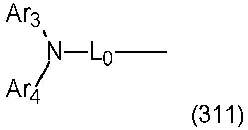
wherein Ar₃, Ar₄ and L₀ in the formula (311) are as defined in formula (31). 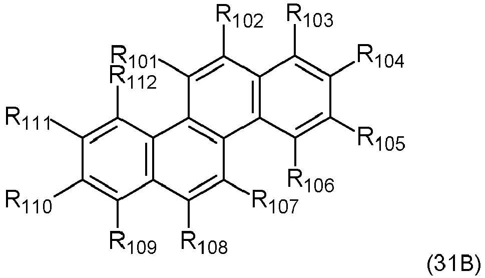 In the formula (31B),
one or more pairs of two or more adjacent groups of R101 to R112 are bonded with each other to form a substituted or unsubstituted, saturated or unsaturated ring, or do not form a substituted or unsubstituted, saturated or unsaturated ring;
at least one of R101 to R112 is a monovalent group represented by the formula (311);
R101 to R112 to that do not form the substituted or unsubstituted, saturated or unsaturated ring and that are not a monovalent group represented by the following formula (311) each independently represents a hydrogen atom, a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms; 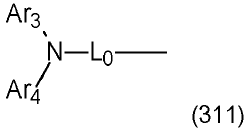
wherein Ar₃, Ar₄ and L₀ in the formula (311) are as defined in formula (31). 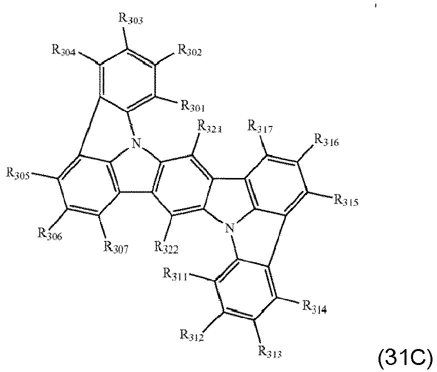 wherein, in the formula (31C),
one or more pairs of two or more adjacent groups of R301 to R307 and R311 to R317 form a substituted or unsubstituted, saturated or unsaturated ring, or do not form a substituted or unsubstituted, saturated or unsaturated ring;
R301 to R307 and R311 to R317 that do not form the substituted or unsubstituted, saturated or unsaturated ring each independently represents a hydrogen atom, a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms;
R321 and R322 each independently represents a hydrogen atom, a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms; and
at least one of R301 to R307 and R311 to R317 , preferably two of R301 to R307 and R311 to R317 is a group represented by formula (311); 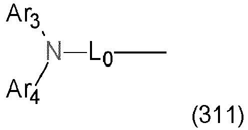
wherein Ar₃, Ar₄ and L₀ in the formula (311) are as defined in formula (31). 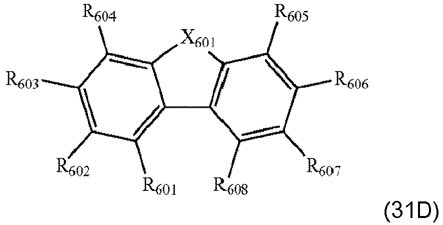 wherein, in the formula (31D),
at least one pair of R601 and R602 , R602 and R603 , and R603 and R604 are bonded with each other to form a divalent group represented by the formula (331);
at least one pair of R605 and R606 , R606 and R607 , and R607 and R608 are bonded with each other to form a divalent group represented by formula (332);

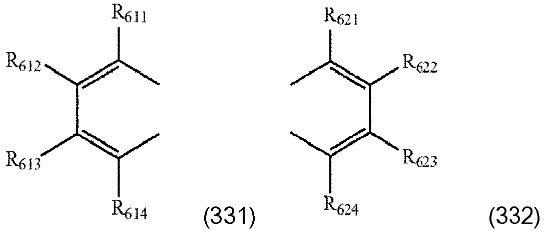

at least one of R601 to R604 that does not form the divalent group represented by the formula (331), or at least one of R611 to R614 is a monovalent group represented by the following formula (311); and/or
at least one of R605 to R608 that do not form the divalent group represented by the formula (332), or at least one of R621 to R624 is a monovalent group represented by the following formula (311);
X601 is an oxygen atom, a sulfur atom, or NR609, preferably an oxygen atom;
R601 to R608 that do not form the divalent group represented by the formulas (331) and (332) and that is not the monovalent group represented by the formula (311), R611 to R614 and R621 to R624 that are not the monovalent group represented by the formula (311), and R609 each independently represents a hydrogen atom, a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms; 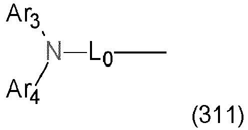
wherein Ar₃, Ar₄ and L₀ in the formula (311) are as defined in formula (31). 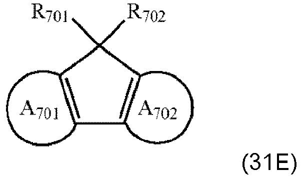 wherein, in the formula (31E),
A701 ring and A702 ring each independently represents a substituted or unsubstituted aromatic hydrocarbon ring having 6 to 50 ring carbon atoms, or a substituted or unsubstituted heterocyclic ring having 5 to 50 ring atoms;
one or more rings selected from the group consisting of A701 ring and A702 ring are bonded to the bond * of the structure represented by the following formula (351); 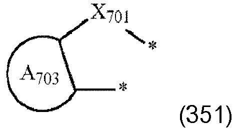
wherein, in the formula (351),
A703 rings each independently represents a substituted or unsubstituted aromatic hydrocarbon ring having 6 to 50 ring carbon atoms, or a substituted or unsubstituted heterocyclic ring having 5 to 50 ring atoms;
X701 is N R703 , C(R704)(R705), Si(R706) (R707), Ge(R708) (R709), O, S or Se;
R701 and R702 are bonded with each other to form a substituted or unsubstituted, saturated or unsaturated ring or do not form a substituted or unsubstituted saturated or unsaturated ring; R701 and R702 that do not form the substituted or unsubstituted, saturated or unsaturated ring, and R703 to R709 each independently represents a hydrogen atom, a substituted or unsubstituted alkyl group having 1 to 50 carbon atoms, a substituted or unsubstituted alkenyl group having 2 to 50 carbon atoms, a substituted or unsubstituted alkynyl group having 2 to 50 carbon atoms, a substituted or unsubstituted cycloalkyl group having 3 to 50 ring carbon atoms, a substituted or unsubstituted aryl group having 6 to 50 ring carbon atoms, or a substituted or unsubstituted monovalent heterocyclic group having 5 to 50 ring atoms;
one or more selected from the group consisting of A701 ring and A702 ring is bonded to * in the structure represented by the formula (351);
at least one group represented by the formula (311) is bonded to one or both of A701 ring and A702 ring; 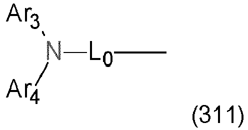
wherein Ar₃, Ar₄ and L₀ in the formula (311) are as defined in formula (31).

Suitable compounds of formula (3) are for example disclosed in US 2021/0005826 A1.

Examples for compounds of formula (3) are:

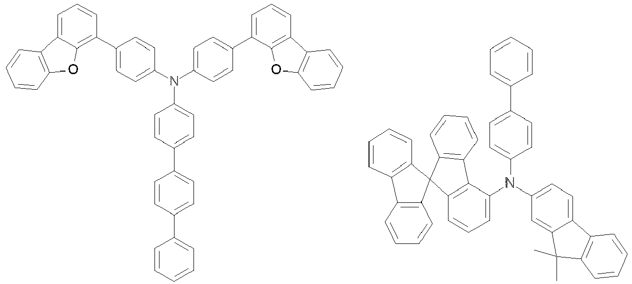

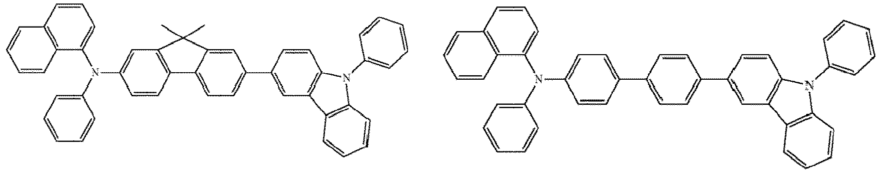

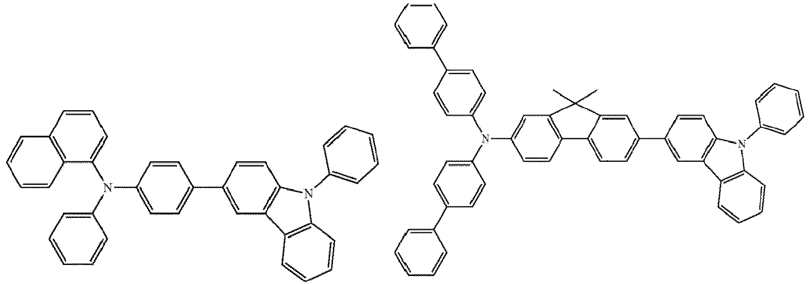

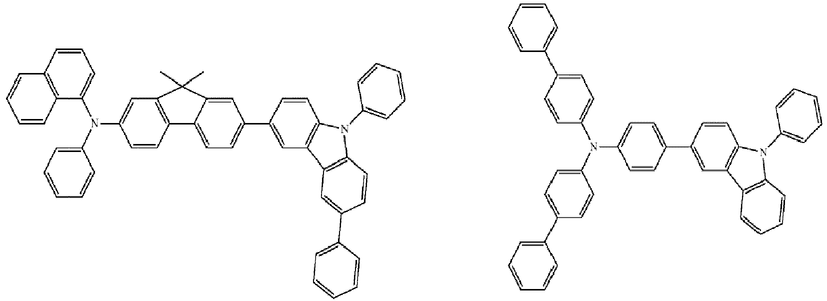

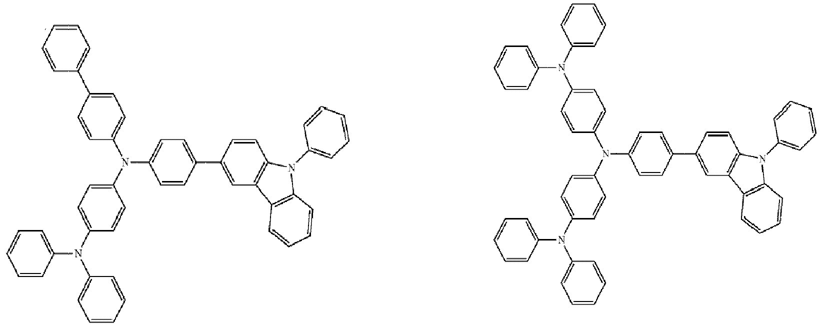

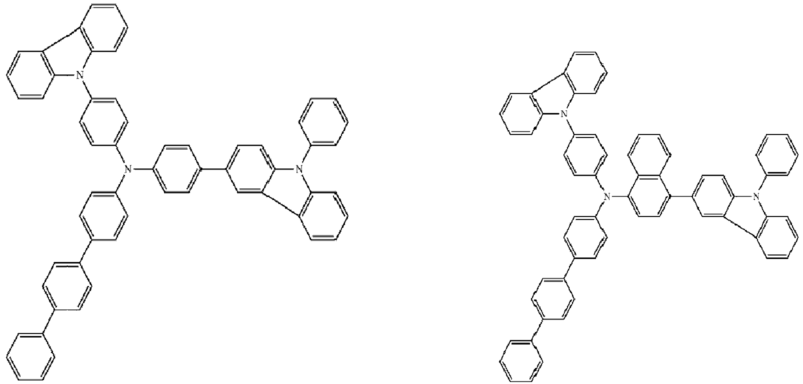

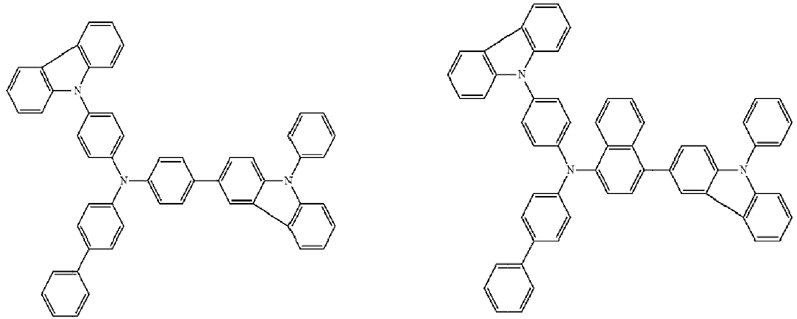

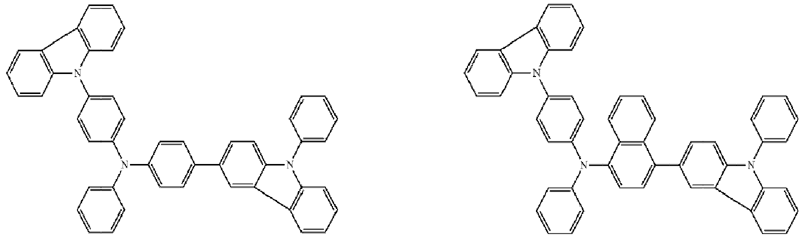

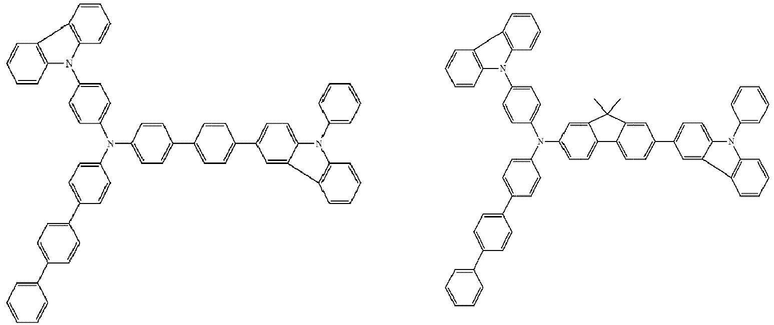

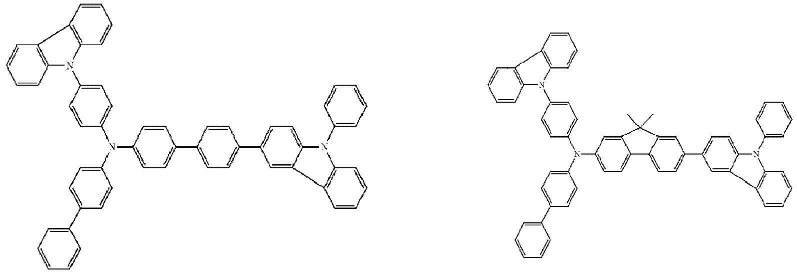

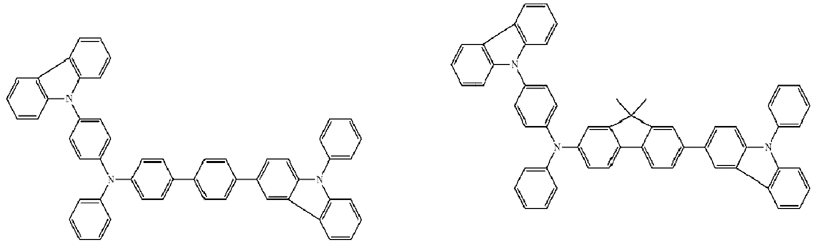

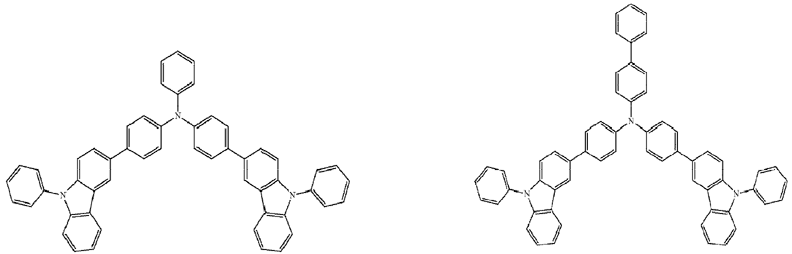

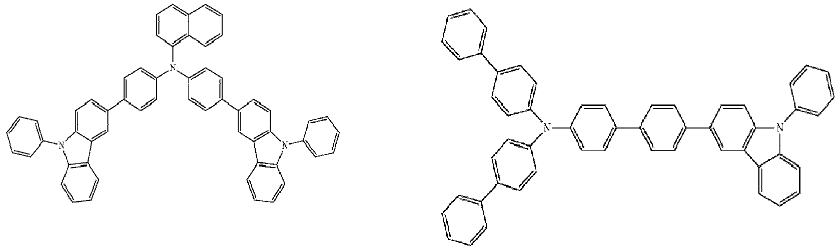

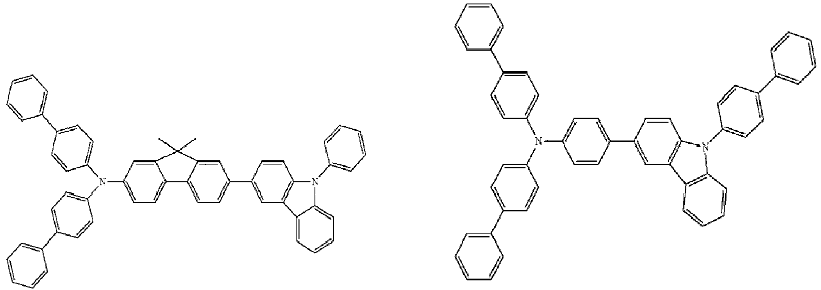

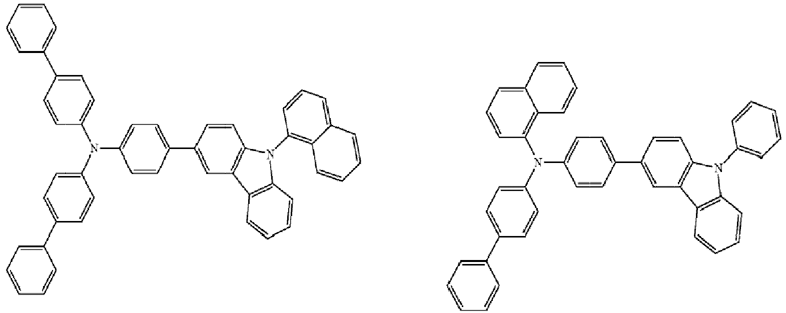

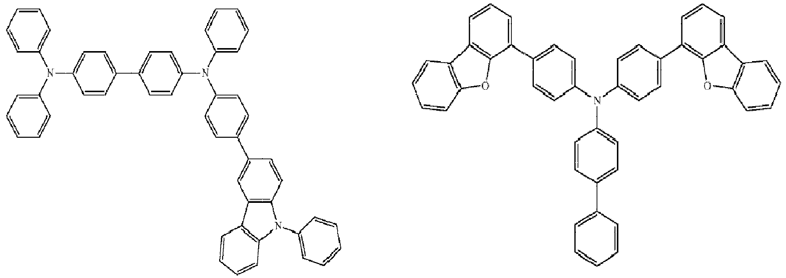

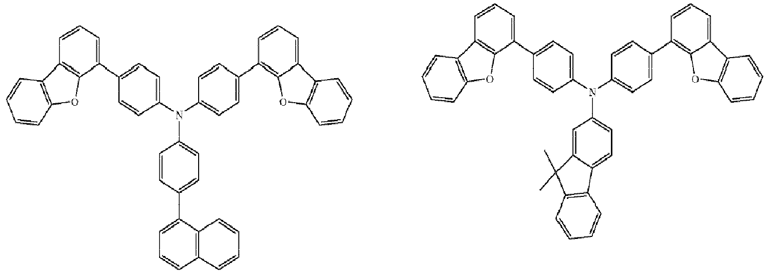

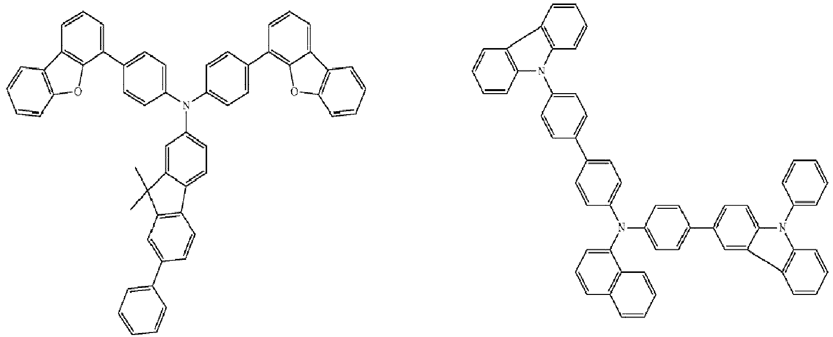

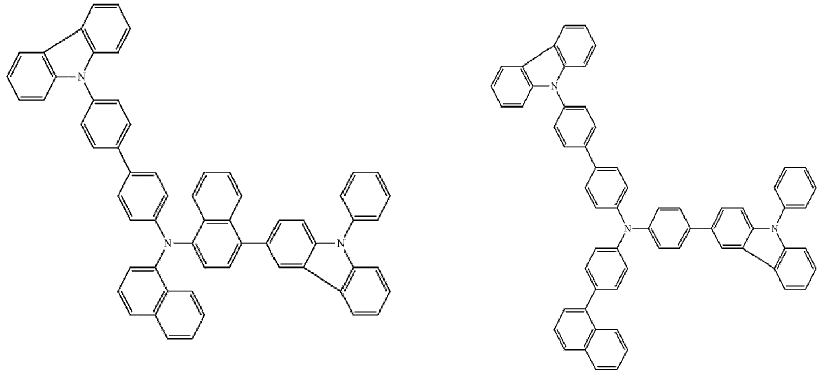

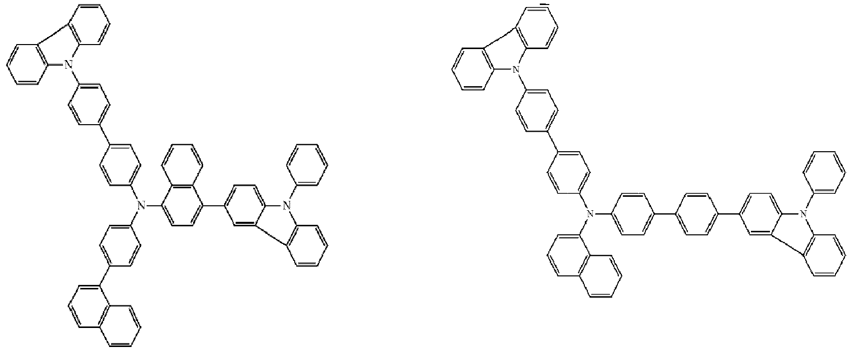

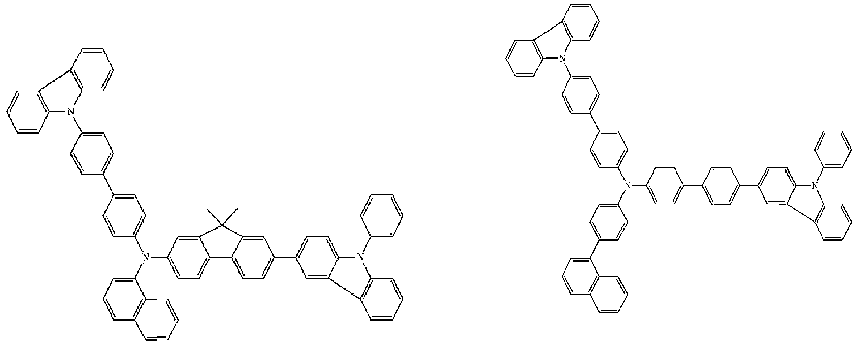

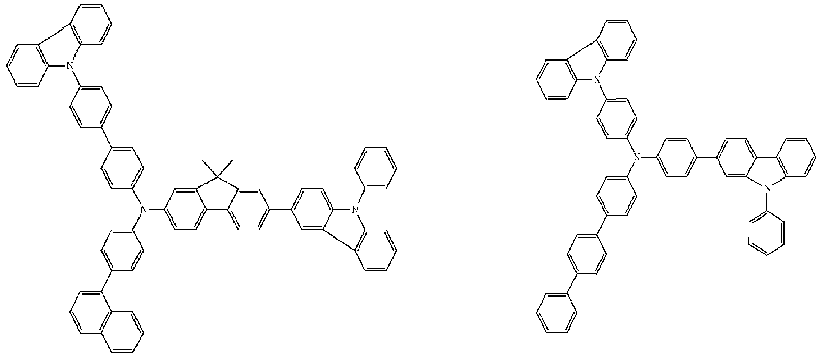

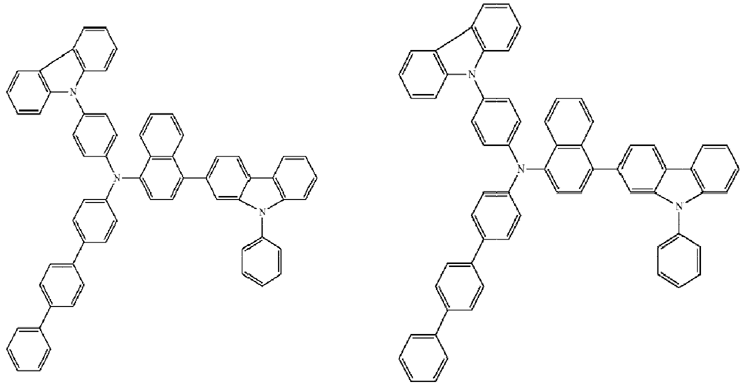

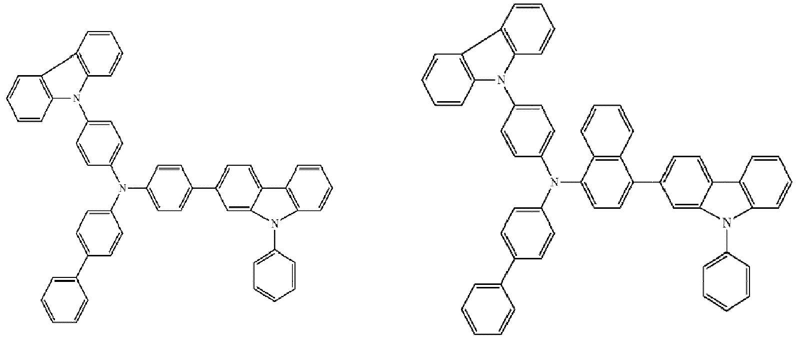

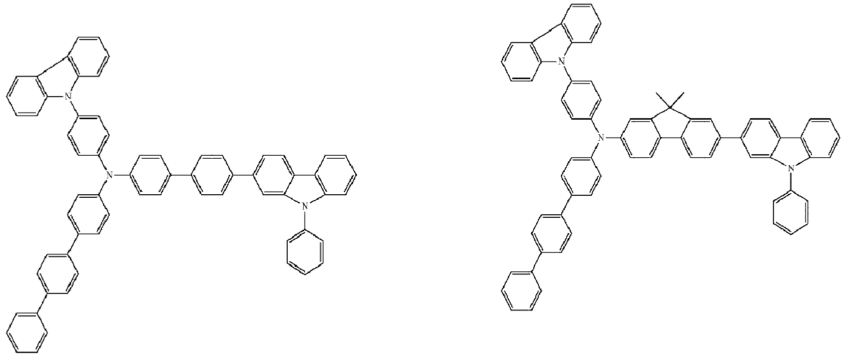

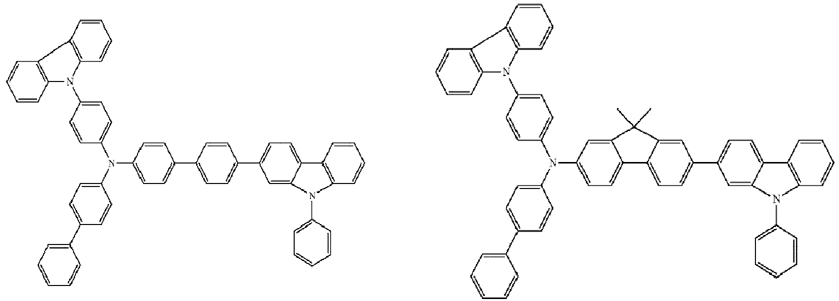

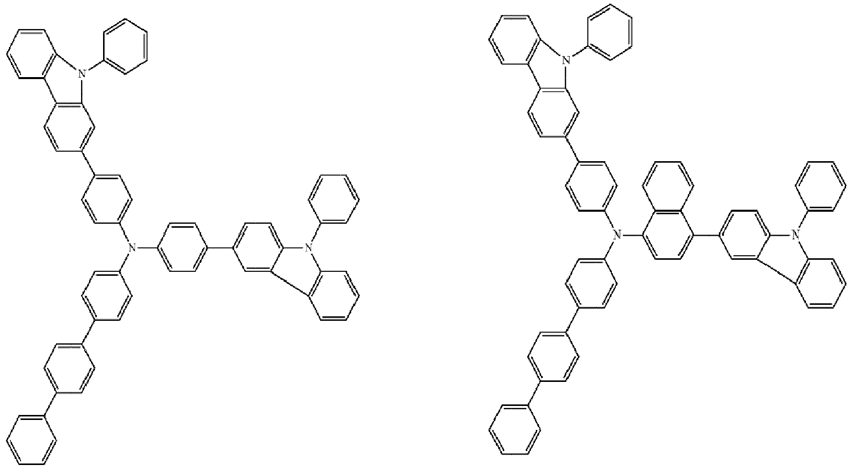

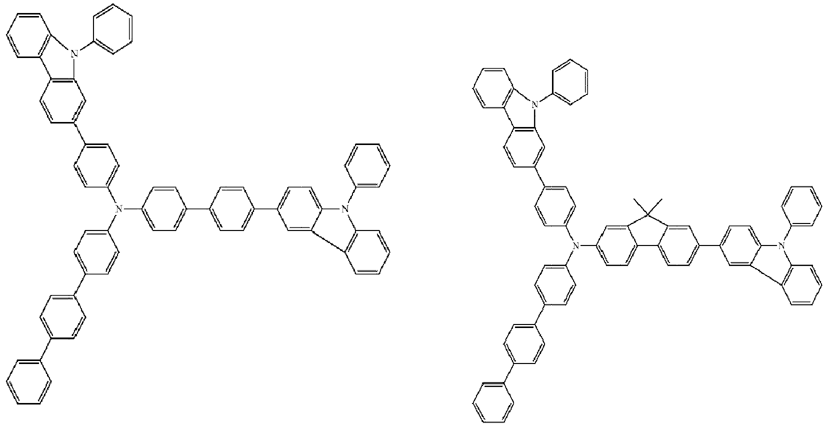

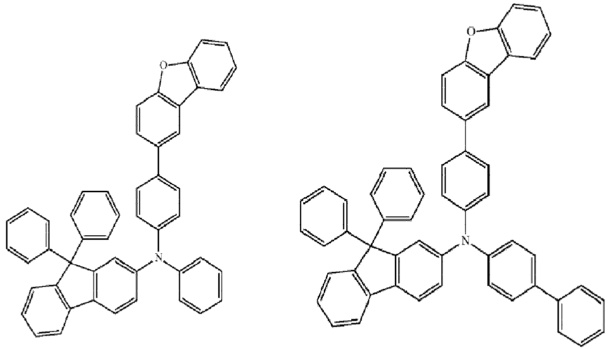

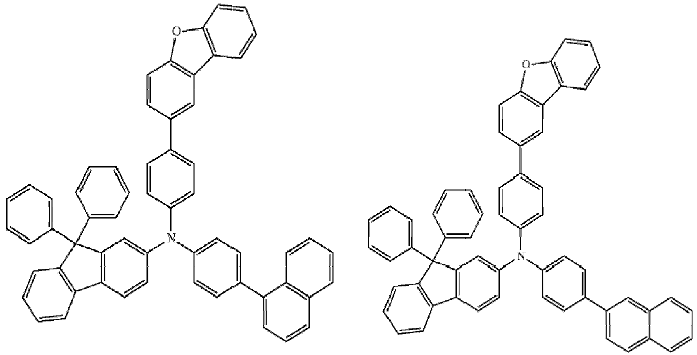

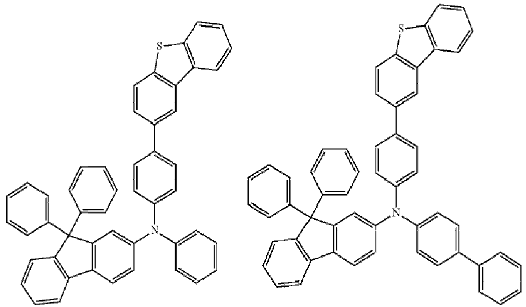

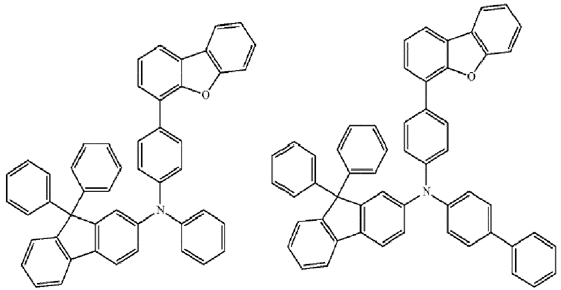

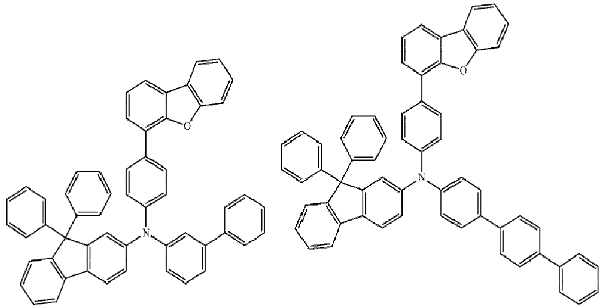

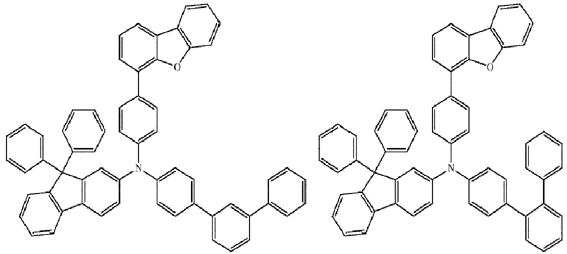

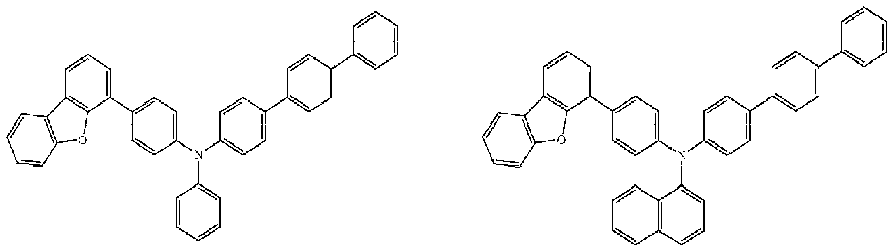

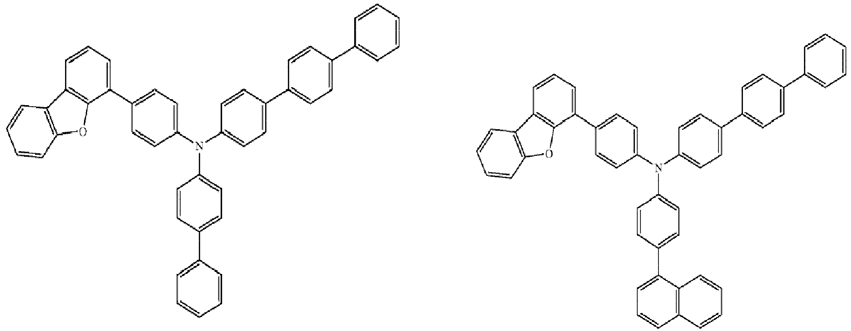

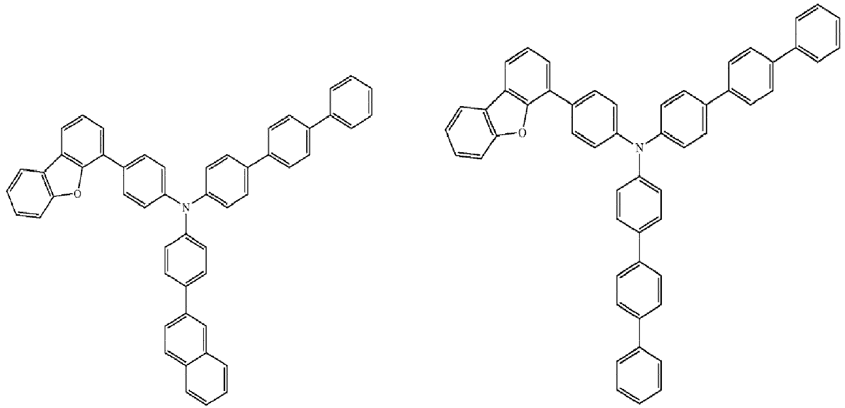

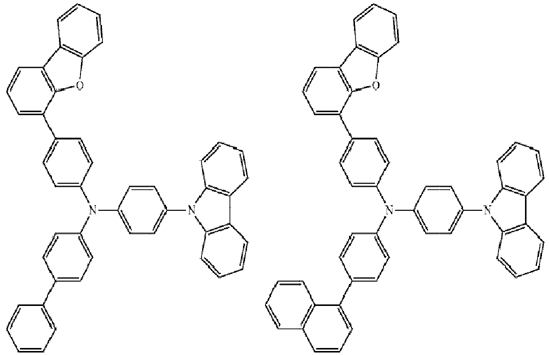

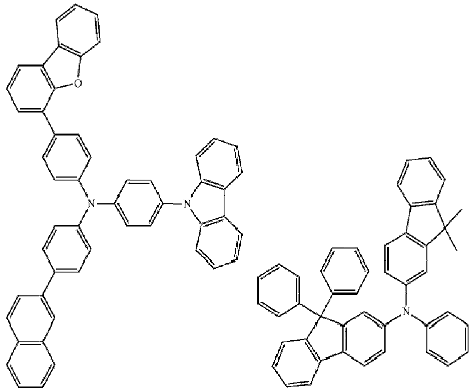

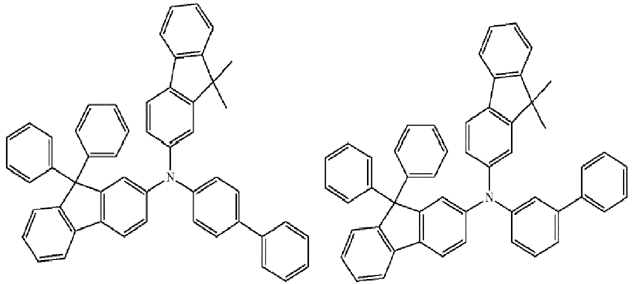

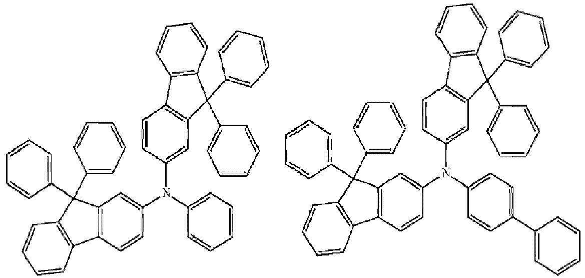

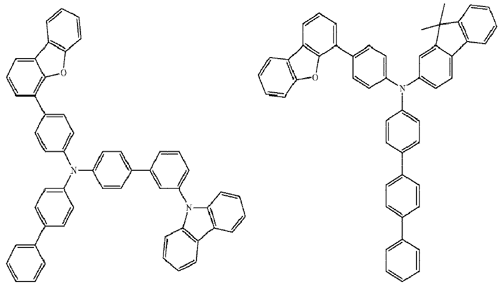

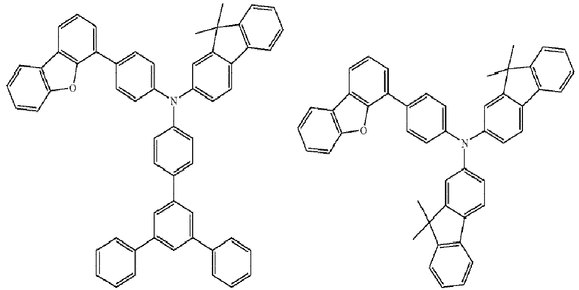

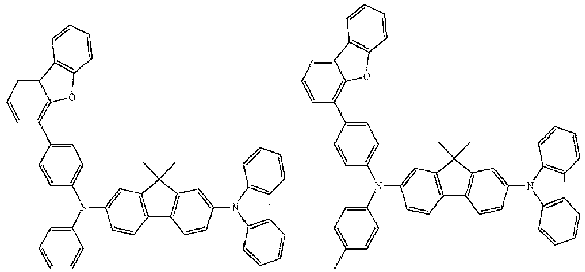

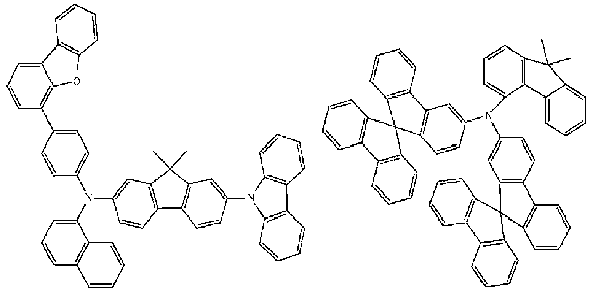

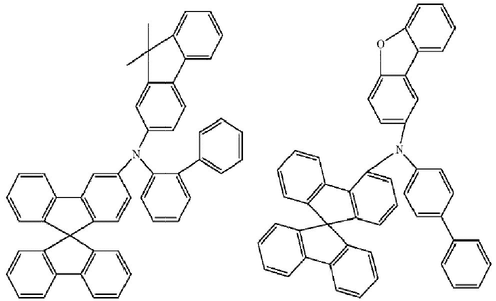

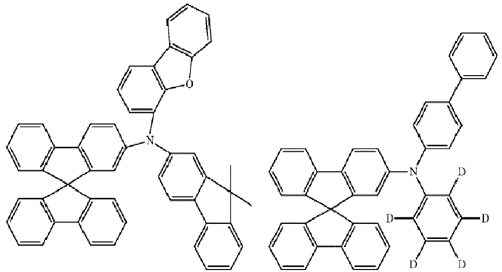

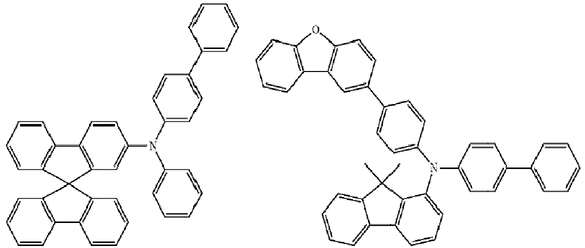

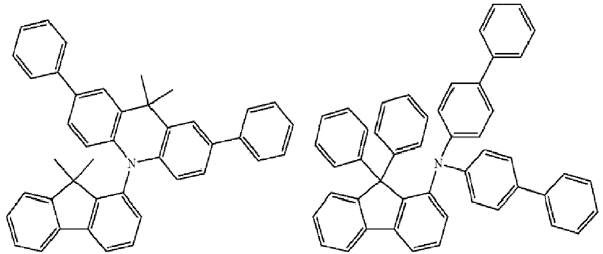

Component (2) is preferably present in the light emitting layer of the organcic electroluminescent device according to the present invention in an amount of 0.5% to 5% by weight, more preferably 0.75% to 4% by weight, most preferably 1 % to 3% by weight, based on the total amount of the light emitting layer.

Component (3) is preferably present in the light emitting layer of the organcic electroluminescent device according to the present invention in an amount of 0.5% to 5% by weight, more preferably 0.75% to 4% by weight, most preferably 1 % to 3% by weight, based on the total amount of the light emitting layer.

The light emitting layer of of the organcic electroluminescent device according to the present invention therefore preferably comprises 0.5% to 5% by weight, preferably 0.75% to 4% by weight, more preferably 1% to 3% by weight, based on the total amount of the light emitting layer, of component (2), 0.5% to 5% by weight, preferably 0.75% to 4% by weight, more preferably 1% to 3% by weight, based on the total amount of the light emitting layer, of component (3) and 90% by weight to 99% by weight, preferably 92% to 98.5% by weight, more preferably 94% to 98% by weight, based on the total amount of the light emitting layer of component (1), wherein the total amount of the light emitting layer adds up to 100% by weight. Component (2) and (3) are preferably present in the light emitting layer of the organic electroluminescence device according to the present invention in a mass ratio of 0.1 to 5 : 1, preferably 0.3 to 3 : 1, more preferably 0.5 to 2 : 1.

The present invention further relates to a material comprising components (2) and (3) as defined above. Preferably, component (2) and (3) are present in the material in the weight ratio mentioned above.

In a further preferred embodiment, the material additionally comprises component (1) as defined above. Preferably, components (1), (2) and (3) are present in the material in the amounts mentioned above, and more preferably, also in the weight ratio of components (2) and (3) as mentioned above.

The material mentioned above can be a simple mixture of at least two powders of components (2) and (3), or an organic alloy of components (2) and (3).

In a preferred embodiment, the material is an organic alloy for an organic electroluminescence device, which is an organic alloy of at least two kinds of organic compounds, the at least two kinds of organic compounds includes a first organic compound, component (2), and a second organic compound, component (3), a difference between evaporation temperatures of the first organic compound and the second organic compound is preferably less than or equal to 20 °C at preferably less than or equal to 0.133 Pa (10⁻³ torr). More preferably, the difference between evaporation temperatures of the first organic compound and the second organic compound is 0 °C to 10 °C at less than or equal to 0.133 Pa (10⁻³ torr). Generally, the organic alloy is present as a solid or powder at room temperature.

The organic alloy is according to the present invention a material obtained by pre-treating the at least two kinds of organic compounds. The pre-treating may be a heat treatment such as heating and sublimation followed by cooling, or at least two kinds of organic compounds are dissolved together in common solvent and precipitated, but is not limited thereto.

### Component (4)

The inventive organic electroluminescence device comprises beside a cathode, an anode and an emitting layer having an anode side and a cathode side disposed between the cathode and the anode a further layer next to the anode side of the emitting layer comprising a compound fulfilling the following requirement:
Ionization potential in absolute values of component (1) - Ionization potential in absolute values of component (4) ≤ 0.35 eV, as component (4);
   wherein
the ionization potential of component (1) and component (4) is measured by photoelectron spectroscopy.

I.e. the difference between the absolute value of the ionization potential of compound (1) and the absolute value of the ionization potential of component (4) is equal to ot less than 0.35 eV, preferably a value between 0 eV and 0.35 eV.

Component (4) is generally a hole transporting material, which is present in the layer next to the anode side of the emitting layer. Said layer defined as "electron blocking layer" in the present application.

The component 4 present in the organic electroluminescent device of the present invention is generally different from component 3 present in the organic electroluminescent device of the present invention.

Preferably, component (4) is an aromatic amine represented by the following formula (4) 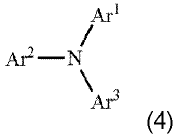 wherein
Ar¹, Ar² and Ar³ each independently represents a substituted or unsubstituted non-fused aryl group having 6 to 50, preferably 6 to 30, more preferably 6 to 20, and still more preferably 6 to 12 ring carbon atoms, a substituted or unsubstituted fused aryl group having 6 to 50, preferably 6 to 30, more preferably 6 to 20, and still more preferably 6 to 12 ring carbon atoms, a substituted or unsubstituted non-fused heteroaryl group having 5 to 50, preferably 5 to 30, more preferably 5 to 20, and still more preferably 5 to 12 ring atoms, a substituted or unsubstituted fused heteroaryl group having 5 to 50, preferably 5 to 30, more preferably 5 to 20, and still more preferably 5 to 12 ring atoms, or a group wherein the non-fused aryl group or the fused aryl group is bonded to the non-fused heteroaryl group or the fused heteroaryl group;
Ar¹ and Ar², Ar² and/or Ar³ and Ar³ and Ar¹ may be bonded to each other to form a ring.

Suitable optional substituents are the substituents mentioned above.

Compounds suitable as component (4) are for example disclosed in US 2020/052212 A1.

Examples of compounds of formula (4) are shown below.

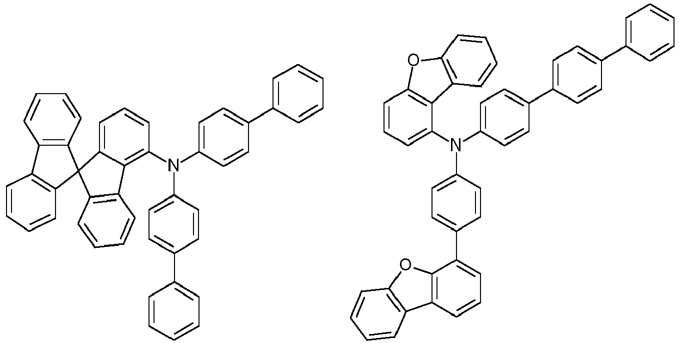

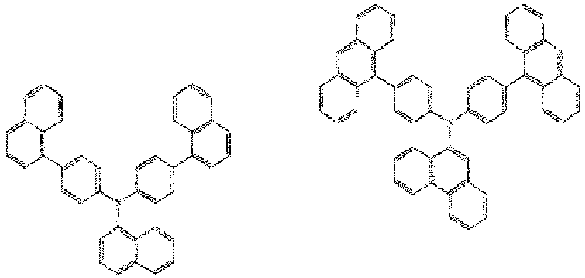

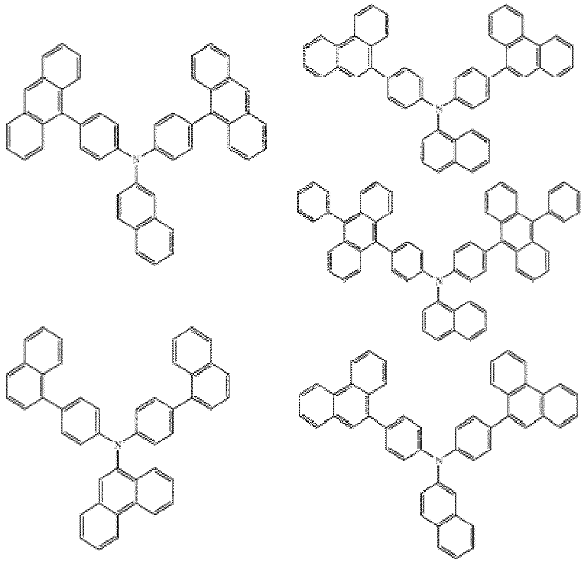

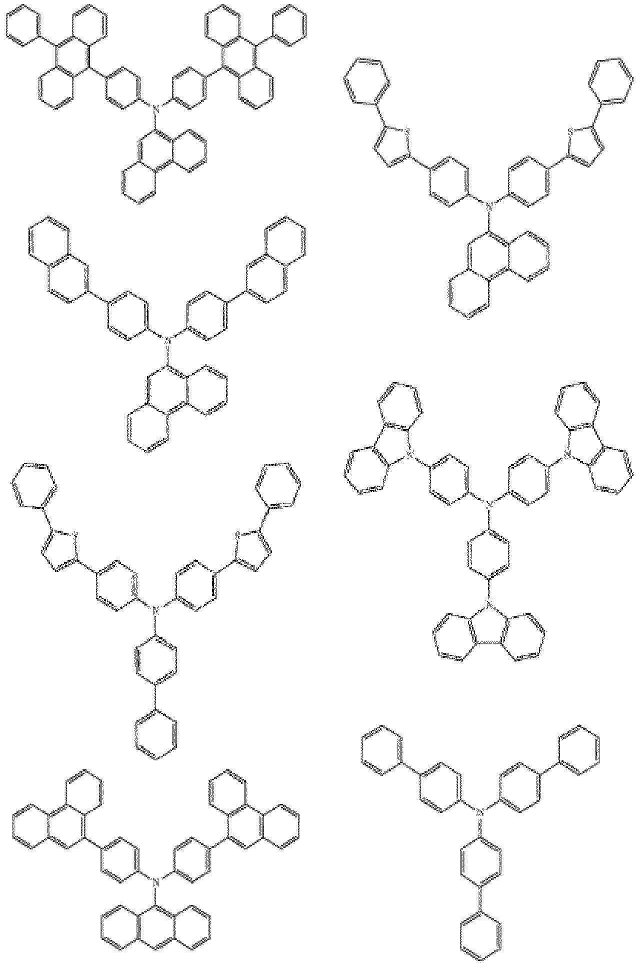

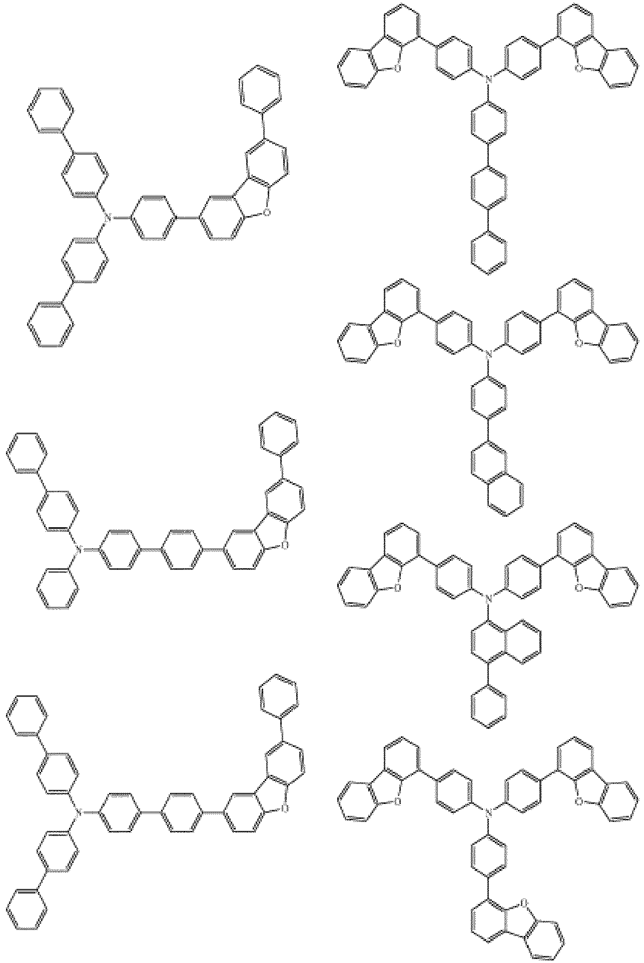

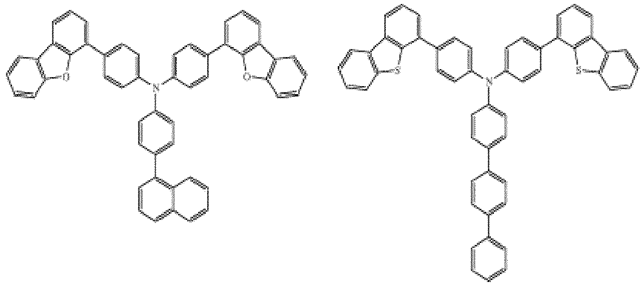

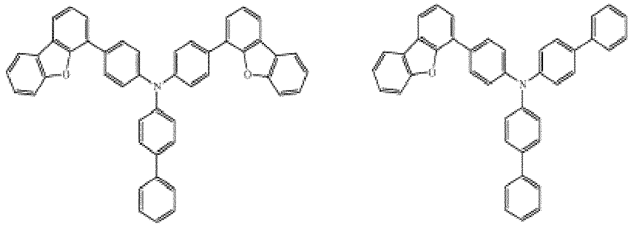

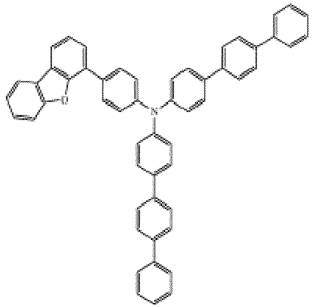

The present invention further relates to a material being in form of a layer structure comprising A first layer comprising
(i) at least one component (1);
(ii) at least one component (2);
(iii) at least one component (3);
as defined above, and
a further layer
comprising a compound having an ionization potential which is not more than 0.35 eV lower than that of component (1), as component (4) as defined above. The further layer is generally present next to the first layer.

The present invention further relates to a composition comprising components (1), (2) and (3) as defined above, wherein component (3) is present in the composition in an amount of 5% by weight or less, preferably in an amount of 0.5% to 5% by weight, based on the total amount of the composition and an organic electroluminescence device comprising a cathode, an anode and an emitting layer disposed between the cathode and the anode, wherein the emitting layer comprises said composition.

The present invention further relates to an electronic equipment comprising the inventive organic electroluminescence device, the inventive material or the inventive composition.

The present invention further relates to the use of the inventive material or the inventive composition in a light emitting layer of an organic electroluminescence device.

### Organic electroluminescence device

The present invention relates to an organic electroluminescence device comprising a cathode, an anode and an emitting layer having an anode side and a cathode side disposed between the cathode and the anode, and a further layer next to the anode side of the emitting layer wherein the emitting layer comprises
(i) At least one compound with a dipole moment of less than 1.7 · 10⁻³⁰ Cm (0.5 debye), preferably less than 1.3 · 10⁻³⁰ Cm (0.4 debye), more preferably 1.0 · 10⁻³⁰ Cm (0.3 debye), as component (1), preferably having a fluorescence onset of >2.75 eV;
(ii) At least one organic fluorescent compound whose onset of fluorescence is at lower energies than that of component (1) and at an energy higher than 2.6 eV, whose photoluminescence quantum yield is higher than 70% and whose ionization potential in absolute values is higher than 5.33 eV, as component (2);
(iii) At least one organic compound whose ionization potential in absolute values is lower than 5.33 eV and whose onset of fluorescence is at higher energies than that of component (2), as component (3);
and
the further layer comprising a compound
fulfilling the following requirement:
Ionization potential in absolute values of component (1) - Ionization potential in absolute values of component (4) ≤ 0.35 eV, as component (4).

Preferred embodiments of components (1), (2), (3) and (4) are defined above.

The present invention further relates to an organic electroluminescence device comprising a cathode, an anode and an emitting layer disposed between the cathode and the anode, wherein the emitting layer comprises a composition comprising components (1), (2) and (3) as defined above, wherein component (3) is present in the composition in an amount of 5% by weight or less, preferably in an amount of 0.5% to 5% by weight, based on the total amount of the composition.

According to the present invention, the dipole moment is computed using the DFT method with the Gaussian 16 software;
the onset of fluorescence is determined by linear fitting of the high energy side of the spectra; the photoluminescence quantum yield is measured with an integrating sphere;
the ionization potential of component (2) and component (3) is measured by cyclic voltammetry; and
the ionization potential of component (1) and component (4) is measured by photoelectron spectroscopy.

The emitting layer may comprise one or more additional host materials, beside component (1). As additional host material, metal complexes such as aluminum complexes, beryllium complexes and zinc complexes; heterocyclic compounds such as indole compounds, pyridine compounds, pyrimidine compounds, triazine compounds, quinoline compounds, isoquinoline compounds, quinazoline compounds, dibenzofuran compounds, dibenzothiophene compounds, oxadiazole compounds, benzimidazole compounds, phenanthroline compounds; fused polyaromatic hydrocarbon (PAH) compounds such as a naphthalene compound, a triphenylene compound, a carbazole compound, an anthracene compound other than component (1), a phenanthrene compound, a pyrene compound, a chrysene compound, a naphthacene compound, a fluoranthene compound; and aromatic amine compound such as triarylamine compounds and fused polycyclic aromatic amine compounds can be given, for example. Plural types of host materials can be used in combination.

Preferred additional host materials are substituted or unsubstituted polyaromatic hydrocarbon (PAH) compounds, substituted or unsubstituted polyheteroaromatic compounds, substituted or unsubstituted anthracene compounds, or substituted or unsubstituted pyrene compounds, preferably substituted or unsubstituted anthracene compounds other than component (1) or substituted or unsubstituted pyrene compounds.

If an additional host material is present in the light emitting layer of the organcic electroluminescent device according to the present invention, the additional host material preferably constitutes from 8.5% by weight to 79% by weight, more preferably 17% by weight to 69% by weight and most preferably 25% by weight to 59% by weight, based on the total amount of the light emitting layer. The amount of component (1) mentioned above is reduced in this case accordingly.

In the case that an additional host compound is present, the light emitting layer of the organcic electroluminescent device according to the present invention therefore preferably comprises 0.5% to 5% by weight, preferably 0.75% to 4% by weight, more preferably 1% to 3% by weight, based on the total amount of the light emitting layer, of component (2), 0.5% to 5% by weight, preferably 0.75% to 4% by weight, more preferably 1% to 3% by weight, based on the total amount of the light emitting layer, of component (3) and 11% by weight to 90.5% by weight, preferably 23% to 81.5% by weight, more preferably 35% to 73% by weight, based on the total amount of the light emitting layer of component (1), and 8.5% to 79% by weight, preferably 17% to 69% by weight, more preferably 25% to 59% by weight of at least one additional host material, wherein the total amount of the light emitting layer adds up to 100% by weight.

Preferably, the organic electroluminescence device comprises in addition to the cathode, the anode, the emitting layer having an anode side and a cathode side, in one preferred embodiment, the further layer next to the anode side of the emitting layer, one or more additional organic thin film layers disposed between the cathode and the anode.

### Layer(s) between the emitting layer and the anode:

In the organic EL device according to the present invention, one or more organic thin film layers may be present between the emitting layer and the anode. If only one organic layer is present between the emitting layer and the anode, it means that layer, and if plural organic layers are present, it means at least one layer thereof. For example, if two or more organic layers are present between the emitting layer and the anode, an organic layer nearest to the emitting layer is called the "electron-blocking layer", an organic layer nearest to the "electron-blocking layer" is called the "hole-transporting layer", and an organic layer nearer to the anode is called the "hole-injecting layer". Each of the "electron-blocking layer", the "hole-transporting layer" and the "hole-injecting layer" may be a single layer or may be formed of two or more layers. One of these layers may be a single layer and the other may be formed of two or more layers. The "the further layer next to the anode side of the emitting layer" present in one embodiment according to the present invention is therefore generally called "electron-blocking layer".

### Layer(s) between the emitting layer and the cathode:

Similarly, one or more organic thin film layers may be present between the emitting layer and the cathode, in the organic EL device according to the present invention (i.e. electron-transporting zone, at least including an electron-transporting layer and preferably also an electron-injecting layer and/or a hole-blocking layer). If only one organic layer is present between the emitting layer and the cathode it means that layer, and if plural organic layers are present, it means at least one layer thereof. For example, if two or more organic layers are present between the emitting layer and the cathode, an organic layer nearest to the emitting layer is called the "hole-blocking layer", an organic layer nearest to the "hole-blocking layer" is called the "electron-transporting layer", and an organic layer nearer to the cathode is called the "electron-injecting layer". Each of the "hole-blocking layer", "electron-transporting layer" and the "electron-injecting layer" may be a single layer or may be formed of two or more layers. One of these layers may be a single layer and the other may be formed of two or more layers.

In an exemplary embodiment, the one or more organic thin film layers of the organic EL device of the present invention at least include the emitting layer and an electron-transporting zone. The electron-transporting zone is provided between the emitting layer and the cathode and at least includes an electron-transporting layer and preferably also an electron injecting layer and/or a hole-blocking layer. The electron-transporting zone may include the electron-injecting layer and an electron-transporting layer and may further include a hole-blocking layer and optionally a space layer. In addition to the above layers, the one or more organic thin film layers may be provided by layers applied in a known organic EL device such as a hole-injecting layer, a hole transporting layer and an electron-blocking layer.

### An explanation will be made on the layer configuration of the organic EL device according to one aspect of the invention.

An organic EL device according to one aspect of the invention comprises a cathode, an anode, and one or more organic thin film layers comprising an emitting layer and, in one preferred embodiment, the further layer next to the anode side of the emitting layer, disposed between the cathode and the anode. The organic layer comprises at least one layer composed of an organic compound. Alternatively, the organic layer is formed by laminating a plurality of layers composed of an organic compound. The organic layer may further comprise an inorganic compound in addition to the organic compound.

The organic EL device according to one aspect of the invention may be, for example, a fluorescent monochromatic light emitting device or a fluorescent hybrid white light emitting device or fluorescent and phosphorescent hybrid white light emitting device.

Further, it may be a simple type device having a single emitting unit or a tandem type device having a plurality of emitting units.

The "emitting unit" in the specification is the smallest unit that comprises organic layers, in which at least one of the organic layers is an emitting layer and light is emitted by recombination of injected holes and electrons.

The layer structure of the organic EL device is not particularly limited, but examples thereof include - beside the emitting layer and, in one preferred embodiment, the further layer next to the anode side of the emitting layer as described above - a further emitting layer, a spacing layer, and an electron-transporting zone (electron-transporting layer, electron-injecting layer, hole-blocking layer, etc.). The further layer next to the anode side of the emitting layer may be part of a hole-transporting zone (a hole-transporting layer, a hole-injecting layer, an electron-blocking layer (which is generally the further layer next to the anode side of the emitting layer), an exciton-blocking layer, etc.).

In addition, the emitting layer described in the present specification is an organic layer having an emitting function. The emitting layer is, for example, a fluorescent emitting layer, and may be a single layer, a double layer or a stack of a plurality of layers. The emitting layer may for example be a single emitting layer comprising components (1), (2) and (3) according to the present invention or a double emitting layer comprising components (1), (2) and (3) according to the present invention in a first emitting layer and comprising a second emitting layer comprising a host and a dopant which are the same or different from the host and the dopant in the first emitting layer. The second emitting layer is in the double emitting layer preferably on the cathode side of the first emitting layer.

The "emitting unit" may be a stacked type unit having a plurality of phosphorescent emitting layers and/or fluorescent emitting layers. In this case, for example, a spacing layer for preventing excitons generated in the phosphorescent emitting layer from diffusing into the fluorescent emitting layer may be provided between the respective light-emitting layers.

As the simple type organic EL device, a device configuration such as anode/emitting unit/cathode or anode/ electron-blocking layer/emitting unit/cathode can be given.

Examples for representative layer structures of the emitting unit are shown below. The layers in parentheses are provided arbitrarily:
(a) (Hole-injecting layer/) Hole-transporting layer/(Electron-blocking layer)/Fluorescent emitting layer (/Hole-blocking layer/Electron-transporting layer/Electron-injecting layer)
(b) (Hole-injecting layer/) Hole-transporting layer/(Electron-blocking layer)/First fluorescent emitting layer/Second fluorescent emitting layer (/Hole-blocking layer/Electron-transporting layer/Electron-injecting layer)
(c) (Hole-injecting layer/) Hole-transporting layer/(Electron-blocking layer)/Phosphorescent emitting layer/Spacing layer /Fluorescent emitting layer (/Hole-blocking layer/Electron-transporting layer/Electron-injecting layer)
(d) (Hole-injecting layer/) Hole-transporting layer/(Electron-blocking layer)/First phosphorescent emitting layer/Second phosphorescent emitting layer/Spacing layer/Fluorescent emitting layer (/Hole-blocking layer/Electron-transporting layer/Electron-injecting layer)
(e) (Hole-injecting layer/) Hole-transporting layer/(Electron-blocking layer)/First phosphorescent layer/Spacing layer/ Second phosphorescent emitting layer/Spacing layer/Fluorescent emitting layer (/Hole-blocking layer/Electron-transporting layer / Electron-injecting layer)
(f) (Hole-injecting layer/) Hole-transporting layer/(Electron-blocking layer)/Phosphorescent emitting layer/Spacing layer/First fluorescent emitting layer/Second fluorescent emitting layer (/Hole-blocking layer/Electron-transporting layer/Electron-injecting layer)
(g) (Hole-injecting layer/) Hole-transporting layer/Exciton-blocking layer/(Electron-blocking layer)/Fluorescent emitting layer (/Hole-blocking layer/Electron-transporting layer/Electron-injecting layer)
(h) (Hole-injecting layer/) First hole-transporting Layer/Second hole-transporting Layer/(Electron-blocking layer)/ Fluorescent emitting layer (/Hole-blocking layer/Electron-transporting layer/electron-injecting Layer)
(i) (Hole-injecting layer/) First hole-transporting layer/Second hole-transporting layer/(Electron-blocking layer)/ Fluorescent emitting layer (/Hole-blocking layer/First electron-transporting layer/Second electron-transporting layer /Electron-injection layer)
(j) (Hole-injecting layer/) Hole-transporting layer/(Electron-blocking layer)/Fluorescent emitting layer/Hole-blocking layer (/Hole-blocking layer/Electron-transporting layer/Electron-injecting layer)
(k) (Hole-injecting layer/) Hole-transporting layer/(Electron-blocking layer)/Fluorescent emitting layer /Exciton-blocking layer (/Hole-blocking layer/Electron-transporting layer/Electron-injecting layer)
(l) (Hole-injecting layer/) Hole-transporting layer/(Electron-blocking layer)/Fluorescent emitting layer/Spacing layer/Phosphorescent emitting layer (/Hole-blocking layer/Electron-transporting layer/Electron-injecting layer)
(m) (Hole-injecting layer/) Hole-transporting layer/(Electron-blocking layer)/Fluorescent emitting layer/Spacing layer/First phosphorescent emitting layer/Second phosphorescent emitting layer (/Hole-blocking layer/Electron-transporting layer/Electron-injecting layer)
(n) (Hole-injecting layer/) Hole-transporting layer/(Electron-blocking layer) /Fluorescent emitting layer/Spacing layer/First phosphorescent layer/Spacing layer/ Second phosphorescent emitting layer(/Hole-blocking layer/Electron-transporting layer / Electron-injecting layer)
(o) (Hole-injecting layer/) Hole-transporting layer/(Electron-blocking layer)/First fluorescent emitting layer/Second fluorescent emitting layer/Spacing layer/Phosphorescent emitting layer(/Hole-blocking layer/Electron-transporting Layer/Electron-injecting layer)
(p) (Hole-injecting layer/) Hole-transporting layer/(Electron-blocking layer)/First fluorescent emitting layer/Spacing layer/Phosphorescent emitting layer/Spacing layer/Second fluorescent emitting layer (/Hole-blocking layer/Electron-transporting layer/Electron-injecting layer)

The layer structure of the organic EL device according to one aspect of the invention is not limited to the examples mentioned above.

For example, when the organic EL device has a hole-injecting layer and a hole-transporting layer, it is preferred that a hole-injecting layer be provided between the hole-transporting layer and the anode. Further, when the organic EL device has an electron-injecting layer and an electron-transporting layer, it is preferred that an electron-injecting layer be provided between the electron-transporting layer and the cathode. Further, each of the hole-injecting layer, the hole-transporting layer, the electron-transporting layer, the electron-blocking layer and the electron-injecting layer may be formed of a single layer or be formed of a plurality of layers.

The plurality of phosphorescent emitting layers and/or fluorescent emitting layers may be emitting layers that emit mutually different colors. For example, the emitting unit (d) may include a hole-transporting layer/(an electron-blocking layer)/first phosphorescent layer (red light emission)/second phosphorescent emitting layer (green light emission)/spacing layer/fluorescent emitting layer (blue light emission)/electron-transporting layer.

An electron-blocking layer may be provided between each light emitting layer and the hole-transporting layer or the spacing layer. Further, a hole-blocking layer may be provided between each emitting layer and the electron-transporting layer. By providing the electron-blocking layer or the hole-blocking layer, it is possible to confine electrons or holes in the emitting layer, thereby to improve the recombination probability of carriers in the emitting layer, and to improve light emitting efficiency.

As a representative device configuration of a tandem type organic EL device, for example, a device configuration such as anode/first emitting unit/intermediate layer/second emitting unit/cathode can be given:

The first emitting unit and the second emitting unit are independently selected from the above-mentioned emitting units, for example.

Further suitable device configurations are, for example, a device configuration such as anode/first emitting unit/intermediate layer/second emitting unit/intermediate layer/third emitting unit/cathode; and
anode/first emitting unit/intermediate layer/second emitting unit/intermediate layer/third emitting unit/intermediate layer/fourth emitting unit/cathode.

The first emitting unit, the second emitting unit, the third emitting unit and the fourth emitting unit are independently selected from the above-mentioned emitting units, for example.

The intermediate layer is also generally referred to as an intermediate electrode, an intermediate conductive layer, a charge generating layer, an electron withdrawing layer, a connecting layer, a connector layer, or an intermediate insulating layer. The intermediate layer is a layer that supplies electrons to the first emitting unit and holes to the second emitting unit, and can be formed from known materials.

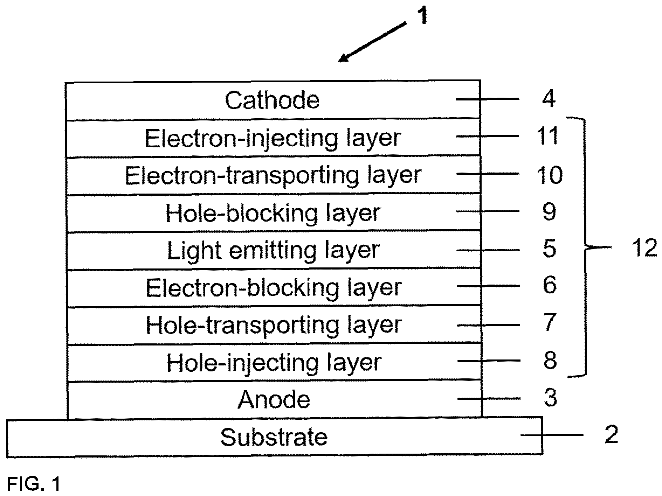

**FIG. 1** shows a schematic configuration of one example of the organic EL device of the invention. The organic EL device 1 comprises a substrate 2, an anode 3, a cathode 4 and an emitting unit 12 provided between the anode 3 and the cathode 4. The emitting unit 12 comprises an emitting layer 5 comprising components (1), (2) and (3). A hole-injecting layer 8 and a hole-transporting layer 7 and/or an electron-blocking layer 6 or the like may be provided between the emitting layer 5 and the anode 3 and an electron-injecting layer 11 and an electron-transporting layer 10 and/or a hole-blocking layer 9 or the like may be provided between the emitting layer 5 and the cathode 4. Due to such configuration, electrons or holes can be confined in the emitting layer 5, whereby possibility of generation of excitons in the emitting layer 5 can be improved.

In one preferred example of the organic EL device of the invention, an electron-blocking layer 6 is provided next to the anode side of the emitting layer 5, wherein the electron-blocking layer 6 comprises a compound
fulfilling the following requirement:
Ionization potential in absolute values of component (1) - Ionization potential in absolute values of component (4) ≤ 0.35 eV, as component (4);
   wherein
the ionization potential of component (1) and component (4) is measured by photoelectron spectroscopy.

**Hereinbelow, an explanation will be made on function, materials, etc. of each layer constituting the organic EL device described in the present specification.**

### (Substrate)

The substrate is used as a support of the organic EL device. The substrate preferably has a light transmittance of 50% or more in the visible light region with a wavelength of 400 to 700 nm, and a smooth substrate is preferable. Examples of the material of the substrate include soda-lime glass, aluminosilicate glass, quartz glass, plastic and the like. As a substrate, a flexible substrate can be used. The flexible substrate means a substrate that can be bent (flexible), and examples thereof include a plastic substrate and the like. Specific examples of the material for forming the plastic substrate include polycarbonate, polyallylate, polyether sulfone, polypropylene, polyester, polyvinyl fluoride, polyvinyl chloride, polyimide, polyethylene naphthalate and the like. Also, an inorganic vapor deposited film can be used.

### (Anode)

As the anode, for example, it is preferable to use a metal, an alloy, a conductive compound, a mixture thereof or the like and having a high work function (specifically, 4.0 eV or more). Specific examples of the material of the anode include indium oxide-tin oxide (ITO: Indium Tin Oxide), indium oxide-tin oxide containing silicon or silicon oxide, indium oxide-zinc oxide, indium oxide containing tungsten oxide or zinc oxide, graphene and the like. In addition, it is also possible to use gold, silver, platinum, nickel, tungsten, chromium, molybdenum, iron, cobalt, copper, palladium, titanium, and nitrides of these metals (e.g. titanium oxide).

The anode is normally formed by depositing these materials on the substrate by a sputtering method. For example, indium oxide-zinc oxide can be formed by a sputtering method by using a target in which 1 to 10 mass% zinc oxide is added relative to indium oxide. Further, indium oxide containing tungsten oxide or zinc oxide can be formed by a sputtering method by using a target in which 0.5 to 5 mass% of tungsten oxide or 0.1 to 1 mass% of zinc oxide is added relative to indium oxide.
As other methods for forming the anode, a vacuum deposition method, a coating method, an inkjet method, a spin coating method or the like can be given. When silver paste or the like is used, it is possible to use a coating method, an inkjet method or the like.

The hole-injecting layer formed in contact with the anode is formed by using a material that allows easy hole injection regardless of the work function of the anode. For this reason, in the anode, it is possible to use a common electrode material, e.g. a metal, an alloy, a conductive compound and a mixture thereof.

### (Hole-transporting layer) / (Hole-injecting layer / Electron-blocking layer)

The hole-transporting layer is an organic layer that is formed between the emitting layer and the anode, and has a function of transporting holes from the anode to the emitting layer. If the hole-transporting layer is composed of plural layers, an organic layer that is nearer to the anode may often be defined as the hole-injecting layer. The hole-injecting layer has a function of injecting holes efficiently to the organic layer unit from the anode. Said hole-injecting layer is generally used for stabilizing hole injection from anode to hole-transporting layer which is generally consist of organic materials. Organic material having good contact with anode or organic material with p-type doping is preferably used for the hole-injecting layer.

p-doping usually consists of one or more p-dopant materials and one or more matrix materials. Matrix materials preferably have shallower HOMO level and p-dopant preferably have deeper LUMO level to enhance the carrier density of the layer. Aryl or heteroaryl amine compounds are preferably used as the matrix materials. Specific examples for the matrix material are the same as that for hole-transporting layer which is explained at the later part. Specific examples for p-dopant are the below mentioned acceptor materials, preferably the quinone compounds with one or more electron withdrawing groups, such as F₄TCNQ, 1,2,3-Tris[(cyano)(4-cyano-2,3,5,6-tetrafluorophenyl)methylene]cyclopropane.

Acceptor materials, or fused aromatic hydrocarbon materials or fused heterocycles which have high planarity, are preferably used as p-dopant materials for the hole-injecting layer. Specific examples for acceptor materials are, the quinone compounds with one or more electron withdrawing groups, such as F₄TCNQ(2,3,5,6-tetrafluoro-7,7,8,8-tetracyanoquinodimethane), and 1,2,3-tris[(cyano)(4-cyano-2,3,5,6-tetrafluorophenyl)methylene]cyclopropane; hexa-azatriphenylene compounds with one or more electron withdrawing groups, such as hexa-azatriphenylene-hexanitrile; aromatic hydrocarbon compounds with one or more electron withdrawing groups; and aryl boron compounds with one or more electron withdrawing groups.

The ratio of the p-type dopant is preferably less than 20% of molar ratio, more preferably less than 10%, such as 1%, 3%, or 5%, related to the matrix material.

The hole-transporting layer is generally used for injecting and transporting holes efficiently, and aromatic or heterocyclic amine compounds are preferably used.
Specific examples for compounds for the hole-transporting layer are represented by the general formula (H), 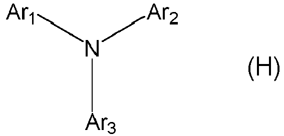 wherein
Ar₁ to Ar₃ each independently represents substituted or unsubstituted aryl group having 5 to 50 carbon atoms or substituted or unsubstituted heterocyclic group having 5 to 50 ring atoms, preferably phenyl group, biphenyl group, terphenyl group, naphthyl group, phenanthryl group, triphenylenyl group, fluorenyl group, spirobifluorenyl group, indenofluorenyl group, carbazolyl group, dibenzofuranyl group, dibenzothiophenyl group, carbazole substituted aryl group, dibenzofuran substituted aryl group or dibenzothiophene substituted aryl group; two or more substituents selected among Ar₁ to Ar₃ may be bonded to each other to form a ring structure, such as a carbazole ring structure, or a acridane ring structure.

Preferably, at least one of Ar₁ to Ar₃ have additional one aryl or heterocyclic amine substituent, more preferably Ar₁ has an additional aryl amino substituent, at the case of that it is preferable that Ar₁ represents substituted or unsubstituted biphenylene group, substituted or unsubstituted fluorenylene group.

A second hole-transporting layer is preferably inserted between the first hole-transporting layer and the emitting layer to enhance device performance by blocking excess electrons or excitons. Specific examples for second hole-transporting layer are the same as for the the first hole-transporting layer. It is preferred that second hole-transporting layer has higher triplet energy to block triplet excitons, such as bicarbazole compounds, biphenylamine compounds, triphenylenyl amine compounds, fluorenyl amine compounds, carbazole substituted arylamine compounds, dibenzofuran substituted arylamine compounds, and dibenzothiophene substituted arylamine compounds.

This second hole-transporting layer also called electron-blocking layer provided adjacent to the emitting layer has a function of preventing leakage of electrons from the emitting layer to the hole-transporting layer.

The inventive organic electroluminescence device preferably comprises an electron-blocking layer next to the anode side of the emitting layer, said electron-blocking layer comprising a compound having an ionization potential which is not more than 0.35 eV lower than that of component (1), as component (4);
wherein
the ionization potential of component (1) and component (4) is measured by photoelectron spectroscopy.

Suitable components (4) have been described above.

The electron-blocking layer may be a single layer or may be formed of two or more layers.

### (Emitting layer)

The emitting layer of the organic electroluminescence device according to the present invention comprises
(i) At least one compound with a dipole moment of less than 1.7 ·10⁻³⁰ Cm (0.5 debye), preferably less than 1.3 ·10⁻³⁰ Cm (0.4 debye), more preferably 1.0 ·10⁻³⁰ Cm (0.3 debye), as component (1), preferably having a here fluorescence onset of >2.75 eV;
(ii) At least one organic fluorescent compound whose onset of fluorescence is at lower energies than that of component (1) and at an energy higher than 2.6 eV, whose photoluminescence quantum yield is higher than 70% and whose ionization potential in absolute values is higher than 5.33 eV, as component (2);
(iii) At least one organic compound whose ionization potential in absolute values is lower than 5.33 eV and whose onset of fluorescence is at higher energies than that of component (2), as component (3).

The emitting layer of the organic electroluminescence device according to the present invention and its components are described above.

### (Electron-transporting layer / Electron-injecting layer / Hole-blocking layer)

Generally, at least one or a plurality of organic layers that is formed between the emitting layer and the cathode and has a function of transporting electrons from the cathode to the emitting layer. The at least one layer is generally at least one electron-transporting layer comprising an electron-transporting material. When a plurality of layers is present, an organic layer or an inorganic layer that is nearer to the cathode is often defined as the electron-injecting layer (see for example FIG. 1, wherein an electron-injecting layer 11 and an electron-transporting layer 10 and/or a hole-blocking layer 9 are present). The electron-injecting layer has a function of injecting electrons from the cathode efficiently to the organic layer unit. Preferred electron-injecting materials are alkali metal, alkali metal compounds, alkali metal complexes, the alkaline earth metal complexes and rare earth metals or rare earth metal complexes.

According to one embodiment, it is preferred that in addition to the electron-transporting layer one or more layer(s) like an electron-injecting layer to enhance efficiency and lifetime of the device, a hole-blocking layer or an exciton/triplet-blocking layer (layer 9 in Fig.1) are present between the emitting layer and the cathode.

According to one embodiment, it is preferred that an electron-donating dopant be contained in the interfacial region between the cathode and the emitting unit. Due to such a configuration, the organic EL device can have an increased luminance or a long life. Here, the electron-donating dopant means one having a metal with a work function of 3.8 eV or less. As specific examples thereof, at least one selected from an alkali metal, an alkali metal complex, an alkali metal compound, an alkaline earth metal, an alkaline earth metal complex, an alkaline earth metal compound, a rare earth metal, a rare earth metal complex and a rare earth metal compound or the like can be mentioned.

As the alkali metal, Li (work function: 2.9 eV), Na (work function: 2.36 eV), K (work function: 2.28 eV), Rb (work function: 2.16 eV), Cs (work function: 1.95 eV) and the like can be given. One having a work function of 2.9 eV or less is particularly preferable. Among them, K, Rb and Cs are preferable. Rb or Cs is further preferable. Cs is most preferable. As the alkaline earth metal, Ca (work function: 2.9 eV), Sr (work function: 2.0 eV to 2.5 eV), Ba (work function: 2.52 eV), Mg (work function: 3.68 eV) and the like can be given. One having a work function of 2.9 eV or less is particularly preferable. As the rare-earth metal, Sc, Y, Ce, Tb, Yb and the like can be given. One having a work function of 2.9 eV or less is particularly preferable.

Examples of the alkali metal compound include an alkali chalcogenide such as Li₂O, Na₂O, Cs₂O, K₂O, Na₂S or Na₂Se, and an alkali halide such as LiF, NaF, CsF, KF, LiCl, KCl and NaCl. Among them, LiF, Li₂O and NaF are preferable. Examples of the alkaline earth metal compound include BaO, SrO, CaO, BeO, BaS, CaSe and mixtures thereof such as BaₓSr₁₋ₓO (0<x<1) and BaₓCa₁₋ₓO (0<x<1). Alkaline earth metal halides are for example fluorides such as CaF₂, BaF₂, SrF₂, MgF₂ and BeF₂. Among them, BaO, SrO and CaO are preferable. Examples of the rare earth metal compounds include one or more oxides, nitrides, oxidized nitrides or halides, especially fluorides, containing at least one element selected from Yb, Sc, Y, Ce, Gd, Tb and the like, for example YbF₃, ScF₃, ScO₃, Y₂O₃, Ce₂O₃, GdF₃ and TbF₃. Among these, YbF₃, ScF₃ and TbF₃ are preferable. Further suitable dopants are one or more oxides, nitrides and oxidized nitrides of Al, Ga, In, Cd, Si, Ta, Sb and Zn and nitrides and oxidized nitrides of Ba, Ca, Sr, Yb, Li, Na and Mg.

The alkali metal complexes, the alkaline earth metal complexes and the rare earth metal complexes are not particularly limited as long as they contain, as a metal ion, at least one of alkali metal ions, alkaline earth metal ions, and rare earth metal ions. Meanwhile, preferred examples of the ligand include, but are not limited to, quinolinol, benzoquinolinol, acridinol, phenanthridinol, hydroxyphenyloxazole, hydroxyphenylthiazole, hydroxydiaryloxadiazole, hydroxydiarylthiadiazole, hydroxyphenylpyridine, hydroxyphenylbenzimidazole, hydroxybenzotriazole, hydroxyfluborane, bipyridyl, phenanthroline, phthalocyanine, porphyrin, cyclopentadiene, β-diketones, and azomethines.

Regarding the addition form of the electron-donating dopant, it is preferred that the electron-donating dopant be formed in a shape of a layer or an island in the interfacial region. A preferred method for the formation is a method in which an organic compound (a light emitting material or an electron-injecting material) for forming the interfacial region is deposited simultaneously with deposition of the electron-donating dopant by a resistant heating deposition method, thereby dispersing the electron-donating dopant in the organic compound. In a case where the electron-donating dopant is formed into the shape of a layer, the light-emitting material or electron-injecting material which serves as an organic layer in the interface is formed into the shape of a layer. After that, a reductive dopant is solely deposited by the resistant heating deposition method to form a layer preferably having a thickness of from 0.1 nm to 15 nm. In a case where the electron-donating dopant is formed into the shape of an island, the emitting material or the electron-injecting material which serves as an organic layer in the interface is formed into the shape of an island. After that, the electron-donating dopant is solely deposited by the resistant heating deposition method to form an island preferably having a thickness of from 0.05 nm to 1 nm.

As the electron-transporting material used in the electron-transporting layer an aromatic heterocyclic compound having one or more hetero atoms in the molecule may preferably be used. In particular, a nitrogen containing heterocyclic compound is preferable.

According to one embodiment, it is preferable that the electron-transporting layer comprises a nitrogen containing heterocyclic metal chelate.

According to another embodiment, it is preferable that the electron-transporting layer comprises a substituted or unsubstituted nitrogen containing heterocyclic compound. Specific examples of preferred heterocyclic compounds for the electron-transporting layer are, 6-membered azine compounds; such as pyridine compounds, pyrimidine compounds, triazine compounds, pyrazine compounds, preferably pyrimidine compounds or triazine compounds; 6-membered fused azine compounds, such as quinolone compounds, isoquinoline compounds, quinoxaline compounds, quinazoline compounds, phenanthroline compounds, benzoquinoline compounds, benzoisoquinoline compounds, dibenzoquinoxaline compounds, preferably quinolone compounds, isoquinoline compounds, phenanthroline compounds; 5-membered heterocyclic compounds, such as imidazole compounds, oxazole compounds, oxadiazole compounds, triazole compounds, thiazole compounds, thiadiazole compounds; fused imidazole compounds, such as benzimidazole compounds, imidazopyridine compounds, naphthoimidazole compounds, benzimidazophenanthridine compounds, benzimidzobenzimidazole compounds, preferably benzimidazole compounds, imidazopyridine compounds or benzimidazophenanthridine compounds.

According to another embodiment, it is preferable the electron-transporting layer comprises a phosphine oxide compound represented as Arₚ₁Arₚ₂Ar_{P3}P=O.

Arₚ₁ to Arₚ₃ are the substituents of phosphor atom and each independently represent substituted or unsubstituted above mentioned aryl group or substituted or unsubstituted above mentioned heterocyclic group.

According to another embodiment, it is preferable that the electron-transporting layer comprises aromatic hydrocarbon compounds. Specific examples of preferred aromatic hydrocarbon compounds for the electron-transporting layer are, oligo-phenylene compounds, naphthalene compounds, fluorene compounds, fluoranthenyl group, anthracene compounds, phenanthrene compounds, pyrene compounds, triphenylene compounds, benzanthracene compounds, chrysene compounds, benzphenanthrene compounds, naphthacene compounds, and benzochrysene compounds, preferably anthracene compounds, pyrene compounds and fluoranthene compounds.

A hole-blocking layer may be provided adjacent to the emitting layer, and has a function of preventing leakage of holes from the emitting layer to the electron-transporting layer. In order to improve hole-blocking capability, a material having a deep HOMO level is preferably used.

Specific electron-transporting or hole-blocking materials are for example

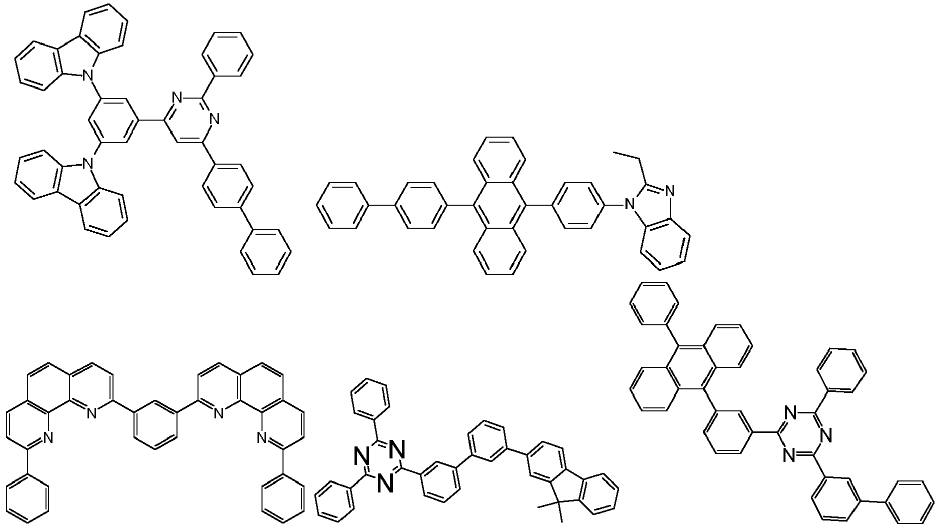

In one embodiment, the organic electroluminescence device according to the present invention, comprises an electron-transporting zone, wherein the electron-transporting zone further comprises at least one of an electron-donating dopant and preferably an organic metal complex. Suitable dopants are mentioned above.

Preferably, the at least one of an electron-donating dopant and an organic metal complex is at least one selected from the group consisting of an alkali metal, an alkali metal compound, an alkali metal complex, an alkaline earth metal, an alkaline earth metal compound, an alkaline earth metal complex, a rare earth metal, a rare earth metal compound, and a rare earth metal complex.

### (Cathode)

For the cathode, a metal, an alloy, an electrically conductive compound, and a mixture thereof, each having a small work function (specifically, a work function of 3.8 eV or less) are preferably used. Specific examples of a material for the cathode include an alkali metal such as lithium and cesium; an alkaline earth metal such as magnesium, calcium, and strontium; an alloy containing these metals (for example, magnesium-silver, aluminum-lithium); a rare earth metal such as europium and ytterbium; and an alloy containing a rare earth metal.

The cathode is usually formed by a vacuum vapor deposition or a sputtering method. Further, in the case of using a silver paste or the like, a coating method, an inkjet method, or the like can be employed.

Moreover, when the electron-injecting layer is provided, various electrically conductive materials such as aluminum, silver, ITO, graphene, indium oxide-tin oxide containing silicon or silicon oxide, selected independently from the work function, can be used to form a cathode. These electrically conductive materials are made into films using a sputtering method, an inkjet method, a spin coating method, or the like.

### (Insulating layer)

In the organic EL device, pixel defects based on leakage or a short circuit are easily generated since an electric field is applied to a thin film. In order to prevent this, it is preferred to insert an insulating thin layer between a pair of electrodes. Examples of materials used in the insulating layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, and vanadium oxide. A mixture thereof may be used in the insulating layer, and a laminate of a plurality of layers that include these materials can be also used for the insulating layer.

### (Spacing layer)

A spacing layer is a layer for example provided between a fluorescent emitting layer and a phosphorescent emitting layer when a fluorescent emitting layer and a phosphorescent emitting layer are stacked in order to prevent diffusion of excitons generated in the phosphorescent emitting layer to the fluorescent emitting layer or in order to adjust the carrier balance. Further, the spacing layer can be provided between the plural phosphorescent emitting layers.

Since the spacing layer is for example provided between the emitting layers, the material used for the spacing layer is preferably a material having both electron-transporting capability and hole-transporting capability. In order to prevent diffusion of the triplet energy in adjacent phosphorescent emitting layers, it is preferred that the spacing layer have a triplet energy of 2.6 eV or more. As the material used for the spacing layer, the same materials as those used in the above-mentioned hole-transporting layer can be given.

### Triplet-blocking layer

A triplet-blocking layer (exciton-blocking layer) may be provided adjacent to the emitting layer.

The triplet-blocking layer has a function of preventing triplet excitons generated in the emitting layer from diffusing into neighboring layers to trap the triplet excitons within the emitting layer, thereby suppressing energy deactivation of the triplet excitons on molecules other than the emitting dopant in the electron-transporting layer.

When the triplet-blocking layer is provided in a phosphorescent device, triplet energy of a phosphorescent dopant in the emitting layer is denoted as ET d and triplet energy of a compound used as the triplet-blocking layer is denoted as ET TB . In an energy relationship of ET d <ET TB , triplet excitons of the phosphorescent dopant are trapped (cannot be transferred to another molecule) to leave no alternative route for energy deactivation other than emission on the dopant, so that highly efficient emission can be expected. However, when an energy gap (ΔET =ET TB -ET d ) is small even though the relationship of ET d <ET TB is satisfied, under actual environments for driving a device (i.e., at around the room temperature), it is considered that triplet excitons can be transferred to another molecule irrespective of the energy gap ΔET by absorbing heat energy around the device. Particularly, since the excitons of the phosphorescent device have longer lifetime than those of a fluorescent device, influence by heat absorption during transfer of the excitons is more likely to be given on the phosphorescent device relative to the fluorescent device. A larger energy gap ΔET relative to heat energy at the room temperature is preferable, more preferably 0.1 eV or more, further preferable at 0.2 eV or more. On the other hand, in the fluorescent device, the organic-EL-device material according to the exemplary embodiment is usable as the triplet-blocking layer in the TTF device structure described in International Publication WO2010/134350A1.

### (Method for forming a layer)

The method for forming each layer of the organic EL device of the invention is not particularly limited unless otherwise specified. A known film-forming method such as a dry film-forming method, a wet film-forming method or the like can be used. Specific examples of the dry film-forming method include a vacuum deposition method, a sputtering method, a plasma method, an ion plating method, and the like. Specific examples of the wet film-forming method include various coating methods such as a spin coating method, a dipping method, a flow coating method, an inkjet method, and the like.

### (Film thickness)

The film thickness of each layer of the organic EL device of the invention is not particularly limited unless otherwise specified. If the film thickness is too small, defects such as pinholes are likely to occur to make it difficult to obtain a sufficient luminance. If the film thickness is too large, a high driving voltage is required to be applied, leading to a lowering in efficiency. In this respect, the film thickness is preferably 5 nm to 10 µm, and more preferably 10 nm to 0.2 µm.

### (Electronic apparatus (electronic equipment))

The present invention further relates to an electronic equipment (electronic apparatus) comprising the organic electroluminescence device according to the present application. Examples of the electronic apparatus include display parts such as an organic EL panel module; display devices of television sets, mobile phones, smart phones, and personal computer, and the like; and emitting devices of a lighting device and a vehicle lighting device.

It should be noted that the invention is not limited to the above exemplary embodiments but may include any modification and improvement as long as such modification and improvement are compatible with the invention.

The following examples are included for illustrative purposes only and do not limit the scope of the claims. Unless otherwise stated, all parts and percentages are by weight.

### Examples

### I Application Examples

### Application Example - general A - Single layer EL

A glass substrate with 130 nm-thick indium-tin-oxide (ITO) transparent electrode (manufactured by Geomatec Co., Ltd.) used as an anode was first treated with N2 plasma for 100 sec. This treatment also improved the hole-injection properties of the ITO. The cleaned substrate was mounted on a substrate holder and loaded into a vacuum chamber. Thereafter, the organic materials specified below were applied by vapor deposition to the ITO substrate at a rate of approx. 0.2-1 Å/sec at about 10⁻⁶-10⁻⁸ mbar. As a hole-injection layer, 10 nm-thick mixture of Compound HT-1 and 3% by weight of Compound HI were applied. Then 80 nm-thick of Compound HT-1 and 10 nm of Compound HT-2 were applied as hole-transporting layer and electron-blocking layer, respectively. Subsequently, a mixture as described in the following drawings and tables 1, 2, 3, 5 and 7 was applied to form a 25 nm-thick fluorescent-emitting layer (EL layer). On the emitting layer, 10 nm-thick Compound ET-1 was applied as an hole-blocking layer and 15 nm of Compound ET-2 as electron transporting layer. Finally, 1 nm LiF was deposited and 50 nm-thick Al was then deposited as a cathode to complete the device. The device was sealed with a glass lid and a getter in an inert nitrogen atmosphere with less than 1 ppm of water and oxygen. To characterize the OLED, electroluminescence spectra were recorded at various currents and voltages. In addition, the current-voltage characteristic was measured in combination with the luminance to determine luminous efficiency and external quantum efficiency (EQE). Voltage and efficiency are reported at 10 mA/cm². Lifetime of OLED device was measured as a decay of the luminance at constant current density of 50 mA/cm² to 95% of its initial value. The device results are shown in Tables 3, 5 and 7.

An example for an EL device according to the present invention comprising a single layer EL is shown in the following:
ITO(130 nm)/HT-1:HI(10 nm; 3%)/HT-1(80 nm)/**EBL**(10 nm)/BH-1:**BD:AD**(25 nm)/ET-1(10 nm)/ET-2(15 nm)/LiF(1 nm)/AI(50 nm)

### Application Example - general B - Double layer EL

A glass substrate with 130 nm-thick indium-tin-oxide (ITO) transparent electrode (manufactured by Geomatec Co., Ltd.) used as an anode was first treated with N2 plasma for 100 sec. This treatment also improved the hole-injection properties of the ITO. The cleaned substrate was mounted on a substrate holder and loaded into a vacuum chamber. Thereafter, the organic materials specified below were applied by vapor deposition to the ITO substrate at a rate of approx. 0.2-1 Å/sec at about 10⁻⁶-10⁻⁸ mbar. As a hole-injection layer, 10 nm-thick mixture of Compound HT-1 and 3% by weight of Compound HI were applied. Then 80 nm-thick of Compound HT-1 and 10 nm of Compound HT-2 were applied as hole-transporting layer and electron-blocking layer, respectively. Subsequently, a mixture as described in the following drawings and tables 1, 2, 4 and 6 was applied to form a 5 nm-thick *first* fluorescent-emitting layer followed by a *second* fluorescent emitting layer comprising a mixture described in the following tables 4 and 6 (EL layer). On the emitting layer, 10 nm-thick Compound ET-1 was applied as an hole-blocking layer and 15 nm of Compound ET-2 as electron transporting layer. Finally, 1 nm LiF was deposited and 50 nm-thick Al was then deposited as a cathode to complete the device. The device was sealed with a glass lid and a getter in an inert nitrogen atmosphere with less than 1 ppm of water and oxygen. To characterize the OLED, electroluminescence spectra were recorded at various currents and voltages. In addition, the current-voltage characteristic was measured in combination with the luminance to determine luminous efficiency and external quantum efficiency (EQE). Voltage and efficiency are reported at 10 mA/cm². Lifetime of OLED device was measured as a decay of the luminance at constant current density of 50 mA/cm² to 95% of its initial value. The device results are shown in Tables 4 and 6.

An example for an EL device according to the present invention comprising a double layer EL is shown in the following:
ITO(130 nm)/HT-1:HI(10 nm; 3%)/HT-1(80 nm)/**EBL**(10 nm)/BH-2:**BD:AD**(5 nm)/BH-1:**BD**(20 nm)/ET-1(10 nm)/ET-2(15 nm)/LiF(1 nm)/AI(50 nm)

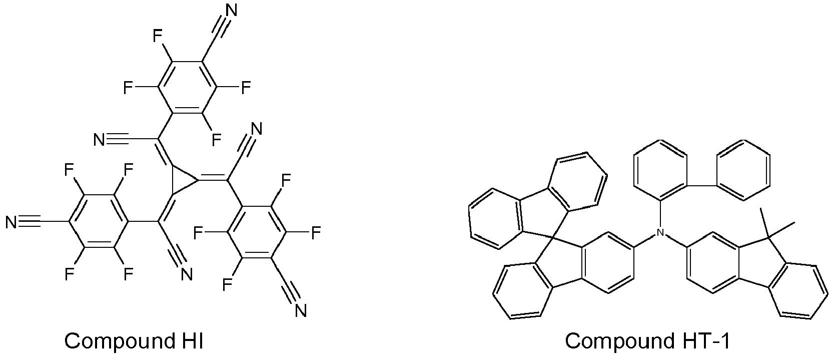

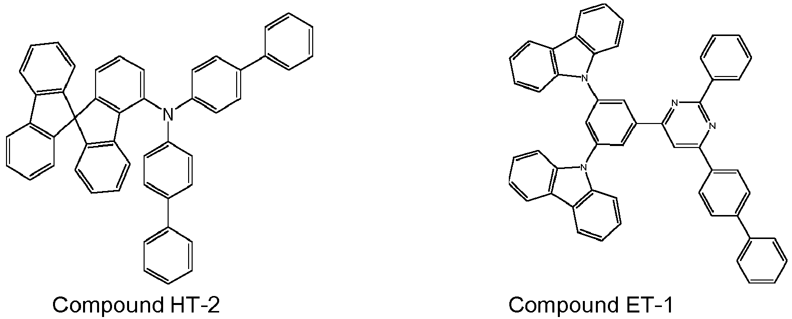

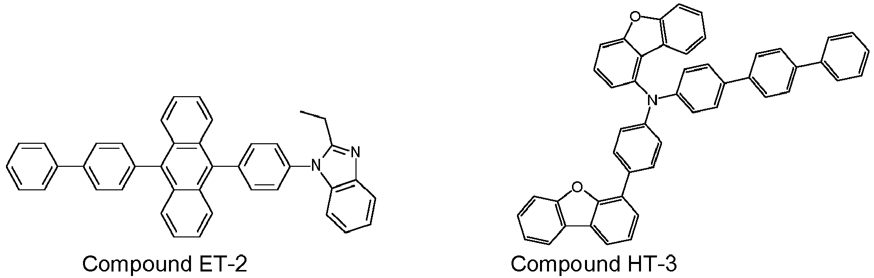

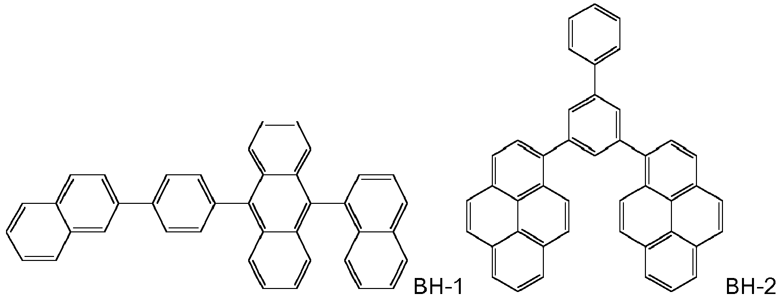

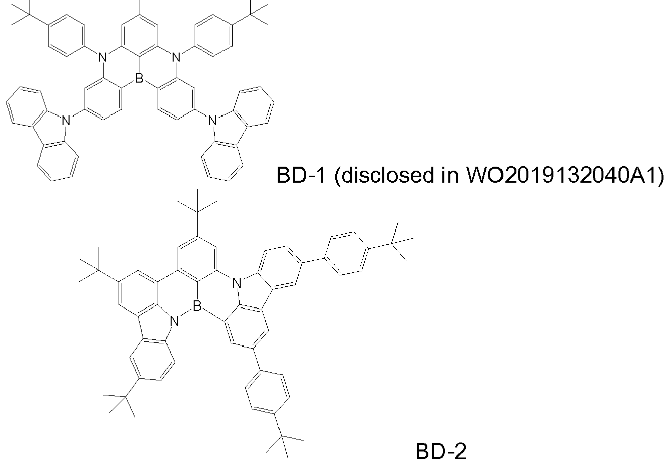

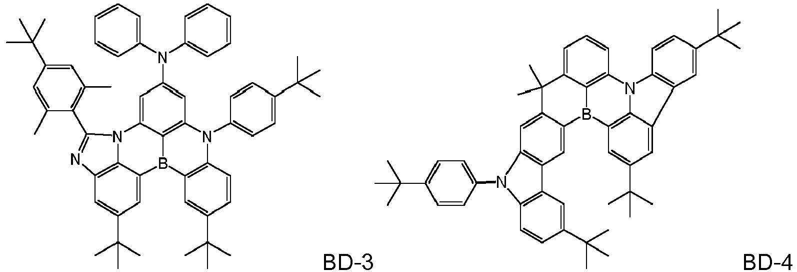

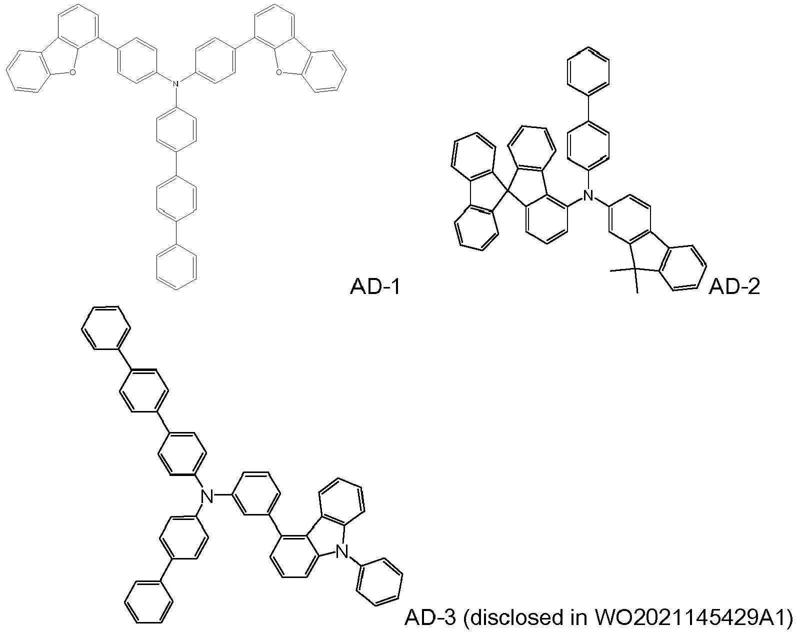

The compounds BD-1, BD-2, BD-3, BD-4, AD-1, AD-2, AD-3, BH-1, BH-2, HI, HT-1, HT-2, HT-3, ET-1 and ET-2 are commercially available and/or prepared by methods known in the art.

**Table 1: Physical data of the compounds used as EBL or as component (1)**

| | | Ionization potential (eV) (absolute values) | Fluorescence onset (eV) |
|---|---|---|---|
| EBL | HT-2 | 5.82 | |
| | HT-3 | 5.72 | |
| | AD-1 | 5.66 | |
| | AD-2 (Com. Ex.) | 5.66 | |
| (1) | BH-1 | 6.03 | 3.13 |
| | BH-2 | 5.85 | 3.38 |

| | | | |
|---|---|---|---|
| 1. The ionization potential is measured under atmosphere using a photoelectron spectroscope (AC-3, RIKEN KEIKI Co., Ltd., according to US 2020/0395552 A1). Specifically, a 50 nm evaporated film of the material is irradiated with light of increasing energies and the number of electrons generated by charge separation is measured to calculate the onset. 2. Fluorescence is measured in toluene solution at a concentration below 5 × 10⁻⁶ M. Fluorescence onsets are determined by linear fitting of the high energy side of the spectra. The onsets represent where the fitted lines with the steepest slopes intercept with zero intensity. | | | |

**Table 2: Physical data of the compounds used as component (2) or component (3)**

| | | Fluorescence onset (eV) | Phosphorescence onset (eV) | Ionization potential (eV) (absolute values) | Photoluminescence quantum yield (%) | Fluorescence FWHM, nm |
|---|---|---|---|---|---|---|
| (2) | BD-1 | 2.81 | | 5.34 | 88 | 23 |
| | BD-2 | 2.84 | | 5.41 | 84 | 20 |
| | BD-3 | 2.84 | | 5.50 | 92 | 23 |
| | BD-4 | 2.87 | | 5.50 | 90 | 24 |
| (3) | AD-1 | 3.21 | 2.58 | 5.29 | | 40 |
| | AD-2 | 3.32 | 2.67 | 5.27 | | 45 |
| | AD-3 | 3.26 | 2.59 | 5.31 | | 44 |
| | HT-3 (Com . Ex.) | 3.28 | 2.59 | 5.41 | | 40 |

| | | | | | | |
|---|---|---|---|---|---|---|
| 1. Fluorescence is measured in toluene solution at a concentration below 5 × 10⁻⁶ M. Phosphorescence is measured in 2-methyltetrahydrofuran solution at 77 Kelvin temperature. The photoluminescence quantum yield is measured with an integrating sphere (Hamamatsu Quantaurus-QY Absolute PL Quantum Yield Spectrometer C11347). 2. The ionization potential is measured with cyclic voltammetry in dimethylformamide, using the formula: 1.4 × (E_{sample oxidation onset} - E_{ferrocene oxidation onset}) + 4.6 eV, according to Org. Electron. 2005, 6, 11-20. 3. Fluorescence and phosphorescence onsets are determined by linear fitting of the high energy side of the spectra. The onsets represent where the fitted lines with the steepest slopes intercept with zero intensity. FWHM - (Full width at half maximum) is a measurement of the width of the fluorescence spectrum being generated at half its amplitude and is determined as shown in the example below: | | | | | | |

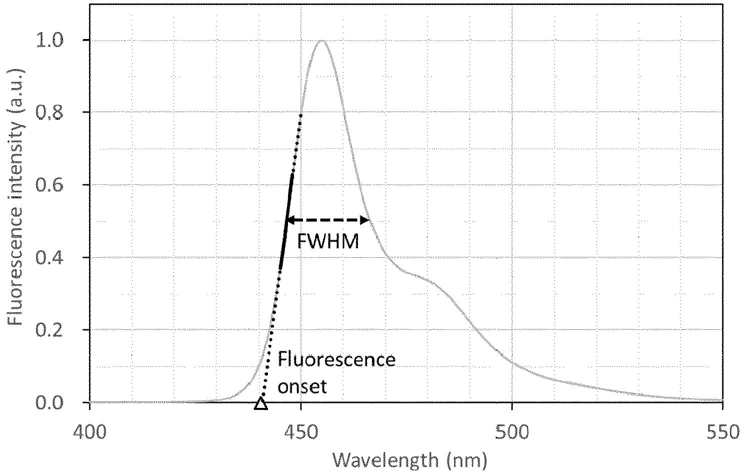

**Table 3: Results of the application examples - Single layer EL**

| Example | EBL | EML BH-1:**BD:AD**(25 nm) | ELₘₐₓ (nm) | EQE (%) | Gray-scaling parameter | LT95 (h) |
|---|---|---|---|---|---|---|
| Ex. 1 | HT-2 | BH-1(96%):BD-1(2%):AD-1(2%) | 463 | 8.79 | 0.99 | 152 |
| Ex. 2 | HT-2 | BH-1(96%):BD-1(2%):AD-2(2%) | 463 | 9.00 | 0.97 | 124 |
| Com. Ex. 1 | HT-2 | BH-1(98%):BD-1 (2%) | 464 | 8.65 | 0.95 | 58 |
| Ex. 3 | HT-2 | BH-1(96%):BD-2(2%):AD-1(2%) | 455 | 8.79 | 0.97 | 163 |
| Ex. 4 | HT-2 | BH-1(96%):BD-2(2%):AD-2(2%) | 456 | 8.91 | 0.97 | 122 |
| Com. Ex. 2 | HT-2 | BH-1(98%):BD-2(2%) | 456 | 8.20 | 0.99 | 17 |
| Ex. 5 | HT-2 | BH-1(96%):BD-3(2%):AD-2(2%) | 458 | 8.38 | 0.94 | 80 |
| Com. Ex. 3 | HT-2 | BH-1(98%):BD-3(2%) | 458 | 8.34 | 0.99 | 13 |
| Ex. 6 | HT-2 | BH-1(96%):BD-4(2%):AD-1(2%) | 452 | 8.87 | 0.96 | 118 |
| Ex. 7 | HT-2 | BH-1(96%):BD-4(2%):AD-2(2%) | 453 | 9.18 | 0.95 | 79 |
| Ex. 8 | HT-2 | BH-1(96%):BD-4(2%):AD-3(2%) | 453 | 9.14 | 0.95 | 88 |
| Com. Ex. 4 | HT-2 | BH-1(98%):BD-4(2%) | 453 | 8.25 | 0.99 | 13 |
| Com. Ex. 5 | HT-2 | BH-1(98%):BD-4(2%):HT-3 (2%) | 453 | 9.01 | 0.97 | 54 |

| | | | | | | |
|---|---|---|---|---|---|---|
| ELₘₐₓ and EQE are reported at the current density of 10 mA/cm². The gray-scaling parameter denotes the ratio of EQE at 10 mA/cm² to EQE at 1 mA/cm². LT95 is measured at the current density of 50 mA/cm². | | | | | | |

**Table 4: Results of the application examples**

| Example | EBL | EML BH-2:BD:AD(5 nm)/BH-1:BD(20 nm) | ELmax (nm) | EQE (%) | Gray-scaling parameter | LT95 (h) |
|---|---|---|---|---|---|---|
| Ex. 9 | HT-2 | BH-2(96%):BD-1(2%):AD-1(2%) | 463 | 9.66 | 1.00 | 157 |
| Ex. 10 | HT-2 | BH-2(96%):BD-1(2%):AD-2(2%) | 464 | 9.84 | 0.95 | 120 |
| Com. Ex. 6 | HT-2 | BH-2(98%):BD-1(2%) | 464 | 9.50 | 0.98 | 100 |
| Ex. 11 | HT-2 | BH-2(96%):BD-2(2%):AD-1(2%) | 456 | 8.98 | 0.99 | 99 |
| Com. Ex. 7 | HT-2 | BH-2(98%):BD-2(2%) | 456 | 8.56 | 0.97 | 23 |
| Ex. 12 | HT-2 | BH-2(96%):BD-4(2%):AD-1(2%) | 453 | 9.02 | 0.95 | 77 |
| Com. Ex. 8 | HT-2 | BH-2(98%):BD-4(2%) | 453 | 8.49 | 0.97 | 17 |
| Com. Ex. 9 | HT-2 | BH-2(98%):BD-4(2%):HT-3(2%) | 453 | 8.96 | 0.99 | 19 |

| | | | | | | |
|---|---|---|---|---|---|---|
| The BD in the second emitting layer is the same as in the first emitting layer. | | | | | | |

**Table 5: Results of the application examples - Single layer EL**

| Example | EBL | EML BH-1:**BD:AD**(25 nm) | ELmax (nm) | EQE (%) | Gray-scaling parameter | LT95 (h) |
|---|---|---|---|---|---|---|
| Ex. 13 | HT-3 | BH-1(96%):BD-4(2%):AD-2(2%) | 453 | 8.98 | 0.91 | 162 |
| Ex. 14 | HT-3 | BH-1(96%):BD-4(2%):AD-3(2%) | 453 | 9.00 | 0.92 | 142 |
| Com. Ex. 10 | HT-3 | BH-1(98%):BD-4(2%) | 453 | 8.65 | 0.89 | 30 |

**Table 6: Results of the application examples**

| Example | EBL | EML BH-2:BD:AD(5 nm)/BH-1:BD(20 nm) | ELmax (nm) | EQE (%) | Gray-scaling parameter | LT95 (h) |
|---|---|---|---|---|---|---|
| Ex. 15 | AD-1 | BH-2(96%):BD-1(2%):AD-1(2%) | 464 | 9.79 | 0.97 | 196 |
| Com. Ex. 11 | AD-1 | BH-2(98%):BD-1(2%) | 464 | 9.32 | 0.95 | 108 |
| Ex. 16 | AD-1 | BH-2(96%):BD-2(2%):AD-1(2%) | 457 | 9.10 | 0.94 | 140 |
| Com. Ex. 12 | AD-1 | BH-2(98%):BD-2(2%) | 457 | 8.33 | 0.91 | 33 |
| Ex. 17 | AD-1 | BH-2(96%):BD-3(2%):AD-1(2%) | 459 | 8.81 | 0.95 | 115 |
| Com. Ex. 13 | AD-1 | BH-2(98%):BD-3(2%) | 459 | 8.36 | 0.94 | 32 |

| | | | | | | |
|---|---|---|---|---|---|---|
| 1. The BD in the second emitting layer is the same as in the first emitting layer. 2. The difference in ionization potential energy between AD-1 and BH-2 is 0.19 eV (see Table 1). | | | | | | |

**Table 7: Results of the application examples - Single layer EL**

| Example | EBL | EML BH-1:**BDAD**(25 nm) | ELmax (nm) | EQE (%) | Gray-scaling parameter | LT95 (h) |
|---|---|---|---|---|---|---|
| Com. Ex. 14 | AD-2 | BH-1(98%):BD-1 (2%) | 463 | 8.19 | 0.89 | 87 |
| Com. Ex. 15 | AD-2 | BH-1(98%):BD-2(2%) | 456 | 8.52 | 0.90 | 64 |
| Com. Ex. 16 | AD-2 | BH-1(98%):BD-3(2%) | 458 | 7.70 | 0.86 | 40 |
| Com. Ex. 17 | AD-2 | BH-1(98%):BD-4(2%) | 453 | 8.42 | 0.91 | 43 |

The difference in ionization potential energy between AD-2 and BH-1 is 0.37 eV (see Table 1).The results of the comparative examples in table 6 show that when the ionization potential energy difference between component (1) and EBL is larger than 0.35 eV, the devices show significantly decreased EQE at high current density (cf. Table 3).

## Claims

1. An organic electroluminescence device comprising a cathode, an anode and an emitting layer having an anode side and a cathode side disposed between the cathode and the anode, and a further layer next to the anode side of the emitting layer wherein
the emitting layer comprises
(iv) At least one compound with a dipole moment of less than 1.7 ·10⁻³⁰ Cm (0.5 debye), preferably less than 1.3 ·10⁻³⁰ Cm (0.4 debye), more preferably 1.0 ·10⁻³⁰ Cm (0.3 debye), as component (1);
(v) At least one organic fluorescent compound whose onset of fluorescence is at lower energies than that of component (1) and at an energy higher than 2.6 eV, whose photoluminescence quantum yield is higher than 70% and whose ionization potential in absolute values is higher than 5.33 eV, as component (2);
(vi) At least one organic compound whose ionization potential in absolute values is lower than 5.33 eV and whose onset of fluorescence is at higher energies than that of component (2), as component (3);
and
the further layer comprising a compound fulfilling the following requirement:
Ionization potential in absolute values of component (1) - Ionization potential in absolute values of component (4) ≤ 0.35 eV,
as component (4);
wherein
the dipole moment is computed using the DFT method with the Gaussian 16 software;
the onset of fluorescence is determined by linear fitting of the high energy side of the spectra;
the photoluminescence quantum yield is measured with an integrating sphere;
the ionization potential of component (2) and component (3) is measured by cyclic voltammetry; and
the ionization potential of component (1) and component (4) is measured by photoelectron spectroscopy.

2. The organic electroluminescence device according to claim 1, wherein component (1) is an aromatic hydrocarbon compound, preferably exclusively comprising carbon and hydrogen, more preferably an anthracene skeleton-containing compound, a chrysene skeleton-containing compound, a pyrene skeleton-containing compound, a fluorene skeleton-containing compound, a fluoranthene skeleton containing compound, with an anthracene skeleton-containing compound and a pyrene skeleton-containing compound being more preferred and an anthracene skeleton-containing compound being most preferred.

3. The organic electroluminescence device according to any one of claims 1 to 3, wherein component (2) has a Full Width at Half Maximum (FWHM) of emission of <30 nm.

4. The organic electroluminescence device according to any one of claims 1 to 3, wherein component (2) is represented by a fused polycyclic aromatic compound, a styrylamine compound, a fused ring amine compound, a boron-containing compound, a pyrrole compound, an indole compound or a carbazole compound; preferably a fused ring amine compound, a boron-containing compound or a carbazole compound.

5. The organic electroluminescence device according to any one of claims 1 to 4, wherein component (3) has an energy difference between fluorescence and phosphorescence onsets of more than 0.20 eV, preferably more than 0.3 eV, more preferably more than 0.4 eV,
wherein the energy difference is determined by fluorescence versus phosphorescence onsets (Δ*E*_{ST}),
wherein fluorescence and phosphorescence onsets are determined by linear fitting of the high energy side of the spectra.

6. The organic electroluminescence device according to any one of claims 1 to 5, wherein component (3) is different from components (1) and (2) and is preferably represented by the following formula (31) 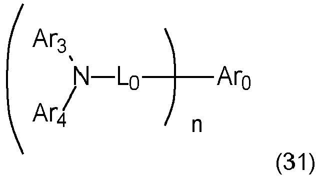 wherein
Ar₀ is a substituted or unsubstituted aromatic hydrocarbon group having 6 to 50 ring carbon atoms, preferably fused aromatic hydrocarbon group, or substituted or unsubstituted heterocyclic group having 5 to 50 ring atoms;
Ar₃ and Ar₄ are independently a substituted or unsubstituted aryl group having 6 to 50 ring carbon atoms, a substituted or unsubstituted heterocyclic ring group having 5 to 50 ring atoms, a substituted or unsubstituted alkyl group having 1 to 30 carbon atoms, a substituted or unsubstituted aralkyl group having 7 to 50 ring carbon atoms; Ar₃ and A₄ may be bonded together to form a saturated or unsaturated ring; when n is 2 or more, plural Ar₃ are mutually the same or different and plural Ar₄ are mutually the same or different;
Lo is a direct bond or a linking group; Lo in a form of the linking group is preferably selected from the group consisting of a substituted or unsubstituted aromatic hydrocarbon group having 6 to 30 ring carbon atoms and a substituted or unsubstituted heterocyclic group having 5 to 30 ring atoms; and when n is 2 or more, plural Lo are mutually the same or different; preferably, Lo is a direct bond;
n is an integer of 1 to 4, preferably 1 or 2.

7. The organic electroluminescence device according to any one of claims 1 to 6, wherein component (2) is present in the light emitting layer in an amount of 0.5% to 5% by weight, based on the total amount of the light emitting layer.

8. The organic electroluminescence device according to any one of claims 1 to 7, wherein component (3) is present in the light emitting layer in an amount of 0.5% to 5% by weight, based on the total amount of the light emitting layer.

9. The organic electroluminescence device according to any one of claims 1 to 8, wherein component (2) and (3) are present in the light emitting layer in a mass ratio of 0.1 to 5 : 1, preferably 0.3 to 3 : 1, more preferably 0.5 to 2 : 1.

10. A material being in form of a layer structure comprising
a first layer comprising
(iv) at least one component (1);
(v) at least one component (2);
(vi) at least one component (3);
as defined in any one of claims 1 to 9, and
a further layer
comprising a compound fulfilling the following requirement:
Ionization potential in absolute values of component (1) - Ionization potential in absolute values of component (4) ≤ 0.35 eV, as component (4).

11. A composition comprising components (1), (2) and (3) as defined in any one of claims 1 to 9, wherein component (3) is present in the composition in an amount of 5% by weight or less, preferably in an amount of 0.5% to 5% by weight, based on the total amount of the composition.

12. An organic electroluminescence device comprising a cathode, an anode and an emitting layer disposed between the cathode and the anode, wherein the emitting layer comprises a composition according to claim 11.

13. An organic electroluminescence device according to any one of claims 1 to 9 and 12,
wherein the emitting layer is a single layer, a double layer or a stack of a plurality of layers.

14. An electronic equipment comprising the organic electroluminescence device according to anyone of claims 1 to 9 and 12, a material according to claim 10 or a composition according to claim 11.

15. Use of a material according to claim 10 or a composition according to claim 11 in a light emitting layer of an organic electroluminescence device.
